(19) Europäisches Patentamt
European Patent Office
Office européen des brevets

(11) EP 1 508 833 A2

(12) EUROPEAN PATENT APPLICATION

(43) Date of publication:
**23.02.2005 Bulletin 2005/08**

(51) Int Cl.[7]: **G03F 7/00**

(21) Application number: **04019952.3**

(22) Date of filing: **23.08.2004**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(30) Priority: **22.08.2003 JP 2003298936**
**25.08.2003 JP 2003300059**

(71) Applicant: **Fuji Photo Film Co., Ltd.**
**Kanagawa (JP)**

(72) Inventors:
- **Takizawa, Hiroo**
**Minami-Ashigara-shi Kanagawa (JP)**
- **Inoue, Noriko**
**Minami-Ashigara-shi Kanagawa (JP)**
- **Akiba, Masaharu**
**Minami-Ashigara-shi Kanagawa (JP)**

(74) Representative: **Grünecker, Kinkeldey,**
**Stockmair & Schwanhäusser Anwaltssozietät**
**Maximilianstrasse 58**
**80538 München (DE)**

# (54) Hologram recording material composition, hologram recording material and hologram recording method

(57) To provide a composition for a hologram recording material, a hologram recording material and a hologram recording method applicable to a high density optical recording medium, a three-dimensional display, a holographic optical element etc. and capable of attaining a high sensitivity, a high diffraction efficiency, a satisfactory storage property, a low shrinkage rate, a dry process, a multiplex recording property and a high recording density. An unrewritable hologram recording method including a step in which a sensitizing dye absorbs light by an exposure to form an excited state, a chemical reaction step including a color forming reaction involving an electron transfer or an energy transfer from such excited state, and a hologram-forming step by such chemical reaction.

FIG. 1

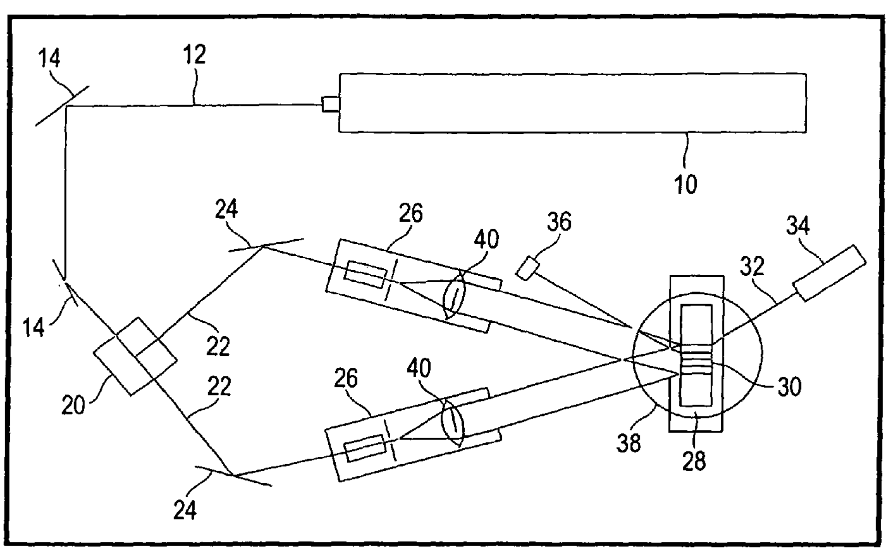


EP 1 508 833 A2

## Description

Background of the Invention

1. Field of the Invention

The present invention relates to a hologram recording material composition, a hologram recording material and hologram recording method which can be applied to high density optical recording medium, three-dimensional display, holographic optical element, etc.

2. Background Art

A general principle concerning the preparation of hologram is described in some literatures and technical books, e.g., Junpei Tsujiuchi, "Holographic Display", Sangyo Tosho, Chapter 2 (Non-patent Reference 1). In this general principle, an object to be recorded is irradiated with one of two fluxes of coherent laser beam. A photosensitive hologram recording material is placed in a position at which light totally reflected by the object can be received. The hologram recording material is directly irradiated with the other coherent laser beam without hitting the object besides the light reflected by the object. The light beam reflected by the object is referred to as "obj ect beam" and the light beam directly aimed at the object is referred to as "reference beam". The interference fringe made by the interaction of the object beam with the reference beam is recorded as an image data. Subsequently, when the recording material processed is irradiated with the same light beam as the reference beam (reproducing illumination), thelightbeam is diffracted by hologram in such a manner that the wave front of the reflected light which has first reached from the object to the recording material during recording can be reproduced. As a result, substantially the same object image as the real image of the object can be three-dimensionally viewed.

The hologram formed by irradiating the hologram recording material with the reference beam and the object beam on the same side thereof is referred to as "transmission hologram". The interference fringe is formed at an interval of from about 1,000 to 3,000 lines per mm in the direction perpendicular to or substantially perpendicular to the surface of the recording material.

On the other hand, the hologram formed by irradiating the hologram recording material with the reference beam and the object beam on opposite sides thereof is normally referred to as "reflection hologram". The interference fringe is formed at an interval of from about 1,000 to 3,000 lines per mm in the direction parallel to or substantially parallel to the surface of the recording material.

The transmission hologram can be prepared by any known method as disclosed in JP-A-6-43634, which corresponds to USP 4,942,112 [Patent Reference 1]. The reflection hologram can be prepared by any known method as disclosed in JP-A-2-3082 [Patent Reference 2] and JP-A-3-50588 [Patent Reference 3].

On the other hand, the hologram having a thickness which is sufficiently great relative to the interval of interference fringe (normally 5 or more times the interval of interference fringe or about 1 μm) is referred to as "volume-type hologram".

On the contrary, the hologram having a thickness which is 5 or less times the interval of interference fringe or about 1 μm or less is referred to as "flat type or surface type hologram".

Further, the hologram which records an interference fringe by the absorption of a dye or silver is referred to as "amplification-type hologram". The hologram which records an interference fringe by surface relief or refractive index modulation is referred to as "phase hologram". The amplification-type hologram undergoes a drastic reduction of light diffraction efficiency or reflection efficiency when light beam is absorbed and thus is disadvantageous in the efficiency of use of light beam. In general, the phase hologram is preferably used.

Holograms have been heretofore used for cover of books, magazines, etc., display such as POP, gift, etc. because of their excellent design and decorating effect. Holograms are also used for credit card, paper money, package, etc. for security purpose of preventing forgery and are now making a big market.

These holograms are flat surface relief phase holograms. Since these holograms are normally mass-produced by preparing an emboss using a master made of a photoresist, they are also referred to as "embossed holograms".

However, the surface relief phase holograms can be difficultly available in the form allowing full-color display, reproduction of white color image, high resolution display and high diffraction display. Therefore, volume phase holograms, which allow these performance, have been recently noted.

In accordance with the volume phase hologram, the phase of light beam can be modulated without absorbing light beam by forming a large number of interference fringes in a hologram rather than by optical absorption.

In particular, the reflection type volume phase hologram is also referred to as "Lipman type hologram". This type of a volume phase hologram makes wavelength-selective reflection involving Bragg diffraction to allow full-color display, reproduction of white image and high resolution display with a high diffraction efficiency and hence provide a

high resolution full-color three-dimensional display.

In recent years, the reflection type volume phase hologram has made the best use of its capability of wavelength-selective reflection to find wide practical application to hologram optical elements (HOE) such as head-up display (HUD) to be mounted on automobile, pickup lens for optical disc, head mount display, color filter for liquid crystal and reflective sheet for reflection type liquid crystal.

In addition, practical use or application of the reflection type volume phase hologram to lens, diffraction grating, interference filter, connector for optical fiber, light polarizer for facsimile, window glass for building, etc. has been studied.

Referring to known volume phase hologram recording materials, bichromatic acid gelatin process, bleached silver halide process and photopolymer process are known as write-once-read-many type process. As rewritable process there are known photorefractive process, photochromic process, etc.

However, none of these known volume phase hologram recording material can meet all the requirements particularly when used for high sensitivity high resolution full-color three-dimensional display. Thus, improvements of volume phase hologram recording materials have been desired.

In some detail, the bichromatic acid gelatin process is advantageous in that it has a high diffraction efficiency and a low noise but is disadvantageous in that it has extremely poor storage properties, requires wet processing and exhibits a low sensitivity.

The bleached silver halide process is advantageous in that it has a high sensitivity but is disadvantageous in that it requires wet processing and complicated bleaching and exhibits a deteriorated light-resistance.

The photorefractive material is advantageous in that it allows rewritable process but is disadvantageous in that it requires application of a high electric field during recording and exhibits deteriorated record storage properties.

The photochromic polymer process using an azobenzene polymer material or the like is advantageous in that it allows rewritable process but is disadvantageous in that it exhibits an extremely low sensitivity and deteriorated record storage properties.

Under these circumstances, the dry photopolymer process disclosed in the above cited Patent References 1 to 3 is essentially composed of a binder, a radical-polymerizable monomer and a photopolymerization initiator and is designed to use a compound having an aromatic ring, chlorine or bromine as one of the binder and the radical-polymerizable monomer so that a refractive index difference is provided to enhance refractive index modulation. In this arrangement, the polymerization proceeds while the monomer and the binder are being concentrated to the bright portion and dark portion, respectively, in the interference fringe formed during holographic exposure, making it possible to form a diffractive index difference. It can be thus said that the dry photopolymer process is a practical process that can realize both high diffraction efficiency and dry processing.

However, the dry photopolymer process is disadvantageous in that it exhibits a sensitivity as low as about one thousandths of that of the bleached silver halide process and requires about 2 hours of heat fixing to enhance diffraction efficiency. Further, since the dry photopolymer process involves radical polymerization, it is subject to effect of polymerization inhibition by oxygen. Moreover, the recording material which has been subjected to exposure and fixing undergoes shrinkage resulting in the change of diffraction wavelength and angle during reproduction. Further improvements of the dry photopolymer process have been desired.

In the midst of the recent high development of data communication, networks such as internet and high-vision TV have been rapidly spread. with the broadcasting of HDTV (High Definition Television) being close at hand, there has been a growing demand for a high density recording medium for recording image data of 100 GB or more simply at reduced cost also in consumers' use.

Further, in the midst of enhancement of computer capacity, there has been a demand for a ultrahigh density recording medium capable of recording data having a capacity as high as about 1 TB or more rapidly at reduced cost in business use such as computer backup and broadcasting backup.

Under these circumstances, small-sized inexpensive optical media which can be replaced and randomly accessed have been more and more noted in place of magnetic tape media, which cannot be randomly accessed, and hard disc, which can be replaced. However, the existing two-dimensional optical recording media such as DVD-R can be provided with a recording capacity of 25 GB at maximum according to physical principle even when the wavelength of recording and reproduction is reduced. Thus, the existing two-dimensional optical recording media cannot be expected to have a recording capacity high enough to meet the future requirements.

As a supreme ultrahigh density recording medium, a three-dimensional optical recording medium which performs recording in the thickness direction has been noted. Examples of effective methods for realizing such a three-dimensional optical recording medium include a method involving the use of a two-photon-absorption material and a method involving the use of holography (interference). Thus, the volume phase hologram recording material has recently been suddenly noted as a three-dimensional optical recording medium.

In the optical recording medium comprising a volume phase hologram recording material, a large number of two-dimensional digital data (referred to as "signal light") generated by spatial light modulation element (SLM) such

as DMD and LCD are recorded instead of object beam reflected by a three-dimensional object. Since recording involves multi-recording such as angle-multiple, phase-multiple, wavelength-multiple and shift-multiple, a recording capacity as high as 1 TB can be realized. CCD, CMOS or the like is used for reading. The parallel writing and reading by these elements makes it possible to realize a transmission speed as high as 1 Gbps.

However, the hologram recording material to be used in holographic memory has severer requirements than in three-dimensional display and HOE uses as follows.

(1) High sensitivity;
(2) High resolving power;
(3) High diffraction efficiency of hologram;
(4) Rapid dry processing during recording;
(5) Capability of multi-recording (wide dynamic range);
(6) Small shrinkage after recording; and
(7) Good storage properties of hologram

In particular, the requirements (3) (high diffraction efficiency), (4) (dry processing), (6) (small shrinkage after recording) and (7) (good storage properties) are contrary to the requirement (1) (high sensitivity) from the chemical standpoint of view. Thus, these requirements can be extremely difficultly met at the same time.

For example, the bleached silver halide process exhibits a high sensitivity but requires wet processing that makes it impossible for this process to find application in high density recording materials.

WO9744365A1 [Patent Reference 4] discloses a rewritable hologram recording material which makes the use of anisotropy in refractive index and orientation control of an azobenzene polymer (photochromic polymer) . However, this rewritable hologram recording material is disadvantageous in that it is subject to reduced quantum yield in azobenzene isomerization and is accompanied by orientation change, resulting in the production of extremely low sensitivity. Further, the rewritability is realized at the sacrifice of record storage properties. Thus, this process is far from practical.

On the other hand, the dry photopolymer process comprising radical polymerization as disclosed in Patent References 1 to 3 exhibits a relatively high sensitivity among photopolymer processes but undergoes an extremely high shrinkage and thus cannot be used in holographic memory use. Further, this dry process photopolymer forms a soft film and thus leaves something to be desired in storage properties as well.

In general, as opposed to radical polymerization, cationic polymerization, particularly accompanied by the ring opening of an epoxy compound or the like, undergoes little shrinkage after polymerization and no polymerization inhibition by oxygen and thus can give a rigid film. It is thus pointed out that cationic polymerization is preferred to radical polymerization in holographic memory use.

For example, JP-A-5-107999 [Patent Reference 5], JP-A-8-16078 [Patent Reference 6], etc. disclose a hologram recording material comprising a cation-polymerizable compound (monomer or oligomer) instead of binder in combination with a sensitizing dye, a radical polymerization initiator, a cationic polymerization initiator and a radical-polymerizable compound.

Further, JP-T-2001-523842 (the term "JP-T" as used herein means a published Japanese translation of a PCT patent application), which corresponds to WO 9926112A [Patent Reference 7], JP-T-11-512947 [Patent Reference 8], etc. disclose a hologram recording material comprising only a sensitizing dye, cationic polymerization initiator, a cation-polymerizable compound and a binder but free from radical polymerization.

Although these cationic polymerization processes show some improvements in shrinkage resistance as compared with radical polymerization processes, the sensitivity is sacrificed. This low sensitivity presumably causes a great trouble with transmission speed during practical use. The diffraction efficiency, too, is deteriorated, presumably causing a trouble with S/N ratio and multi-recording properties.

As previously mentioned, the photopolymer process involves the movement of materials. Accordingly, when the application of this process to holographic memory is studied, there occurs a dilemma that when it is tried to improve storage properties and reduce shrinkage, the resulting sensitivity is reduced (cationic polymerization process) while when it is tried to enhance sensitivity, the resulting storage properties and shrinkage resistance are deterioration (radical polymerization process). In order to enhance the recording density of holographic memory, multi-recording composed of 50 or more times, preferably 100 or more times of recording jobs is essential. However, since the photopolymer process performs recording involving polymerization accompanied by the movement of materials, the recording speed in the latter stage of multi-recording after the movement of majority of materials is lower than that in the initial stage of multi-recording. It is thus a practically great problem to adjust exposure by controlling the recording speed and obtain a wide dynamic range.

On the other hand, in the silver halide process, a latent image can be formed even when exposed to slight amount of light beam during holographic exposure as in the silver salt photograph system. The latent image thus formed

can be amplified at the development process. Accordingly, the silver halide process is extremely attractive from the standpoint of sensitivity as compared with other processes such as photopolymer process.

However, the silver halide process is not suitable for holographic memory use for the reason that it requires wet processing and it is of oscillation type rather than phase type and thus has an extremely low diffraction efficiency, although it involves the conversion of silver halide to developed silver (black).

The bleached silver halide process involving bleaching (oxidation) of developed silver back to silver halide forms a phase type process that can provide an enhanced diffraction efficiency. However, this process is also disadvantageous in that it exhibits deteriorated storage properties, causes much scattering and requires complicated wet processing and is not suitable for holographic memory use.

The aforementioned dilemma that high sensitivity and good storage properties and low shrinkage are contrary to each other and problems with multi-recording properties cannot be avoided in physical principle so far as the photopolymer process involving the movement of materials. In order to apply a hologram recording material to holographic memory, quite a new recording process giving drastic simultaneous solution to the aforementioned problems, particularly high sensitivity, low shrinkage, good storage properties and multi-recording properties, has been keenly desired.

Summary of the Invention

It is therefore an aim of the invention to provide a hologram recording material composition, a hologram recording material and hologram recording method having a high sensitivity as well as a high diffraction efficiency, good storage properties, a low shrinkage, a good dry-processability and multi-recording properties which can be applied to high density optical recording medium, three-dimensional display, holographic optical element, etc.

As a result of extensive studies by the inventors, it was found that the aims of the invention are accomplished by the following means.

(A-1) A hologram recording material composition comprising at least one set of compound group which allows hologram recording by a principle other than recording method involving polymerization accompanied by the movement of materials and recording method involving the change of orientation of a birefringent compound.

(A-2) The hologram recording material composition according to Clause (A-1), wherein holographic exposure is not followed by any wet processing.

(A-3) The hologram recording material according to Clause (A-1) or (A-2), wherein hologram recording employs a nonrewritable process.

(A-4) The hologram recording material composition according to any one of Clauses (A-1) to (A-3), comprising as a compound group allowing hologram recording at least a sensitizing dye which is subjected to holographic exposure to absorb light and produce excited state and an interference fringe recording component capable of undergoing chemical reaction when electron or energy moves from the excited state of sensitizing dye to record an interference fringe formed by holographic exposure.

(A-5) The hologram recording material composition according to Clause (A-4), wherein the interference fringe recording component contains a dye precursor which can form a colored material having absorption in a longer wavelength than the original state when electron or energy moves from the excited state of sensitizing dye.

(A-6) The phase hologram recording material composition according to any one of Clauses (A-1) to (A-5), wherein the hologram recording material is a phase hologram recording materialwhichrecords an interference fringe by refractive index modulation.

(A-7) The phase hologram recording material composition according to Clause (A-5) or (A-6) , wherein the dye precursor contained in the interference fringe recording component can form a colored material having absorption in a longer wavelength than the original state when electron or energy moves from the excited state of sensitizing dye, which, afterholographicexposure, turns out to be a colored material having no absorption in the wavelength of hologram-reproducing light but absorption in a shorter wavelength than the wavelength of hologram-reproducing light, resulting in the formation of a phase hologram recording material which can form an interference fringe by refractive index modulation.

(A-8) The phase hologram recording material composition according to Clause (A-7), wherein the dye precursor contained in the interference fringe recording component can form a colored material having absorption in a longer wavelength than the original state when electron or energy moves from the excited state of sensitizing dye, which, after holographic exposure, turns out to be a colored material having no absorption in the wavelength of hologram-reproducing light but absorption maximum in the range between the wavelength of hologram-reproducing light and the wavelength 200 nm shorter than the wavelength of hologram-reproducing light, resulting in the formation of a phase hologram recording material which can form an interference fringe by refractive index modulation.

(A-9) The phase hologram recording material composition according to Clause (A-8), wherein the dye precursor contained in the interference fringe recording component can form a colored material having absorption in a longer

wavelength than the original state when electron or energy moves from the excited state of sensitizingdye, which, after holographic exposure, turns out to be a colored material having no absorption in the wavelength of hologram-reproducing light but absorption maximum in the range between the wavelength of hologram-reproducing light and the wavelength 100 nm shorter than the wavelength of hologram-reproducing light, resulting in the formation of a phase hologram recording material which can form an interference fringe by refractive index modulation.

(A-10) The hologram recording material composition according to any one of Clauses (A-4) to (A-9), wherein the interference fringe recording component comprises at least an acid-induced color-forming dye precursor as a dye precursor and an acid generator.

(A-11) The hologram recording material composition according to Clause (A-10), wherein the acid generator is a diaryl iodonium salt, sulfonium salt, diazonium salt, metal arene complex, trihalomethyl-substituted triazine or sulfonic acid ester.

(A-12) The hologram recording material composition according to Clause (A-11), wherein the acid generator is a diaryl iodonium salt, sulfonium salt or sulfonic acid ester.

(A-13) The hologram recording material composition according to any one of Clauses (A-10) to (A-12), wherein the dye produced by the acid-induced color-forming dye precursor is a xanthene (preferably fluorane) dye or triphenylmethane dye.

(A-14) The hologram recording material composition according to any one of Clauses (A-10) to (A-13), wherein the interference fringe recording component comprises at least an acid-induced color-forming dye precursor as a dye precursor, an acid generator and an acid proliferator.

(A-15) The hologram recording material composition according to Clause (A-14), wherein the acid proliferator is represented by any of the following general formulae (4-1) to (4-6):

Formula (4-1)

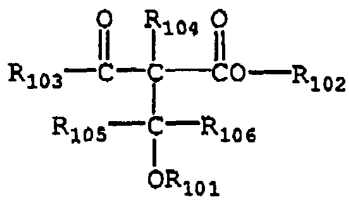

Formula (4-2)

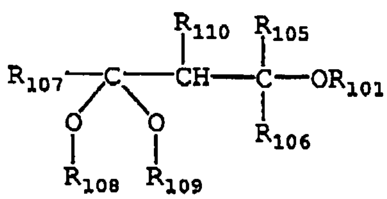

Formula (4-3)

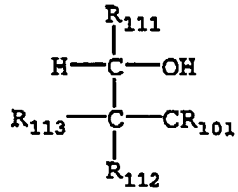

Formula (4-4)

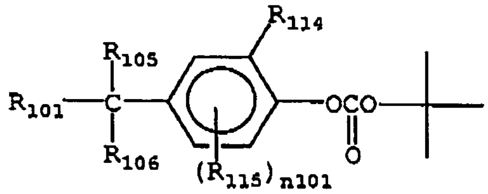

Formula (4-5)

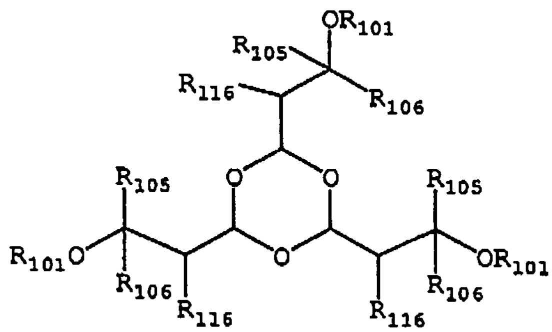

Formula (4-6)

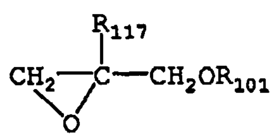

wherein $R_{101}$ represents a group which forms an acid having pKa of 5 or less in the form of $R_{101}$ OH; $R_{102}$ represents any of 2-alkyl-2-propyl group, 2-aryl-2-propyl group, cyclohexyl group, tetrahydropyranyl group and bis(p-alkoxyphenyl)methyl group; $R_{103}$, $R_{104}$, $R_{115}$ and $R_{117}$ each independently represent a substituent; $R_{105}$, $R_{106}$, $R_{107}$, $R_{110}$, $R_{113}$ and $R_{116}$ each independently represent a hydrogen atom or substituent; $R_{108}$ and $R_{109}$ each represent an alkyl group and may be connected to each other to form a ring; $R_{111}$ and $R_{112}$ represent alkyl groups which are connected to each other to form a ring; $R_{114}$ represents a hydrogen atom or nitro group; and n101 represents an integer of from 0 to 3.

(A-16) The hologram recording material composition according to Clause (A-15), wherein in the general formulae (4-1) to (4-6), $R_{101}$ represents any of sulfonic acid and electrophilic group-substituted carboxylic acid in the form of $R_{101}OH$.

(A-17) The hologram recording material composition according to anyone of Clauses (A-4) to (A-9), wherein the interference fringe recording component comprises at least a base-induced color-forming dye precursor as a dye precursor and a base generator.

(A-18) The hologram recording material composition according to Clause (A-17), wherein the base generator is represented by any of the following general formulae (1-1) to (1-4):

Formula (1-1):

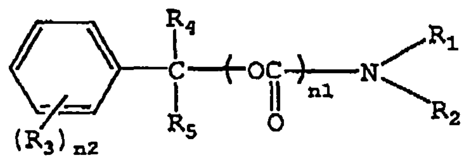

Formula (1-2):

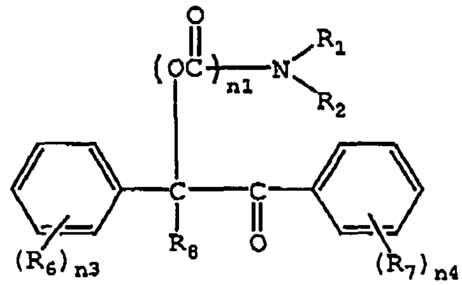

Formula (1-3):

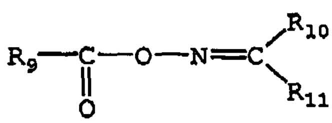

Formula (1-4):

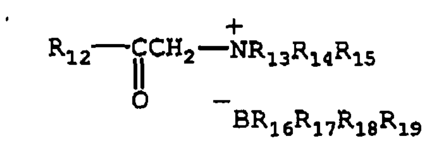

wherein $R_1$, $R_2$, $R_{13}$, $R_{14}$ and $R_{15}$ each independently represent any one of hydrogen atom, alkyl group, alkenyl group, cycloalkyl group, aryl group and heterocyclic group; $R_1$ and $R_2$ may be connected to each other to form a ring; $R_{13}$, $R_{14}$ and $R_{15}$ may be connected to each other to form a ring; $R_3$, $R_6$, $R_7$ and $R_9$ each independently represent a substituent; $R_4$, $R_5$, $R_8$, $R_{10}$ and $R_{11}$ each independently represent a hydrogen atom or substituent; $R_{10}$ and $R_{11}$ may be connected to each other to form a ring; $R_{16}$, $R_{17}$, $R_{18}$ and $R_{19}$ each independently represent an alkyl or aryl group; $R_{12}$ represents an aryl group or heterocyclic group; n1 represents an integer of 0 or 1; and n2 to n4 each independently represent an integer of from 0 to 5.

(A-19) The hologram recording material composition according to Clause (A-18), wherein in the general formulae (1-1) and (1-2), n1 is 1.

(A-20) The hologram recording material composition according to Clause (A-18) or (A-19), wherein in the general formula (1-1), $R_3$ represents a 2- or 2,6-substituted nitro group or 3,5-substituted alkoxy group.

(A-21) The hologram recording material composition according to Clause (A-18) or (A-19), wherein in the general formula (1-2), $R_6$ represents a 3,5-substituted alkoxy group.

(A-22) The hologram recording material composition according to any one of Clauses (A-17) to (A-21), wherein the base-induced color-forming dye precursor is an undissociated form of dissociative azo dye, dissociative azomethine dye, dissociative oxonol dye, dissociative xanthene (preferably fluorane) dye or dissociative triphenylmethane dye.

(A-23) The hologram recording material composition according to any one of Clauses (A-17) to (A-22), wherein the interference fringe recording component comprises at least a base-induced color-forming dye precursor as a

dye precursor, a base generator and a base proliferator.

(A-24) The hologram recording material composition according to Clause (A-23), wherein the base proliferator is represented by the following general formula (5):

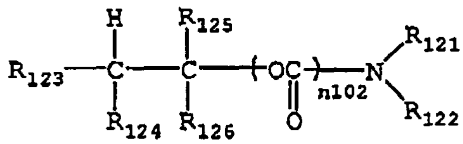

wherein $R_{121}$ and $R_{122}$ each independently represent any one of hydrogen atom, alkyl group, alkenyl group, cycloalkyl group, aryl group and heterocyclic group; $R_{121}$ and $R_{122}$ may be connected to each other to form a ring; $R_{123}$ and $R_{124}$ each independently represent a substituent; $R_{123}$ and $R_{124}$ may be connected to each other to form a ring; $R_{125}$ and $R_{126}$ each independently represent a hydrogen atom or substituent; and n102 represents an integer of 0 or 1.

(A-25) The hologram recording material composition according to Clause (A-24), wherein in the general formula (5), n102 is 1.

(A-26) The hologram recording material composition according to Clause (A-24) or (A-25), wherein the base proliferator of the general formula (5) is represented by the following general formula (6-1) or (6-2):

Formula (6-1):

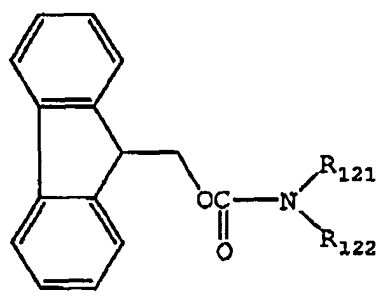

Formula (6-2):

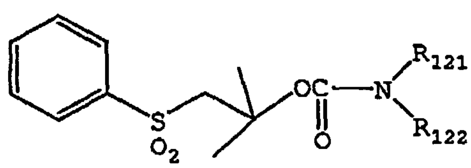

wherein $R_{121}$ and $R_{122}$ are according to the general formula (5).

(A-27) The hologram recording material composition according to any one of Clauses (A-4) to (A-9), wherein the interference fringe recording component comprises at least a dye precursor represented by the following general formula (2):

A1-PD (2)

wherein A1 and PD are covalently bonded to each other; A1 represents an organic compound moiety capable of severing the covalent bonding to PD when electron or energy transfers from the excited state of sensitizing dye; and PD represents an organic compound moiety which differs in absorption form between when covalently bonded to A1 and when severed and released from the covalent bonding to A1.

(A-28) The hologram recording material composition according to Clause (A-27), wherein the dye precursor of the general formula (2) is represented by any of the following general formulae (3-1) to (3-6):

Formula (3-1):

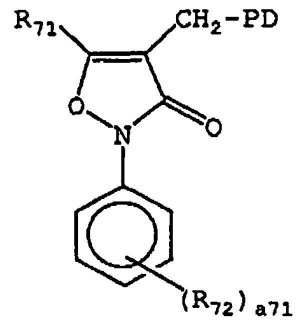

Formula (3-2):

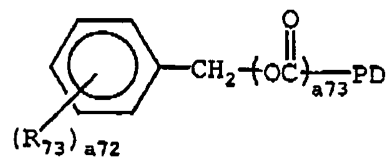

Formula (3-3):

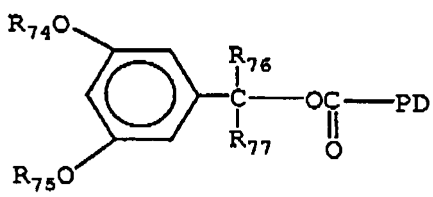

Formula (3-4):

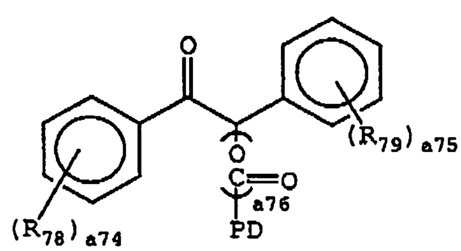

Formula (3-5):

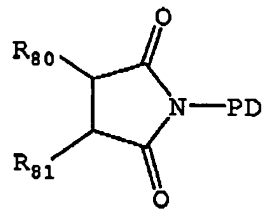

Formula (3-6):

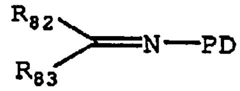

wherein PD is according to the general formula (2); $R_{71}$, $R_{80}$ and $R_{81}$ each independently represent a hydrogen atom or substituent; $R_{72}$, $R_{73}$, $R_{78}$, $R_{79}$, $R_{82}$ and $R_{83}$ each independently represent a substituent; $R_{74}$ to $R_{77}$ each independently represent an alkyl group; a71, a72, a74 and a75 each independently represent an integer of from 0 to 5; a73 and a76 each independently represent 0 or 1; when a71, a72, a74 and a75 are 2 or more, the plurality of $R_{72}$'S, $R_{73}$'S, $R_{78}$'S and $R_{79}$'S each may be the same or different or may be connected to each other to form a ring; $R_{80}$ and $R_{81}$ may be connected to each other to form a ring; and $R_{82}$ and $R_{83}$ may be connected to each other to form a ring.

(A-29) The hologram recording material composition according to Clause (A-27) or (A-28), wherein in the general formula (2) or general formulae (3-1) to (3-6), PD is a group formed by any of dissociative azo dye, dissociative azomethine dye, dissociative oxonol dye, triphenylmethane dye and xanthene dye and covalently bonded to A1 on a chromophore.

(A-30) The hologram recording material composition according to anyone of Clauses (A-1) to (A-29) , comprising an electron-donating compound capable of reducing radical cations of sensitizing dye or an electron-accepting compound capable of oxidizing radical anions of sensitizing dye.

(A-31) The hologram recording material composition according to Clause (A-30), wherein there is incorporated an electron-donating compound which is any one of alkylamine, aniline, phenylenediamine, triphenylamine, carbazole, phenothiazine, phenoxazine, phenazine, hydroquinone, catechol, alkoxybenzene, aminophenol, imidazole, pyridine, metalocene, metal complex and particulate semiconductor.

(A-32) The hologram recording material composition according to Clause (A-31), wherein the electron-donating compound is a phenothiazine.

(A-33) The hologram recording material composition according to any one of Clauses (A-1) to (A-29), comprising an electron-accepting compound capable of oxidizing radical anions of sensitizing dye.

(A-34) The hologram recording material composition according to Clause (A-33), wherein there is incorporated an electron-accepting compound which is any one of aromatic compound having an electrophilic group incorporated therein such as dinitrobenzene and dicyanobenzene, heterocyclic compound, heterocyclic compound having an electrophilic group incorporated therein, N-alkylpyridinium salt, benzoquinone, imide, metal complex and particulate semiconductor.

(A-35) A hologram recording material comprising a hologram recording material composition according to any one of Clauses (A-1) to (A-32).

(A-36) A non rewritable process hologram recording method comprising a step at which a sensitizing dye is subjected to exposure to absorb light and produce excited state, a chemical reaction step involving color development reaction accompanied by the transfer of electron or energy from the excited state and a hologram formation step involving the chemical reaction.

(A-37) The hologram recording method according to Clause (A-36), wherein exposure is not followed by any wet processing.

(A-38) The hologram recording method according to Clause (A-35), wherein volume phase hologram recording is conducted using a hologram recording material according to Clause (A-35).

(A-39) The hologram recording method according to Clause (A-35) or (A-36), wherein holographic exposure is followed by heat treatment during hologram recording using a hologram recording material according to Clause (A-35).

(A-40) The hologram recording method according to any one of Clauses (A-36) to (A-39), wherein multi-recording (preferably composed of 50 or more times of recording) is conducted using a hologram recording material according to Clause (A-35).

(A-41) The hologram recording method according to Clause (A-40), wherein multi-recording composed of 100 or more times of recording is conducted using a hologram recording material according to Clause (A-35).

(A-42) The hologram recording method according to Clause (A-40) or (A-41), wherein any multi-recording can be effected with exposure kept constant.

(A-43) An optical recording medium comprising a hologram recording material according to Clause (A-35) and amethod for recording on the optical recording medium.

(A-44) The optical recording medium according to Clause (A-43), wherein the hologram recording material according to Clause (A-35) is kept in a light-shielding cartridge during storage.

(A-45) A three-dimensional display hologram comprising a hologram recording material according to any one of Clauses (A-35) to (A-42) and employing a hologram recording method according to any one of Clauses (A-35) to (A-42) and a process for the production of the three-dimensional display hologram.

(A-46) A holographic optical element comprising a hologram recording material according to any one of Clauses (A-35) to (A-42) and employing a hologram recording method according to any one of Clauses (A-35) to (A-42) and a process for the production of the holographic optical element.

(B-1) A hologram recording method comprising at least a first step at which holographic exposure is effected to form a latent image and a second step at which the latent image is amplified to form an interference fringe , wherein the two steps are effected in a dry process (The first step corresponds to the hologram recording according to Clause (A-1)).

(B-2) The hologram recording method according to Clause (B-1), wherein the second step comprises amplifying the latent image to perform refractive index modulation by which an interference fringe is formed.

(B-3) The hologram recording method according to Clause (B-1) or (B-2) , wherein the second step is triggered by any one of irradiation with light, application of heat and application of electric field.

(B-4) The hologram recording method according to Clause (B-3), wherein the second step involves any one of irradiation with light, application of heat and application of electric field and a hologram recording material allowing such a recording.

(B-5) The hologram recording method according to Clause (B-3), wherein the second step involves any of irradiation with light and application of heat.

(B-6) The hologram recording method according to Clause (B-3), wherein the second step involves irradiation with light.

(B-7) The hologram recording method according to any one of Clauses (B-1) to (B-7), wherein the first step comprises forming a colored material having no absorption in the wavelength of hologram-reproducing light as a latent image and the second step comprises irradiating the colored material latent image with light having a different wavelength from that of holographic exposure to make self-sensitized amplified production of colored material by which an interference fringe is recorded as refractive index modulation.

(B-8) The hologram recording method according to any one of Clauses (B-1) to (B-7), wherein no silver halides are used.

(B-9) The hologram recording method according to any one of Clauses (B-1) to (B-8), wherein hologram recording employs a nonrewritable process.

(B-10) A hologram recording material allowing hologram recording by a hologram recording method according to any one of Clause (B-1) to (B-9), comprising as a compound group at least:

1) a sensitizing dye which absorbs light at holographic exposure of the first step to produce excited state; and
2) an interference fringe recording component containing a dye precursor which can form a colored material having absorption in a longer wavelength than the original state and no absorption in the wavelength of hologram-reproducing light and capable of recording an interference fringe using refractive index modulation by color development which occurs via the step of transfer of electron or energy from the excited state of sensitizing dye or colored material.

(B-11) The hologram recording material according to Clause (B-10), wherein the dye precursor contained in the interference fringe recording component can form a colored material having absorption in a longer wavelength than the original state, no absorption in the wavelength of hologram-reproducing light and an absorption maximum in the range between the wavelength of hologram-reproducing light and the wavelength 200 nm shorter than the wavelength of hologram-reproducing light.

(B-12) The hologram recording material according to Clause (B-11), wherein the dye precursor contained in the interference fringe recording component can form a colored material having absorption in a longer wavelength

than the original state, no absorption in the wavelength of hologram-reproducing light and an absorption maximum in the range between the wavelength of hologram-reproducing light and the wavelength 100 nm shorter than the wavelength of hologram-reproducing light.

(B-13) The hologram recording method according to any one of Clauses (B-10) to (B-12), comprising a first step at which a hologram recording material according to Clause (B-10) to (B-12) is subjected to holographic exposure to produce excited state of sensitizing dye from which electron or energy moves to an interference fringe recording component to form a colored material having absorption in a longer wavelength than the original state and no absorption in the wavelength of hologram-reproducing light as a latent image and a second step at which the hologram recording material is irradiated with light having a wavelength different from and shorter than that of holographic exposure within which wavelength the molar absorptivity of the sensitizing dye is 5,000 or less to allow the colored material formed as a latent image at the first step to be self-sensitized, causing color development by which refractive index modulation is effected to record an interference fringe, wherein the two steps are effected in a dry process, and a hologram recording material allowing the recording method.

(B-14) The hologram recording method according to Clause (B-13), wherein the second step comprises irradiating the hologram recording material with light having a wavelength different from and shorter than that of holographic exposure within which wavelength the molar absorptivity of the sensitizing dye is 1,000 or less to allow the colored material formed as a latent image at the first step to be self-sensitized, causing color development by which refractive index modulation is effected to record an interference fringe and a hologram recording material allowing the recording method.

(B-15) The hologram recording method according to Clause (B-13), wherein the second step comprises irradiating the hologram recording material with light having a wavelength different from and shorter than that of holographic exposure within which wavelength the molar absorptivity of the sensitizing dye is 500 or less to allow the colored material formed as a latent image at the first step to be self-sensitized, causing color development by which refractive index modulation is effected to record an interference fringe and a hologram recording material allowing the recording method.

(B-16) The hologram recording method according to any one of Clauses (B-10) to (B-15), wherein the second step comprises irradiating the hologram recording material with light having a wavelength different from and shorter than that of holographic exposure within which wavelength the molar absorptivity of the sensitizing dye is 1,000 or more to allow the colored material formed as a latent image at the first step to be self-sensitized, causing color development by which refractive index modulation is effected to record an interference fringe and a hologram recording material allowing the recording method.

(B-17) The hologram recording material according to any one of Clauses (B-10) to (B-16), wherein the interference fringe recording component comprises at least an acid-induced color-forming dye precursor as a dye precursor and an acid generator.

(B-18) The hologram recording material according to Clause (B-17), wherein the acid generator is a diaryl iodonium salt, sulfonium salt, diazonium salt, trihalomethyl-substituted triazine or sulfonic acid ester.

(B-19) The hologram recording material according to Clause (B-18), wherein the acid generator is a diaryl iodonium salt, sulfonium salt or sulfonic acid ester.

(B-20) The hologram recording material according to any one of Clauses (B-17) to (B-19) , wherein the colored material produced by the acid-induced color-forming dye precursor is a xanthenic (preferably fluorane-based) dye or triphenylmethane dye.

(B-21) The hologram recording material according to any one of Clauses (B-17) to (B-21), wherein the interference fringe recording component further comprises an acid proliferator.

(B-22) The hologram recording material according to Clause (B-21), wherein the acid proliferator is a compound represented by any one of the following general formulae (4-1) to (4-6):

Formula (4-1)

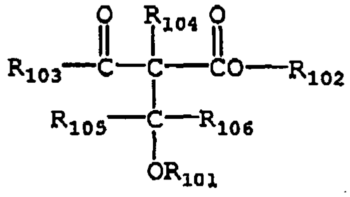

Formula (4-2)

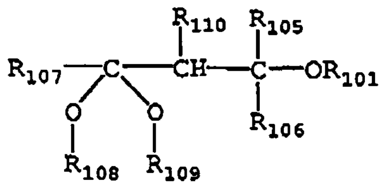

Formula (4-3)

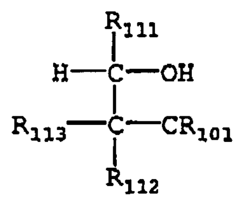

Formula (4-4)

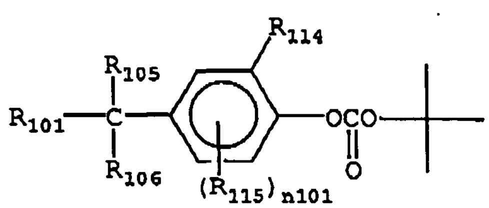

Formula (4-5)

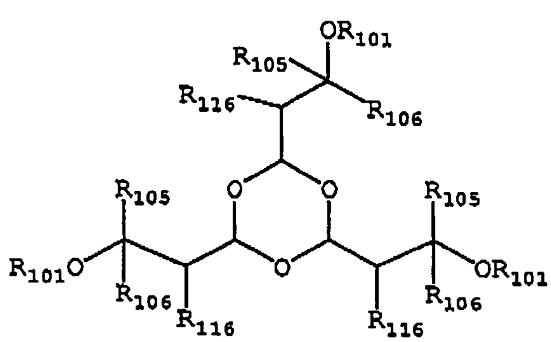

Formula (4-6)

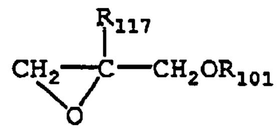

wherein $R_{101}$ represents a group which forms an acid having pKa of 5 or less in the form of $R_{101}$ OH; $R_{102}$ represents any of 2-alkyl-2-propyl group, 2-aryl-2-propyl group, cyclohexyl group, tetrahydropyranyl group and bis(p-alkoxyphenyl)methyl group; $R_{103}$, $R_{104}$, $R_{115}$ and $R_{117}$ each independently represent a substituent; $R_{105}$, $R_{106}$, $R_{107}$, $R_{110}$, $R_{113}$ and $R_{116}$ each independently represent a hydrogen atom or substituent; $R_{108}$ and $R_{109}$ each represent an alkyl group and may be connected to each other to form a ring; $R_{111}$ and $R_{112}$ represent alkyl groups which are connected to each other to form a ring; $R_{114}$ represents a hydrogen atom or nitro group; and n101 represents an integer of from 0 to 3.

(B-23) The hologram recording material composition according to Clause (B-22), wherein in the general formulae (4-1) to (4-6), $R_{101}$ represents any of sulfonic acid and electrophilic group-substituted carboxylic acid in the form of $R_{101}OH$.

(B-24) The hologram recording material composition according to any one of Clauses (B-10) to (B-16), wherein the interference fringe recording component comprises at least abase-induced color-forming dye precursor as a dye precursor and a base generator.

(B-25) The hologram recording material composition according to Clause (B-24), wherein the base generator is represented by any of the following general formulae (1-1) to (1-4):

Formula (1-1):

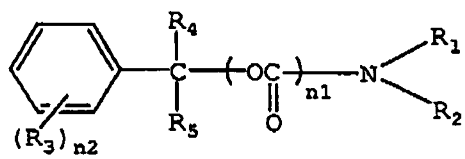

Formula (1-2):

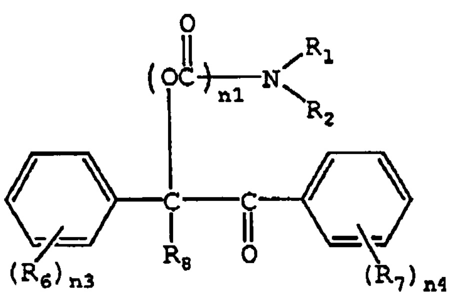

Formula (1-3):

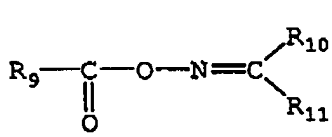

Formula (1-4):

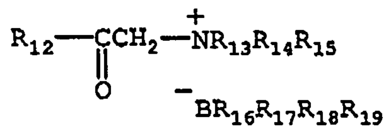

wherein $R_1$, $R_2$, $R_{13}$, $R_{14}$ and $R_{15}$ each independently represent any one of hydrogen atom, alkyl group, alkenyl group, cycloalkyl group, aryl group and heterocyclic group; $R_1$ and $R_2$ may be connected to each other to form a ring; $R_{13}$, $R_{14}$ and $R_{15}$ may be connected to each other to form a ring; $R_3$, $R_6$, $R_7$ and $R_9$ each independently represent a substituent; $R_4$, $R_5$, $R_8$, $R_{10}$ and $R_{11}$ each independently represent a hydrogen atom or substituent; $R_{10}$ and $R_{11}$ may be connected to each other to form a ring; $R_{16}$, $R_{17}$, $R_{18}$ and $R_{19}$ each independently represent an alkyl or aryl group; $R_{12}$ represents an aryl group or heterocyclic group; n1 represents an integer of 0 or 1; and n2 to n4 each independently represent an integer of from 0 to 5.

(B-26) The hologram recording material composition according to Clause (B-25), wherein in the general formulae (1-1) and (1-2), n1 is 1.

(B-27) The hologram recording material composition according to Clause (B-25) or (B-26), wherein in the general formula (1-1), $R_3$ represents a 2- or 2,6-substituted nitro group or 3,5-substituted alkoxy group.

(B-28) The hologram recording material composition according to Clause (B-25) or (B-26), wherein in the general formula (1-2), $R_6$ represents a 3,5-substituted alkoxy group.

(B-29) The hologram recording material composition according to any one of Clauses (B-24) to (B-28), wherein the base-induced color-forming dye precursor is an undissociated form of dissociative azo dye, dissociative azomethine dye, dissociative oxonol dye, dissociative xanthene-based (preferably fluorane-based) dye or dissociative triphenylmethane dye.

(B-30) The hologram recording material composition according to any one of Clauses (B-24) to (B-29), wherein the interference fringe recording component further comprises a base proliferator.

(B-31) The hologram recording material composition according to Clause (B-30), wherein the base proliferates is represented by the following general formula (5):

Formula (5):

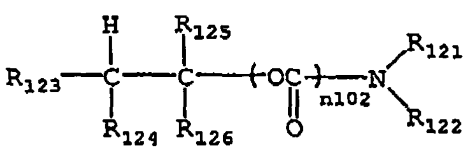

wherein $R_{121}$ and $R_{122}$ each independently represent any one of hydrogen atom, alkyl group, alkenyl group, cycloalkyl group, aryl group and heterocyclic group; $R_{121}$ and $R_{122}$ may be connected to each other to form a ring; $R_{123}$ and $R_{124}$ each independently represent a substituent; $R_{123}$ and $R_{124}$ may be connected to each other to form a ring; $R_{125}$ and $R_{126}$ each independently represent a hydrogen atom or substituent; and n102 represents an integer of 0 or 1.

(B-32) The hologram recording material composition according to Clause (B-31), wherein in the general formula (5), n102 is 1.

(B-33) The hologram recording material composition according to Clause (B-31) or (B-32), wherein the base proliferator of the general formula (5) is represented by the following general formula (6-1) or (6-2):

Formula (6-1):

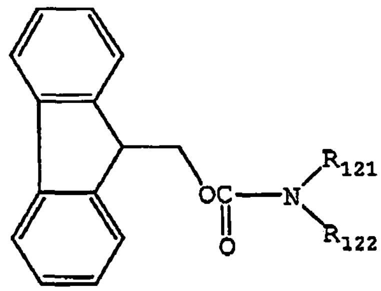

Formula (6-2):

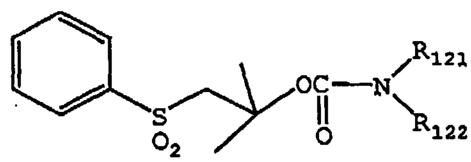

wherein $R_{121}$ and $R_{122}$ are according to the general formula (5).

(B-34) The hologram recording material composition according to any one of Clauses (B-10) to (B-16), wherein the interference fringe recording component comprises at least a dye precursor represented by the following general formula (2):

$$A1\text{-}PD \quad (2)$$

wherein A1 and PD are covalently bonded to each other; A1 represents an organic compound moiety capable of severing the covalent bonding to PDwhen electron or energy transfers to the excited state of sensitizing dye or colored material; and PD represents an organic compound moiety which differs in absorption form between when covalently bonded to A1 and when severed and released from the covalent bonding to A1.

(B-35) The hologram recording material composition according to Clause (B-34), wherein the dye precursor of the general formula (2) is represented by any of the following general formulae (3-1) to (3-6):

Formula (3-1):

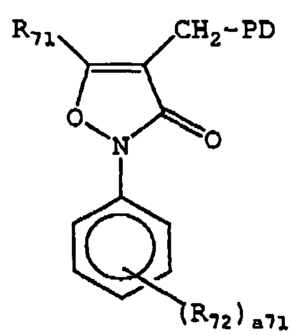

Formula (3-2):

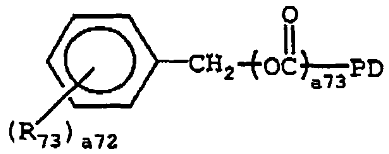

Formula (3-3):

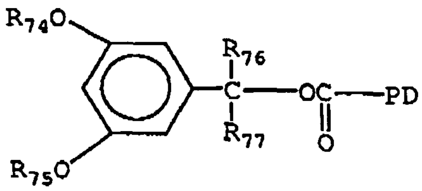

Formula (3-4):

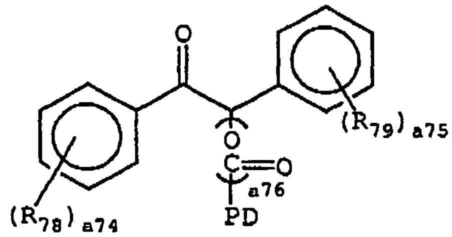

Formula (3-5):

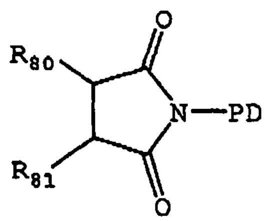

Formula (3-6):

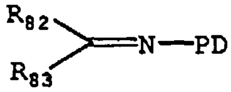

wherein PD is according to the general formula (2); $R_{71}$, $R_{80}$ and $R_{81}$ each independently represent a hydrogen atom or substituent; $R_{72}$, $R_{73}$, $R_{78}$, $R_{79}$, $R_{82}$ and $R_{83}$ each independently represent a substituent; $R_{74}$ to $R_{77}$ each independently represent an alkyl group; a71, a72, a74 and a75 each independently represent an integer of from 0 to 5; a73 and a76 each independently represent 0 or 1; when a71, a72, a74 and a75 are 2 or more, the plurality of $R_{72}$'s, $R_{73}$'s, $R_{78}$'s and $R_{79}$'s each may be the same or different or may be connected to each other to form a ring; $R_{80}$ and $R_{81}$ may be connected to each other to form a ring; and $R_{82}$ and $R_{83}$ may be connected to each other to form a ring.

(B-36) The hologram recording material composition according to Clause (B-34) or (B-35), wherein in the general formula (2) or general formulae (3-1) to (3-6), PD is a group formed by any of dissociative azo dye, dissociative azomethine dye, dissociative oxonol dye, triphenylmethane dye and xanthene dye and covalently bonded to A1 on a chromophore.
(B-37) The hologram recording material composition according to any one of Clauses (B-1) to (B-36) , comprising an electron-donating compound capable of reducing radical cations of colored material produced by sensitizing dye or dye precursor or an electron-accepting compound capable of oxidizing radical anions of colored material produced by sensitizing dye or dye precursor.
(B-38) The hologram recording material composition according to Clause (B-37), wherein there is incorporated an electron-donating compound which is any one of alkylamine, aniline, phenylenediamine, triphenylamine, carbazole, phenothiazine, phenoxazine, phenazine, hydroquinone, catechol, alkoxybenzene, aminophenol, imidazole, pyridine, metalocene, metal complex and particulate semiconductor.
(B-39) The hologram recording material composition according to Clause (B-38), wherein the electron-donating compound is a phenothiazine.
(B-40) The hologram recording material composition according to Clause (B-37), wherein the electron-accepting compound is any one of aromatic compound having an electrophilic group incorporated therein such as dinitrobenzene and dicyanobenzene, heterocyclic compound, heterocyclic compound having an electrophilic group incorporated therein, N-alkylpyridinium salt, benzoquinone, imide, metal complex and particulate semiconductor.
(B-41) A volume phase hologram recording method involving volume phase hologram recording using a hologram recording material according to any one of Clauses (B-1) to (B-40) and a volume phase hologram recording material allowing the volume phase type recording.
(B-42) The hologram recording method according to any one of Clauses (B-1) to (B-41), wherein holographic exposure is followed by heat treatment at the second step or subsequent steps during hologram recording using a hologram recording material according to any one of Clauses (B-1) to (B-41), and a hologram recording material allowing the recording.
(B-43) The hologram recording method according to any one of Clauses (B-1) to (B-42), wherein 10 or more times of multi-hologram recording jobs are conducted using a hologram recording material according to any one of Clauses (B-1) to (B-42) to form a latent image at a first step which is followed by a second step at which the latent image is used to form an interference fringe , and a hologram recording material allowing the recording.
(B-44) The hologram recording method according to Clause (B-43) wherein 100 or more times of multi-hologram recording jobs are conducted using a hologram recording material according to Clause (B-43) form a latent image at a first step which is followed by a second step at which the latent image is used to form an interference fringe, and a hologram recording material allowing the recording.
(B-45) The hologram recording material and hologram recording method according to any one of Clauses (B-1) to (B-44), wherein any multi-recording job can be effected with exposure kept constant during multi-hologram recording at the first step.
(B-46) An optical recording medium comprising a hologram recording material according to any one of Clauses (B-1) to (B-45) and a method of recording and reproducing on an optical recording medium using a hologram recording and reproducing method according to any one of Clauses (B-1) to (B-45).
(B-47) An optical recording medium wherein a hologram recording material according to any one of Clauses (B-1) to (B-45) is kept in a light-shielding cartridge during storage.
(B-48) A three-dimensional display hologram comprising a hologram recording material according to any one of Clauses (B-1) to (B-44) and a process for the production of a three-dimensional display hologram using a hologram recording method according to any one of Clauses (B-1) to (B-44).
(B-49) A holographic optical element comprising a hologram recording material according to any one of Clauses (B-1) to (B-44) and a process for the production of a holographic optical element using a hologram recording method according to any one of Clauses (B-1) to (B-44).

It was found that the use of the hologram recording material of the invention makes it possible to perform hologram recording with a high sensitivity, a high diffraction efficiency and a linear rise of refractive index modulation relative to exposure. Further, since no shrinkage occurs during recording, the hologram recording material is advantageous in transfer speed, multi-recording properties, etc. during the application to holographic memory, etc.

It was also found that the use of the holographic exposure latent image-color forming self-sensitized amplification process hologram recording material and method of the invention makes it possible to perform hologram recording with a high sensitivity, a high diffraction efficiency and a linear rise of refractive index modulation relative to exposure. Further, since no shrinkage occurs during recording, the holographic exposure latent image-color forming self-sensitized amplification process hologram recording material and method of the invention are advantageous in transfer speed, multi-recording properties, recording density, etc. during the application to holographic memory, etc.

Brief Description of the Drawing

The sole figure is a schematic view showing a 2-beam optical system for holographic exposure.

Description of Symbols:

| | |
|---|---|
| 10 | YAG laser |
| 12 | laser beam |
| 14 | mirror |
| 20 | beam splitter |
| 22 | beam segment |
| 24 | mirror |
| 26 | spatial filter |
| 40 | beam expander |
| 30 | hologram recording material |
| 28 | sample |
| 32 | He-Ne laser beam |
| 34 | He-Ne laser |
| 36 | detector |
| 38 | rotating stage |

Detailed Description of the Invention

The hologram recording material composition and hologram recording material of the invention will be further described hereinafter.

The hologram recording material of the invention and its composition comprises at least one set of compound group allowing hologram recording by a principle other than recording method involving polymerization accompanied by the movement of materials and recording method involving the change of orientation of a birefringent compound.

The hologram recording material of the invention preferably involves no wet processing after holographic exposure.

Further, the hologram recording method of the invention preferably employs a nonrewritable process. The term "nonrewritable process" as used herein is meant to indicate a process involving recording by an irreversible reaction allowing the storage of data once recorded without being overwritten (rewritten). Accordingly, the nonrewritable process is suitable for storage of data which are important and needed to be stored over an extended period of time. However, the nonrewritable process allows additional recording of data on unwritten area. In this sense, the nonrewritable process is normally called "write-once-read-many process".

The compound group allowing hologram recording of the invention preferably contains at least a sensitizing dye which is subjected to holographic exposure to absorb light and produce excited state and an interference fringe recording component which undergoes chemical reaction when electron or energy moves from the excited state of sensitizing dye to record an interference fringe formed by holographic exposure.

Further, the interference fringe recording component preferably contains a dye precursor which can form a colored material that changes in its absorption from the original state directly or indirectly (e.g., via the generation of an acid or base) when electron or energy moves from the excited state of sensitizing dye.

In the invention, even if the precursor is colored, the reaction involving the change of its absorption wavelength or absorptivity is called color development reaction and the dye produced by the color development reaction is called colored material. In other words, the color development reaction contains fading reaction.

The hologram recording method of the invention and the hologram recording material allowing the recording method are characterized in that there comprises at least a first step at which holographic exposure is conducted to form a latent image and a second step at which the latent image is amplified to form an interference fringe , wherein the two steps are effected in a dry process. More preferably, there comprises a second step at which the latent image is amplified to perform refractive index modulation by which an interference fringe is formed.

The term "latent image" as used in the first step of the invention is meant to indicate an "interference fringe which has been subjected to refractive index modulation in a proportion of preferably half or less of refractive index modulation formed after the second step (that is, a step of amplification of a factor or two or more is effected or a diffraction efficiency rise of twice or more is shown at the second step), more preferably one fifth or less, more preferably one tenth or less of refractive index modulation formed after the second step (that is, a step of amplification of a factor

or preferably 5 or more, more preferably 10 or more, even more preferably 30 or more is effected or a diffraction efficiency rise of preferably 5 or more times, more preferably 10 or more times, even more preferably 30 or more times is shown at the second step)".

The second step is preferably triggered by any one of irradiation with light, application of heat, application of electric field and application of magnetic field. These treatments are preferably made on the entire surface of the recording material.

The second step preferably involves any one of irradiation with light, application of heat and application of electric field, more preferably either irradiation with light or application of heat, most preferably irradiation with light.

In the case where the second step involves irradiation with light, the recording material is preferably exposed to light on the entire surface thereof (so-called solid exposure, blanket exposure, non-imagewise exposure).

Preferred examples of the light source employable herein include visible laser, ultraviolet laser, infrared laser, carbon arc, high voltage mercury vapor lamp, xenon lamp, metal halide lamp, fluorescent lamp, tungsten lamp, LED, and organic EL. In order to emit light having a specific wavelength, a sharp cut filter, abandpass filter, a diffraction grating, etc. are preferably used as necessary.

The hologram recording material of the invention is preferably free of silver halide.

The hologram recording method preferably employs a nonrewritable process. The term "nonrewritable process" as used herein is meant to indicate a process involving recording by an irreversible reaction allowing the storage of data once recorded without being overwritten (rewritten). Accordingly, the nonrewritable process is suitable for storage of data which are important and needed to be stored over an extended period of time. However, the nonrewritable process allows additional recording of data on unwritten area. In this sense, the nonrewritable process is normally called "write-once-read-many process".

The hologram recording method of the invention and the hologram recording material allowing the recording preferably comprise at least a first step at which a colored material having no absorption in the wavelength of hologram-reproducing light is formed as a latent image by holographic exposure and a second step at which the colored material latent image is irradiated with light having a wavelength different from that of holographic exposure to make self-sensitized amplified production of colored material by which an interference fringe is recorded as refractive index modulation, wherein the two steps are effected in a dry process.

More preferably, the hologram recording material of the invention comprises as a compound group allowing hologram recording at least:

1) a sensitizing dye which absorbs light at holographic exposure of the first step to produce excited state; and
2) an interference fringe recording component containing a dye precursor which can form a colored material having absorption in a longer wavelength than the original state and no absorption in the wavelength of hologram-reproducing light and capable of recording an interference fringe using refractive index modulation by color development which occurs via the step of transfer of electron or energy from the excited state of sensitizing dye or colored material.

Even more preferably, the hologram recording method and the hologram recording material allowing the recording method comprise a first step at which a hologram recording material according to Clauses (B-10) to (B-12) is subjected to holographic exposure to produce excited state of sensitizing dye from which electron or energy moves to an interference fringe recording component to form a colored material having absorption in a longer wavelength than the original state and no absorption in the wavelength of hologram-reproducing light as a latent image and a second step at which the hologram recording material is irradiated with light having a wavelength different from and shorter than that of holographic exposure within which wavelength the molar absorptivity of the sensitizing dye is 5, 000 or less to allow the colored material formed as a latent image at the first step to be self-sensitized, causing color development by which refractive index modulation is effected to record an interference fringe , wherein the two steps are effected in a dry process.

The molar absorptivity of the sensitizing dye in the wavelength range of light emitted at the second step is preferably 1, 000 or less, more preferably 500 or less. The molar absorptivity of the colored material in the wavelength range of light emitted at the second step is preferably 1,000 or more.

The compound group allowing hologram recording of the invention comprises at least:

1) a sensitizing dye which absorbs light at holographic exposure of the first step to produce excited state; and
2) an interference fringe recording component containing a dye precursor which can form a colored material having absorption in a longer wavelength than the original state and no absorption in the wavelength of hologram-reproducing light and capable of recording an interference fringe using refractive index modulation by color development which occurs via the step of transfer of electron or energy from the excited state of sensitizing dye or colored material.

The hologram recording material of the invention and its composition preferably comprise a binder and optionally additives such as electron-donating compound, electron-accepting compound, polymerizable monomer, polymerizable oligomer, polymerization initiator, crosslinking agent, heat stabilizer, plasticizer and solvent incorporated therein besides the sensitizing dye and interference fringe recording component.

However, the interference fringe recording method (refractive index modulation) using the hologram recording material of the invention itself does not necessarily require binder, polymerizable monomer, polymerizable oligomer, etc. These additives are used for the purpose of enhancing the film hardenability and storage properties and reducing the percent shrinkage.

The hologram recording material of the invention is preferably adapted for volume phase hologram recording. As previously mentioned, volume phase hologram recording involves recording of interference fringe s as refractive index modulation by a number as large as 1, 000 to 7,000 per mm along the thickness in the direction parallel to or substantially parallel to the surface of the recording material (reflection type) or perpendicular to or substantially perpendicular to the surface of the recording material (scanning type).

The hologram recording material of the invention and its composition preferably has different refractive indexes from the interference bright portion which undergoes chemical reaction (preferably color development) when electron or energy moves from the excited state of sensitizing dye or colored material to the interference dark portion which undergoes no chemical reaction when electron or energy moves from the excited state of sensitizing dye or colored material.

The hologram recording material of the invention is preferably subjected to fixing by either or both of light and heat after holographic exposure.

In particular, in the case where the hologram recording material of the invention comprises an acid proliferator or base proliferator incorporated therein, fixing is preferably carried out by heating to allow the acid proliferator or base proliferator to perform its function effectively.

In the case of fixing by light, the hologram recording material is irradiated with ultraviolet rays or visible light on the entire surface thereof (non-interference exposure). Preferred examples of the light source employable herein include visible laser, ultraviolet laser, infrared laser, carbon arc, high voltage mercury vapor lamp, xenon lamp, metal halide lamp, fluorescent lamp, tungsten lamp, LED, and organic EL.

Heat fixing, if effected, is preferably carried out at a temperature of from 40°C to 160°C, more preferably from 60°C to 130°C.

In the case where both fixing by light and heat fixing are effected, light and heat may be applied at the same time or separately.

In the invention, the aforementioned first step and second step may each also involve fixing. Preferably, the second step also involves fixing.

During the interference fringe recording, refractive index modulation is preferably from 0.00001 to 0.5, more preferably from 0.0001 to 0.3.

Preferably, the greater the thickness of the hologram recording material is, the less is the refractive index modulation. On the contrary, the smaller the thickness of the hologram recording material is, the more is the refractive index modulation.

The diffraction efficiency η of the hologram recording material is given by the following equation (1) :

$$\eta = Idiff/Io \qquad (1)$$

where Io is the intensity of incident light; and Idiff is the intensity of light diffracted (transmission type) or reflected (reflection type). The diffraction efficiency ranges from 0% to 100%, preferably 30% or more, more preferably 60% or more, most preferably 80% or more.

The light (for recording and reproduction) to be used in the invention is preferably any one of ultraviolet ray, visible light and infrared ray having a wavelength of from 200 to 2,000 nm, more preferably ultraviolet ray or visible light having a wavelength of from 300 to 700 nm, even more preferably visible light having a wavelength of from 400 to 700 nm.

The light to be used in the invention is preferably coherent (phase and wavelength-adjusted) laser beam. As the laser there may be used any of solid laser, semiconductor laser, gas laser and liquid laser. Preferred examples of laser beam employable herein include frequency-doubled YAG laser beam of 532 nm, frequency-tripled YAG laser beam of 355 nm, GaN laser beam of 405 to 415 nm, Ar ion laser beam of 488 nm or 515 nm, He-Ne laser beam of 632 nm or 633 nm, Kr ion laser of 647 nm, ruby laser beam of 694 nm, and He-Cd laser beam of 636 nm, 634 nm, 538 nm, 534 nm and 442 nm.

Alternatively, a pulse laser beam on the order of nanoseconds or picoseconds is preferably used.

In the case where the hologram recording material of the invention is used for optical recording medium,

frequency-doubled YAG laser beam of 532 nm or GaN laser beam of 405 nm to 415 nm is preferably used.

The wavelength of light to be used in hologram reproduction is the same as or longer than that of light to be used in holographic exposure (recording), preferably the same as that of light to be used in holographic exposure.

The sensitivity of the hologram recording material is normally represented by exposure per unit area (mJ/$cm^2$). The higher this value is, the higher is the sensitivity. However, the point at which exposure is measured to determine sensitivity differs from literature or patent to literature or patent. In some cases, exposure at the start of recording (refractive index modulation) may be measured. In other cases, exposure giving the maximum diffraction efficiency (maximum refractive index modulation) may be measured. In further cases, exposure giving half the maximum diffraction efficiency may be measured. In still further cases, exposure at which the gradient of diffraction efficiency with respect to exposure E is maximum may be measured.

According to Kugel-Nick's theoretical equation, refractive index modulation An required to give a certain diffraction efficiency is inversely proportional to the thickness d. In other words, the sensitivity required to give a certain diffraction efficiency differs with thickness. The smaller the thickness d is, the smaller is the required refractive index modulation $\Delta n$. Accordingly, the sensitivity cannot be unequivocally compared unless the conditions such as thickness are unified.

In the invention, the sensitivity is defined by "exposure (mJ/$cm^2$) required to give half the maximum diffraction efficiency". The sensitivity of the hologram recording material of the invention is preferably 2 J/$cm^2$ or less, more preferably 1 J/$cm^2$ or less, even more preferably 500 mJ/$cm^2$ or less, most preferably 200 mJ/$cm^2$ or less when the thickness is from about 10 to 200 μm.

In order to use the hologram recording material of the invention as an optical recording medium in a holographic memory, a spatial light modulation element (SLM) such as DMD and LCD is preferably used to record a large number of two-dimensional digital data (referred to as "signal light"). The recording is preferably carried out by multi-recording to enhance the recording density. Examples of multi-recording method employable herein include angle-multiple recording, phase-multiple recording, wavelength-multiple recording, and shift-multiple recording. Preferred among these multi-recording methods are angle-multiple recording and shift-multiple recording. In order to read the two-dimensional data reproduced, CCD or DMOS is preferably used.

In the case where the hologram recording material of the invention is used for optical recording medium, it is essential that multi-recording be effected to enhance the volume (recording density). In this case, multi-recording composed of preferably 10 or more times of recording jobs, more preferably 50 or more times of recording jobs, even more preferably 100 or more times of recording jobs is effected. During any recording job of multi-recording, exposure is preferably kept constant to simplify the recording system and enhance S/N ratio.

The concept of the hologram recording method of the invention will be described below, but it goes without saying that the invention is not limited thereto. The values given below are provided merely for the qualitative explanation and don't necessarily reflect the quantitative values.

For example, the hologram recording material is irradiated with YAG·SHG laser beam of 532 nm to allow the sensitizing dye to absorb light and produce excited state. By causing electron or energy to move from the excited state of the sensitizing dye to an interference fringe recording component, the dye precursor contained in the interference fringe recording component is partially caused to turn out to be a colored material as a latent image (first step). Subsequently, the hologram recording material is irradiated with light having a wavelength of from 400 to 450 nm to cause the colored material (latent image) to absorb light and undergo self-sensitization by which the colored material is further produced (dye precursor → colored material) (second step). Since a latent image is not produced too much on the interference dark portion at the first step, little or no self-sensitized color development reaction occurs at the second step, resulting in the occurrence of a great refractive index modulation on the interference bright portion and the interference dark portion which can be recorded as an interference fringe For example, the hologram recording material having date recorded thereon is again irradiated with laser beam of 532 nm, data, image and other data thus recorded can be reproduced. Thus, the hologram recording material of the invention can act as a desired optical material.

The various components of the hologram recording material composition of the invention will be further described hereinafter.

The compound group allowing the hologram recording method of the invention comprises at least a sensitizing dye which absorbs light at holographic exposure to produce excited state and an interference fringe recording component capable of undergoing chemical reaction when electron or energy moves from the excited state of sensitizing dye to record an interference fringe formed by holographic exposure.

Among these components, the sensitizing dye which absorbs light in the hologram recording material of the invention to produce excited state or absorbs light at holographic exposure of the first step to produce excited state will be described.

The sensitizing dye of the invention preferably absorbs any one of ultraviolet ray, visible light and infrared ray in the wavelength range of from 200 to 2, 000 nm, more preferably ultraviolet ray or visible light in the wavelength range of from 300 to 700 nm, even more preferably visible light in the wavelength range of from 400 to 700 nm to

produce excited state.

Preferred examples of the sensitizing dye employable herein include cyanine dyes, squarilium cyanine dyes, styryl dyes, pyrilium dyes, melocyanine dyes, arylidene dyes, oxonol dyes, azlenium dyes, coumarine dyes, ketocoumarine dyes, styrylcoumarine dyes, pyrane dyes, xanthene dyes, thioxanthene dyes, phenothiazine dyes, phenoxazine dyes, phenazine dyes, phthalocyanine dyes, azaporphyrine dyes, porphyrine dyes, condensed aromatic dyes, perylene dyes, azomethine dyes, anthraquinone dyes, metal complex dyes, and metalocene dyes. More desirable among these sensitizing dyes are cyanine dyes, squarilium cyanine dyes, pyrilium dyes, melocyanine dyes, oxonol dyes, coumarine dyes, ketocoumarine dyes, styrylcoumarine dyes, pyrane dyes, xanthene dyes, thioxanthene dyes, condensed aromatic dyes, metal complex dyes, and metalocene dyes. Even more desirable among these sensitizing dyes are cyanine dyes, melocyanine dyes, oxonol dyes, metal complex dyes, and metalocene dyes.

In addition to these sensitizing dyes, dyes and dyestuffs disclosed in Sinya Ogawara, "Shikiso Handobukku (Handbook of Dyes)", Kodansha, 1986, Shinya Ogawara, "Kinosei Shikiso no Kagaku (Chemistry of Functional Dyes)", CMC, 1981, and Tadasaburo Ikemori, "Tokushu Kino Zairyo (Specially Functional Materials)", CMC, 1986 may be used as sensitizing dye of the invention. The sensitizing dye to be used in the invention is not limited to these examples. Any dye or dyestuff may be used so far as it absorbs light in the visible range. These sensitizing dyes maybe selected such that they are adapted for the wavelength of radiation from the light source depending on the purpose. Two or more sensitizing dyes may be used in combination depending on the purpose.

Since the hologram recording material needs to be used in the form of thick layer and light needs to be transmitted by the layer, the molar absorptivity of the sensitizing dye at the wavelength of holographic exposure is preferably reduced to maximize the added amount of the sensitizing dye for the purpose of enhancing sensitivity. The molar absorptivity of the sensitizing dye at the wavelength of holographic exposure is preferably from not smaller than 1 to not greater than 10,000, more preferably from not smaller than 1 to not greater than 5, 000, even more preferably from not smaller than 5 to not greater than 2,500, most preferably from not smaller than 10 to not greater than 1,000.

The transmittance of the hologram recording material at the recording wavelength is preferably from 10% to 99%, more preferably from 20% to 95%, even more preferably from 30% to 90%, particularly from 40% to 85% from the standpoint of diffraction efficiency, sensitivity and recording density. To this end, the molar absorptivity of the sensitizing dye at the recording wavelength and the molarity of the sensitizing dye to be added are preferably adjusted according to the thickness of the hologram recording material.

$\lambda$max of the sensitizing dye is preferably shorter than the wavelength of hologram recording, more preferably between the wavelength of hologram recording and the wavelength 100 nm shorter than the wavelength of hologram recording.

Further, the molar absorptivity of the sensitizing dye at the recording wavelength is preferably one fifth or less, more preferably one tenth or less of that at $\lambda$max. In particular, when the sensitizing dye is an organic dye such as cyanine dye and melocyanine dye, the molar absorptivity of the sensitizing dye at the recording wavelength is more preferably one twentieth or less, even more preferably one fiftieth or less, particularly one hundredth or less of that at $\lambda$max.

Specific examples of the sensitizing dye employable herein will be given below, but the invention is not limited thereto.

Particularly preferred examples of metal complex dyes include Ru complex dyes. Particularly preferred examples of metalocene dyes include ferrocene dyes.

<cyanine dye>

D-1

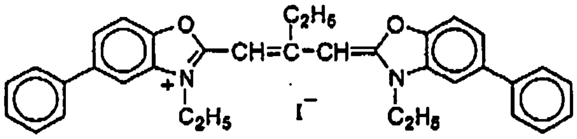

D-2

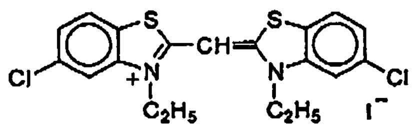

D-3

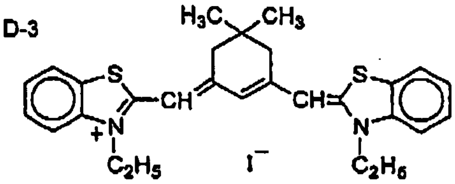

D-4

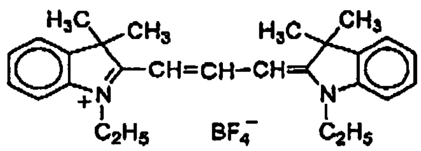

D-5

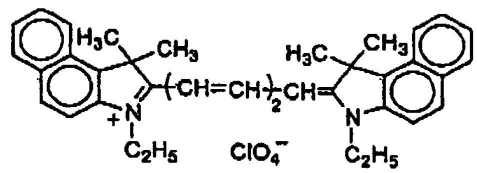

D-6

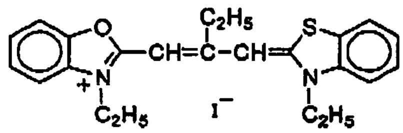

D-7

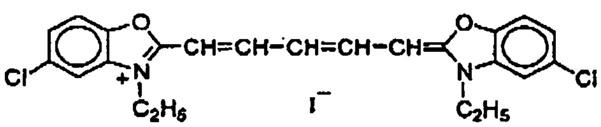

D-8

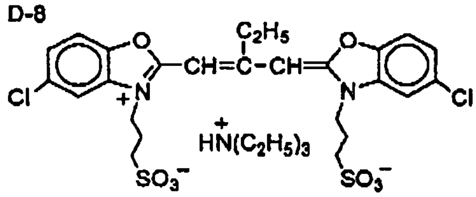

D-9

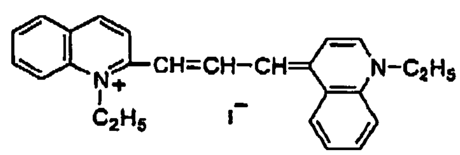

<squarylium cyanine dye>

D-10

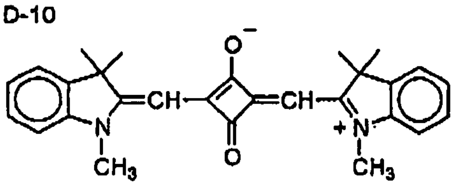

D-11

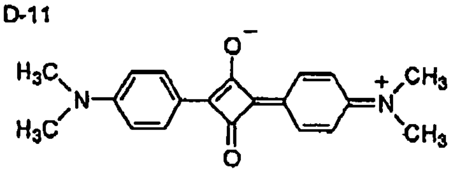

<styryl dye>

D-12

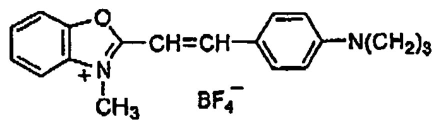

D-13

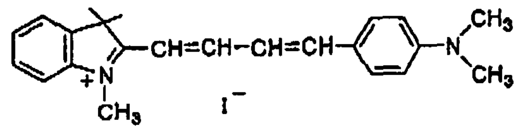

<pyrilium dye>

D-14

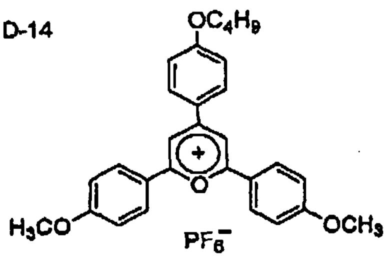

D-15

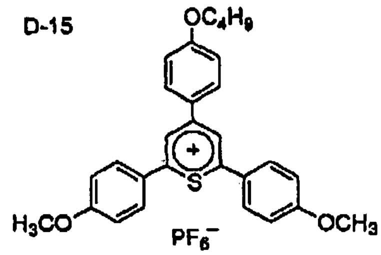

<merocyanine dye>

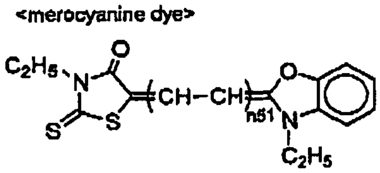

| | n51 |
|---|---|
| D-16 | 0 |
| D-17 | 1 |
| D-18 | 2 |

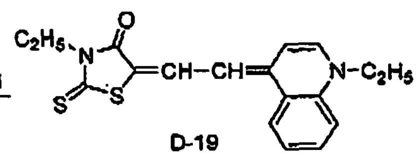

D-19

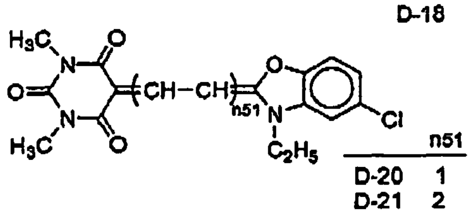

| | n51 |
|---|---|
| D-20 | 1 |
| D-21 | 2 |

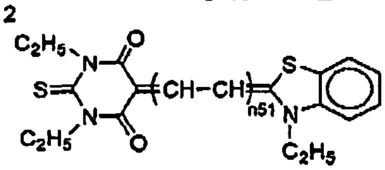

| | n51 |
|---|---|
| D-22 | 1 |
| D-23 | 2 |

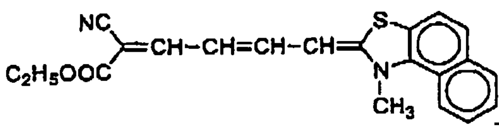

D-24

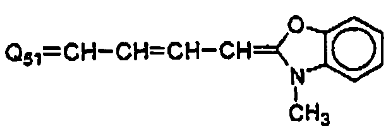

Q51

D-25

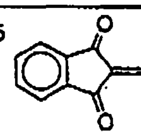

D-28

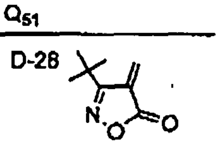

D-26

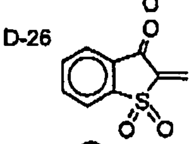

D-29

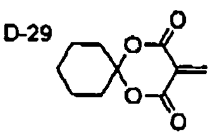

D-27

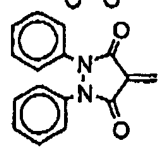

<merocyanine dye (continued)>

D-30

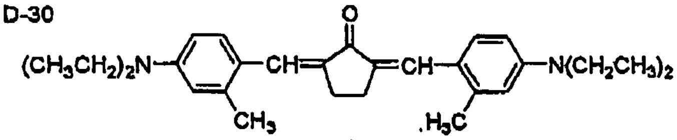

D-31

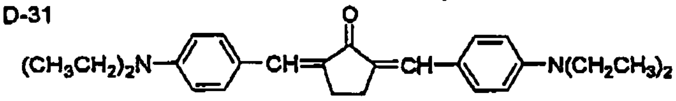

D-32

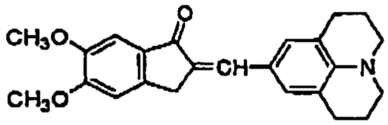

D-33

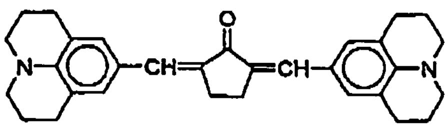

D-34

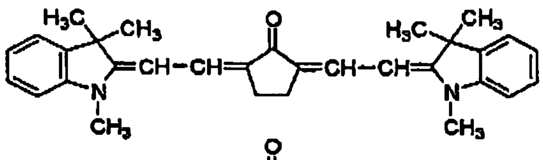

D-35

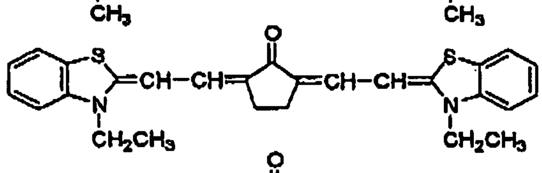

D-36

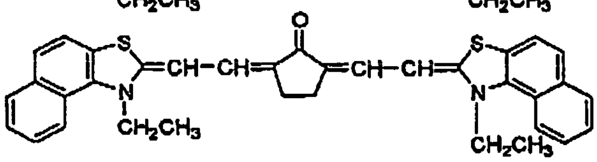

<arylidene dye>

D-37

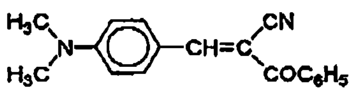

D-38

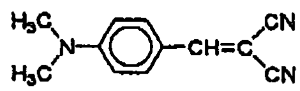

D-39

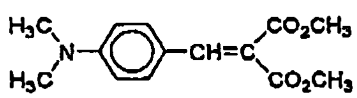

D-40

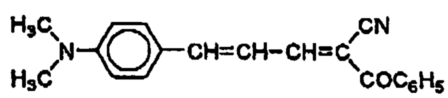

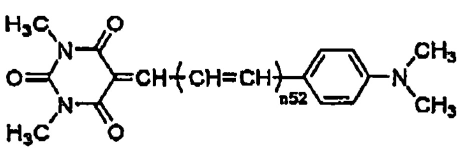

| | n52 |
|---|---|
| D-41 | 0 |
| D-42 | 1 |

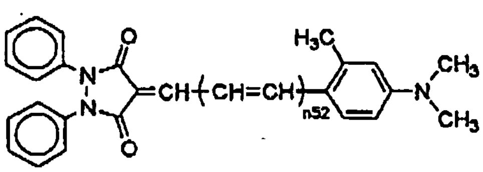

| | n52 |
|---|---|
| D-43 | 0 |
| D-44 | 1 |

<oxonol dye>

$$Q_{52}=CH-(CH=CH)_{n53}-Q_{53} \quad Cl$$

| | $Q_{52}$ | $Q_{53}$ | $n_{53}$ | Cl |
|---|---|---|---|---|
| D-45 | 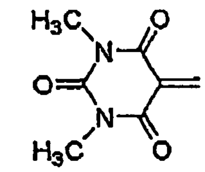 | 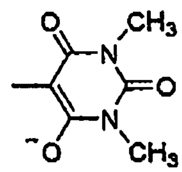 | 2 | $H^+$ |
| D-46 | 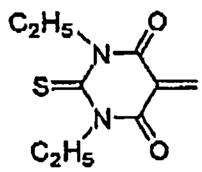 | 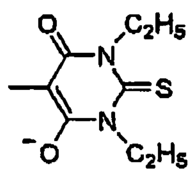 | 1 | 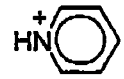 |
| D-47 | 〃 | 〃 | 2 | $H\overset{+}{N}(C_2H_5)_3$ |
| D-48 | 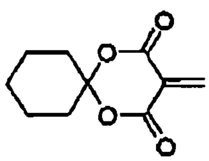 | 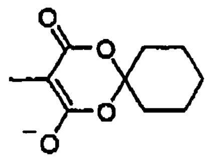 | 2 | $H^+$ |
| D-49 | 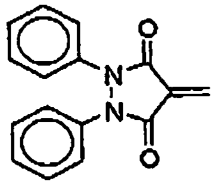 | 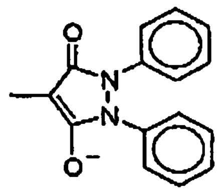 | 1 | $H^+$ |
| D-50 | 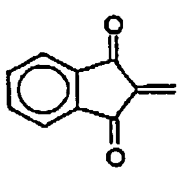 | 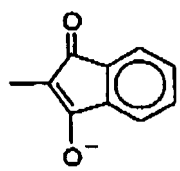 | 1 | $H\overset{+}{N}(C_2H_5)_3$ |
| D-51 | 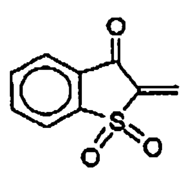 | 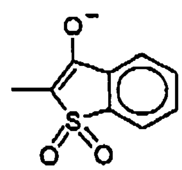 | 2 | 〃 |

<azulenium dye>

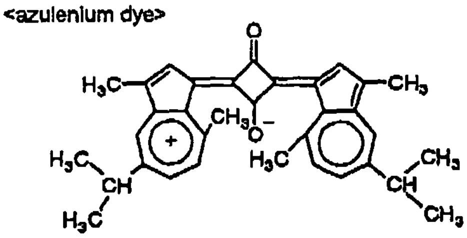

D-52

<coumarin dye>

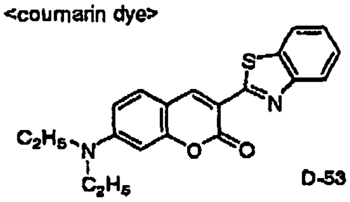

D-53

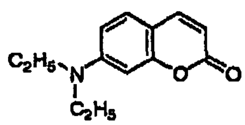

D-54

<ketocoumarin dye>

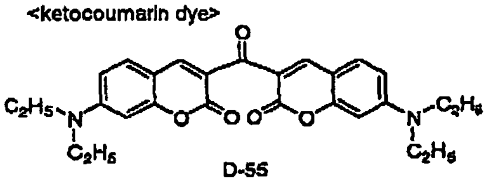

D-55

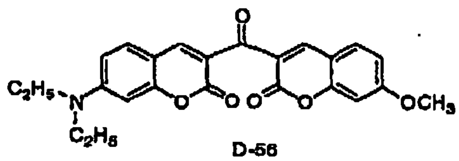

D-56

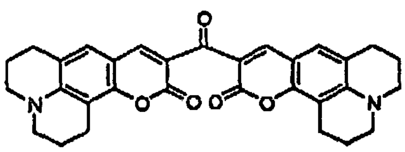

D-57

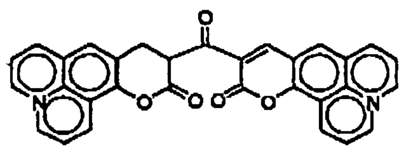

D-58

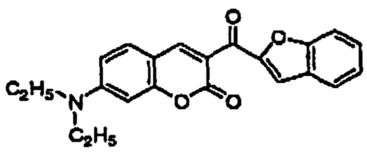

D-59

<stylcoumarin dye>

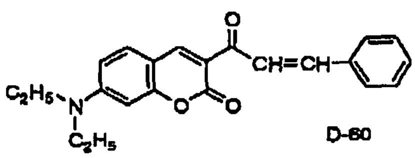

D-60

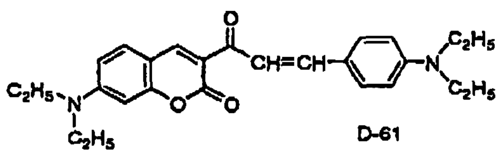

D-61

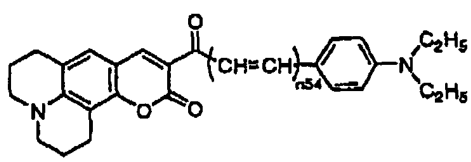

| | n54 |
|---|---|
| D-62 | 2 |
| D-63 | 3 |
| D-64 | 4 |

<pyran dye>

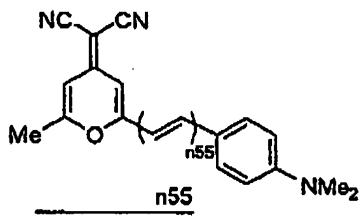

| | n55 |
|---|---|
| D-65 | 1 |
| D-66 | 2 |
| D-67 | 3 |
| D-68 | 4 |

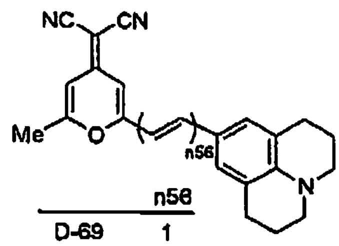

| | n56 |
|---|---|
| D-69 | 1 |
| D-70 | 2 |
| D-71 | 3 |

<xanthene dye>

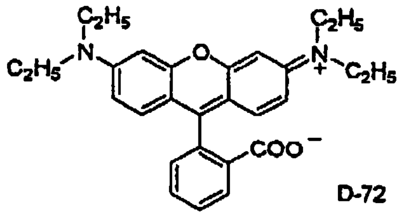

D-72

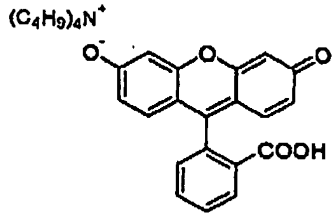

D-73

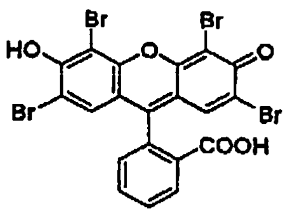

D-74

<thioxanthene dye>

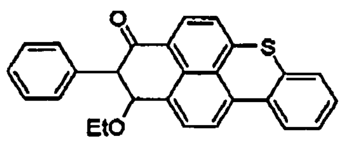

D-75

<phenothiazine dye>

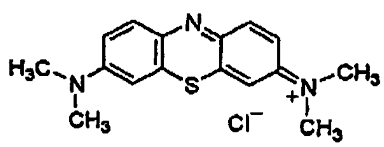

D-76

<phenoxazine dye>

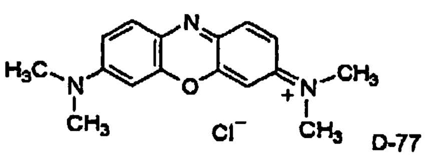

D-77

<phenazine dye>

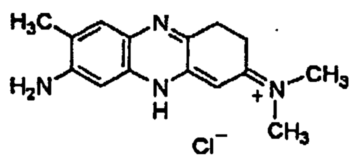

D-78

<phthalocyanine dye>

D-79

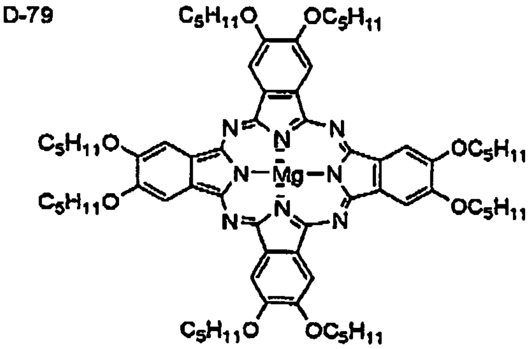

<azaporphyrin dye>

D-80

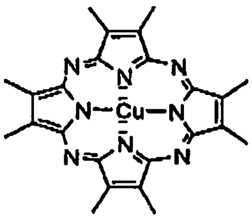

D-81

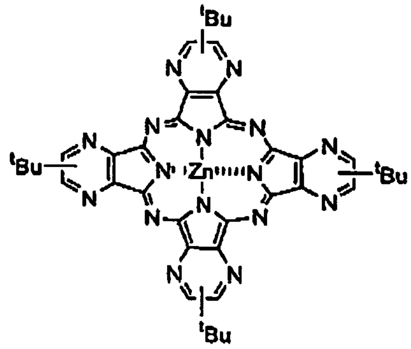

<porphyrin dye>

D-82

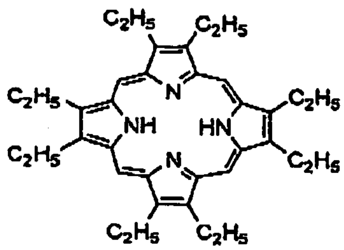

D-83

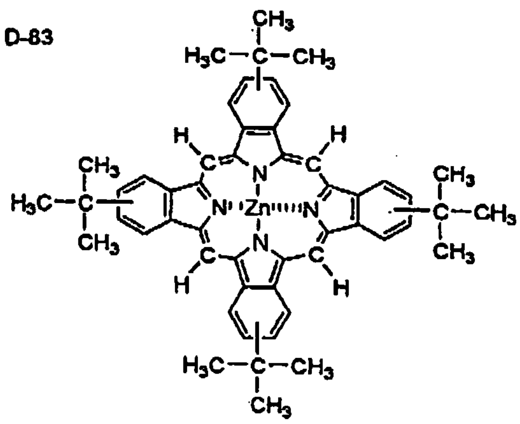

<condensed aromatic dye>

D-84

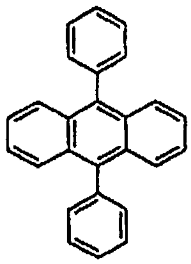

D-85

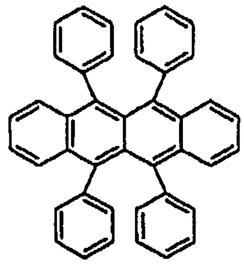

D-86

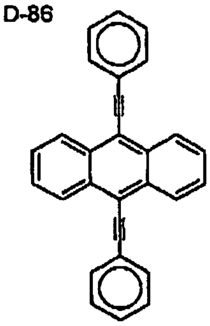

D-87

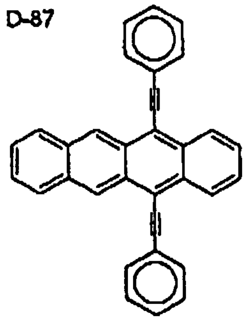

<perylene dye>

D-88

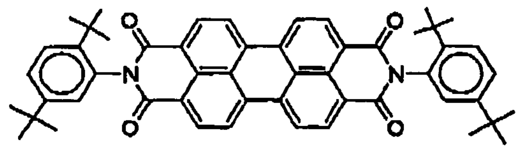

<azomethine dye>

D-89

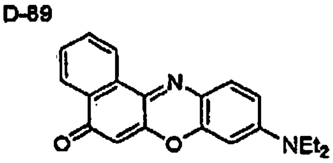

<anthraquinone dye>

D-90

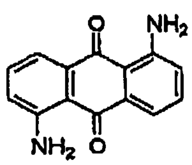

<metal complex dye>

D-91

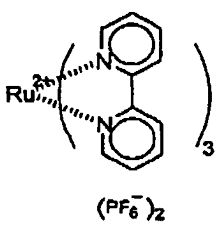

D-92

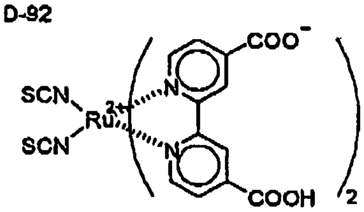

D-93

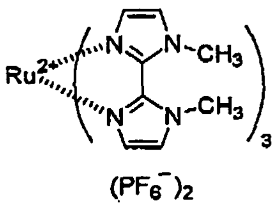

D-94

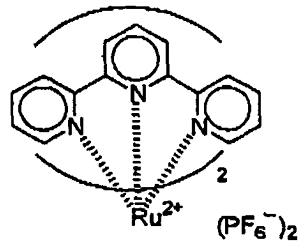

D-95

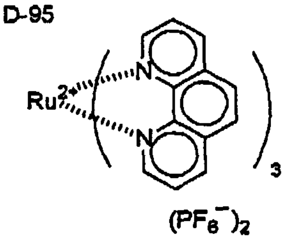

D-96

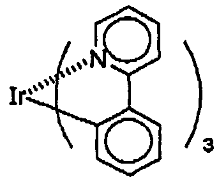

D-97

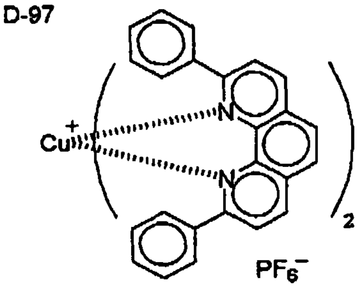

D-98

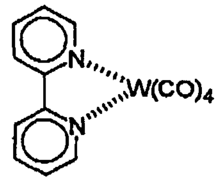

D-99

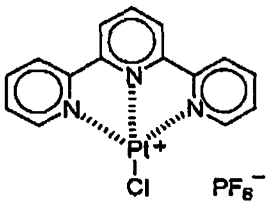

D-100

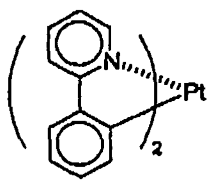

<metallocene dye>

D-101

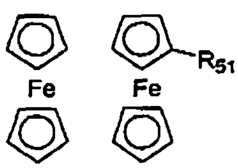

| | $R_{51}$ |
|---|---|
| D-102 | $-CHO$ |
| D-103 | $-CH_2CH_2COOH$ |
| D-104 | $-CH_2CH_2COOCH_3$ |
| D-105 | $-CH_2OH$ |
| D-106 | $-COOCH_3$ |

D-107

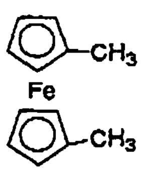

D-108

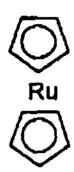

D-109

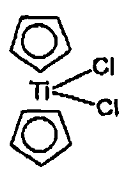

<cyanine dye (continued)>

D-110

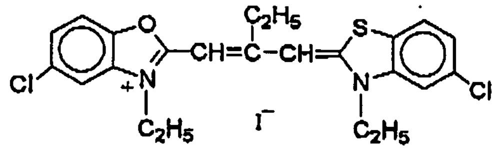

D-111

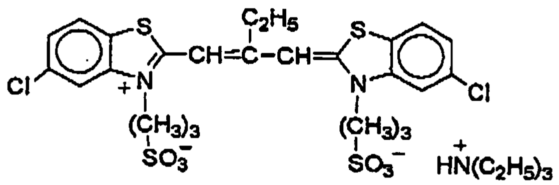

D-112

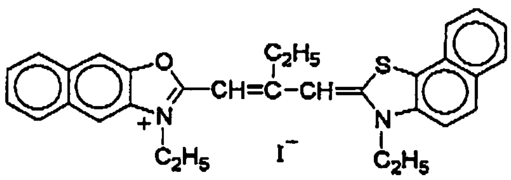

D-113

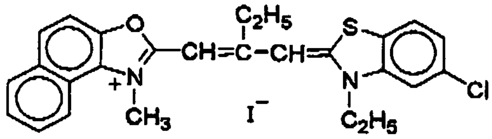

D-114

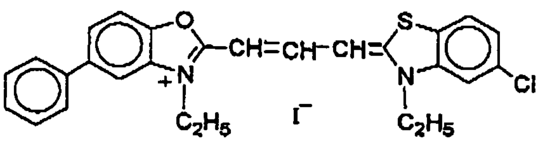

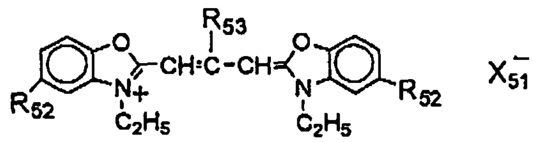

| | $R_{52}$ | $R_{53}$ | $X_{51}$ |
|---|---|---|---|
| D-115 | $-Cl$ | $-C_2H_5$ | $PF_6^-$ |
| D-116 | $-Cl$ | $-H$ | $I^-$ |
| D-117 | $-H$ | $-C_2H_5$ | " |
| D-118 | " | $-H$ | " |
| D-119 | " | " | $PF_6^-$ |
| D-120 | $-Br$ | " | $BF_4^-$ |
| D-121 | $-CH_3$ | " | $I^-$ |
| D-122 | $-OCH_3$ | $-C_2H_5$ | $PF_6^-$ |

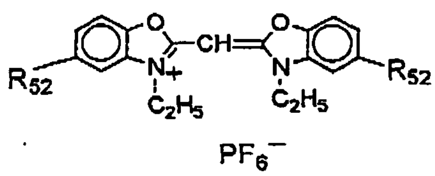

| | $R_{52}$ |
|---|---|
| D-123 | $-H$ |
| D-124 | $-Cl$ |
| D-125 | $-Ph$ |
| D-126 | $-CH_3$ |
| D-127 | $-OCH_3$ |

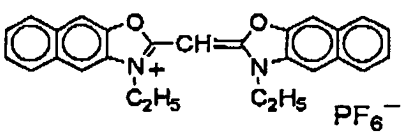 D-128

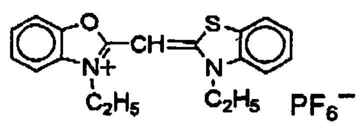 D-129

The sensitizing dye of the invention may be commercially available or may be synthesized by any known method.

In the case where hologram recording is effected using frequency-doubled YAG laser beam of 532 nm, the sensitizing dye to be used is particularly preferably a trimethinecyanine dye having a benzoxazole ring, Ru complex dye or ferrocene. In the case hologram recording is effected using GaN laser beam of 405 to 415 nm, the sensitizing dye to be used is particularly preferably a monomethinecyanine dye having a benzoxazole ring, Ru complex dye or ferrocene.

In the hologram recording material of the invention and its composition, as the compound group allowing hologram recording there is preferably used an interference fringe recording component capable of undergoing chemical reaction when electron or energy moves from the excited state of sensitizing dye to record an interference fringe formed by holographic exposure.

The interference fringe recording component in the hologram recording material of the invention containing a dye precursor which can form a colored material having absorption in a longer wavelength than the original state and no absorption in the wavelength of hologram-reproducing light and capable of recording an interference fringe using refractive index modulation by color development which occurs via the step of transfer of electron or energy from the excited state of sensitizing dye or colored material will be further described hereinafter.

It is herein important that refractive index differs from the position where color development reaction occurs (interference bright portion) to the position where no color development reaction occurs (interference dark portion). In

general, a dye shows a high refractive index at a longer wavelength than around the wavelength of absorption maximum (λmax) , particularly in the range of from λmax to wavelength 200 nm longer than λmax. Some dyes show a refractive index as high as more than 2, even more than 2.5.

On the other hand, organic compound which is not a dye, such as binder polymer shows a refractive index of from about 1.4 to 1.6.

Accordingly, the interference fringe recording component of the invention preferably comprises a dye precursor which can form a colored material that shows different absorption from the original state under the action of an acid or base generated when electron or energy moves directly from the excited state of sensitizing dye or colored material or when electron or energy moves from the excited state of sensitizing dye or colored material to an acid generator or base generator.

The hologram recording material of the invention is preferably a phase hologram recording material which records an interference fringe by refractive index modulation from the standpoint of enhancement of diffraction efficiency. In other words, it is preferred that the hologram recording material has little or no absorption in the wavelength of reproducing light during hologram reproduction.

Accordingly, the dye precursor contained in the interference fringe recording component in the hologram recording material of the invention preferably can form a colored material having absorption in a longer wavelength range than the original state under the action of an acid or base generated when electron or energy moves directly from the excited state of sensitizing dye or colored material or when electron or energy moves from the excited state of sensitizing dye or colored material. The colored material produced by reaction after holographic exposure preferably has no absorption in the wavelength of hologram-reproducing light but has absorption in a shorter wavelength range than the wavelength of hologram-reproducing light. The sensitizing dye preferably decomposes during hologram recording or subsequent fixing step to lose its absorption and sensitizing capability.

As a result, the hologram recording material of the invention can provide a phase hologram recording material capable of recording an interference fringe by refractive index modulation.

In order to give a high refractive index modulation, the dye precursor contained in the interference fringe recording component preferably has no absorption in the wavelength of hologram-reproducing light but has absorption in the range between the wavelength of hologram-reproducing light and the wavelength 200 nm shorter than the wave length of hologram-reproducing light, more preferably in the range between the wavelength of hologram-reproducing light and the wavelength 100 nm shorter than the wave length of hologram-reproducing light after holographic exposure.

Since the wavelength of light to be used in holographic exposure (recoding) is more preferably the same as that of light to be used in hologram reproduction as previously mentioned, the colored material preferably has no absorption in the wavelength of hologram-recording light and hologram-reproducing light.

Preferred examples of combination of interference fringe recording components in the hologram recording material of the invention will be given below.

A) Combination of at least an acid-induced color-forming dye precursor as a dye precursor and an acid general formula, and optionally an acid proliferator;

B) Combination of at least a base-induced color-forming dye precursor as a dye precursor and a base generator, and optionally a base proliferator;

C) Combination of a compound having a covalent bonding of an organic compound moiety capable of severing the covalent bonding when electron or energy moves to excited state of sensitizing dye and an organic compound moiety which forms a colored material when covalently bonded the former organic compound moiety and when released from the former organic compound moiety, and optionally a base.

D) Combination of capable of changing its absorption form when electron moves to the excited state of sensitizing dye or colored material.

In any case, the mechanism of transfer of energy from the excited state of sensitizing dye or colored material may be either a Foerster type mechanism involving the occurrence of energy transfer from the singlet excited state of sensitizing dye or colored material or a Dexter type mechanism involving the energy transfer from the triplet excited state of sensitizing dye or colored material.

In this case, in order to cause efficient transfer of energy, it is preferred that the exciting energy of the sensitizing dye or colored material be greater than that of the dye precursor.

On the other hand, the mechanism of transfer of electron from the excited state of sensitizing dye or colored material may be either a mechanism involving the transfer of electron from the singlet excited state of sensitizing dye or colored material or a mechanism involving the transfer of electron from the triplet excited state of sensitizing dye or colored material.

The sensitizing dye or colored material in excited state may give electron to the dye precursor, acid generator or base generator or receive electron therefrom. In the case where the sensitizing dye or colored material in excited

state gives electron, in order to cause efficient transfer of electron, it is preferred that the energy of the orbit (LUMO) at which excited electron in the excited state of sensitizing dye or colored material exists be higher than that of LUMO orbit of the dye precursor, acid generator or base generator.

In the case where the sensitizing dye or colored material in excited state receives electron, in order to cause efficient transfer of electron, it is preferred that the energy of the orbit (LUMO) at which excited electron in the excited state of sensitizing dye or colored material exists be lower than that of LUMO orbit of the dye precursor, acid generator or base generator.

Preferred examples of combination of interference fringe recording components in the hologram recording material of the invention and its composition will be further described hereinafter.

Firstly, the case where the interference fringe recording component in the hologram recording material of the invention comprises at least an acid-induced color-forming dye precursor as a dye precursor and an acid generator will be described.

The term "acid generator" as used herein is meant to indicate a compound capable of generator an acid when energy or electron moves from the excited state of sensitizing dye or colored material. The acid generator preferably stays stable in the dark. The acid generator of the invention is preferably a compound capable of generating an acid when electron moves from the excited state of sensitizing dye or colored material.

Preferred examples of the acid generator of the invention include the following six systems.

These acid generators may be used in admixture of two or more thereof in an arbitrary proportion as necessary.

1) Trihalomethyl-substituted triazine-based acid generator;
2) Diazonium salt-based acid generator;
3) Diaryliodonium salt-based acid generator;
4) Sulfonium salt-based acid generator;
5) Metal-arene complex-based acid generator; and
6) Sulfonic acid ester-based acid generator

The aforementioned preferred systems will be further described hereinafter.

In the case where a specific moiety is referred to as "group" herein, it means that the group may or may not be substituted by one or more (as much as possible) substituents unless otherwise specified. For example, the term "alkyl group" is meant to indicate a substituted or unsubstituted alkyl group. Substituents which can substitute the compounds in the invention are arbitrary.

In the case where a specific moiety is referred to as "ring" herein, it means that the ring may be monocyclic or condensed ring or may or may not be substituted.

For example, "aryl group" may be a phenyl group, naphthyl group or substituted phenyl group.

1) Trihalomethyl-substituted triazine-based acid generator

The trihalomethyl-substituted triazine-based acid generator is preferably represented by the following general formula (11):

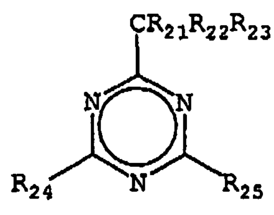

In the general formula (11), $R_{21}$, $R_{22}$ and $R_{23}$ each independently represents a halogen atom, preferably a chlorine atom; and $R_{24}$ and $R_{25}$ each independently represents a hydrogen atom, $-CR_{21}R_{22}R_{23}$, or another substituent.

Preferred examples of the substituent include an alkyl group (preferably with 1 to 20 carbon atoms, such asmethyl, ethyl, n-propyl, isopropyl, n-butyl, n-pentyl, benzyl, 3-sulfopropyl, 4-sulfobutyl, carboxymethyl or 5-carboxypentyl), an alkenyl group (preferably with 2 to 20 carbon atoms, such as vinyl, allyl, 2-butenyl or 1,3-butadienyl), a cycloalkyl group (preferably with 3 to 20 carbon atoms, such as cyclopentyl, or cyclohexyl), an aryl group (preferably with 6 to 20 carbon atoms, such as phenyl, 2-chlorophenyl, 4-methoxyphenyl, 3-methylphenyl, or 1-naphthyl), a heterocyclic group (preferably with 1 to 20 carbon atoms, such as pyridyl, thienyl, furyl, thiazolyl, imidazolyl, pyrazolyl, pyrolidino, piperidino or morpholino), an alkinyl group (preferably with 2 to 20 carbon atoms, such as ethinyl, 2-propinyl,

1,3-butadinyl, or 2-phenylethinyl), a halogen atom (such as F, Cl, Br or I), an amino group (preferably with 0 to 20 carbon atoms, such as amino, dimethylamino, diethylamino, dibutylamino, or anilino), a cyano group, a nitro group, a hydroxyl group, a mercapto group, a carboxyl group, a sulfo group, a phosphoric acid group, an acyl group (preferably with 1 to 20 carbon atoms, such as acetyl, benzoyl, salicyloyl or pivaloyl), an alkoxy group (poreferably with 1 to 20 carbon atoms, such as methoxy, butoxy or cyclohexyloxy), an aryloxy group (preferably with 6 to 26 carbon atoms, such as phenoxy or 1-naphthoxy), an alkylthio group (preferably with 1 to 20 carbon atoms, such as methylthio or ethylthio), an arylthio group (preferably with 6 to 20 carbon atoms, such as phenylthio or 4-chlorophenylthio), an alkylsulfonyl group (preferably with 1 to 20 carbon atoms, such as methanesulfonyl or butanesulfonyl), an arylsulfonyl group (preferably with 6 to 20 carbon atoms, such as benzenesulfonyl or paratoluenesulfonyl), a sulfamoyl group (preferably with 0 to 20 carbon atoms, such as sulfamoyl, N-methylsulfamoyl or N-phenylsulfamoyl), a carbamoyl group (preferably with 1 to 20 carbon atoms, such as carbamoyl, N-methylcarbamoyl, N,N-dimethylcarbamoyl or N-phenylcarbamoyl), an acylamino group (preferably with 1 to 20 carbon atoms, such as acetylamino, or benzoylamino), an imino group (preferablywith2 to 20 carbon atoms, suchasphthalimino) , an acyloxy group (preferably with 1 to 20 carbon atoms, such as acetyloxy or benzoyloxy) , an alkoxycarbonyl group (preferably with 2 to 20 carbon atoms, such as methoxycarbonyl or phenoxycarbonyl), and a carbamoylamino group (preferably with 1 to 20 carbon atoms, such as carbamoylamino, N-methylcarbamoylamino or N-phenylcarbamoylamino), and more preferably an alkyl group, an aryl group, a heterocyclic group, a halogen atom, a cyano group, a carboxyl group, a sulfo group, an alkoxy group, a sulfamoyl group, a carbamoyl group and an alkoxycarbonyl group.

$R_{24}$ preferably represents $-CR_{21}R_{22}R_{23}$, more preferably $-CCl_3$; and $R_{25}$ preferably represents $-CR_{21}R_{22}R_{23}$, an alkyl group, an alkenyl group or an aryl group.

Specific examples of the acid generating agent of trihalomethyl-substituted triazine type include:

2-methyl-4,6-bis(trichloromethyl)-1,3,5-triazine,
2,4,6-tris(trichloromethyl)-1,3,5-triazine,
2-phenyl-4,6-bis(trichloromethyl)-1,3,5-triazine,
2-(4'-methoxyphenyl)-4,6-bis(trichloromethyl)-1,3,5-triazine,
2-(4'-trifluoromethylphenyl)-4,6-bis(trichloromethyl )-1,3, 5-triazine,
2,4-bis(trichloromethyl)-6-(p-methoxyphenylvinyl)-1, 3,5-triazine, and
2-(4'-methoxy-1'-naphthyl)-4,6-bis(trichloromethyl)-1,3,5triazine. Also preferred examples include compounds described in BP No. 1388492 and JP-A No. 53-133428.

2) Acid generating agent of diazonium salt type

An acid generating agent of diazonium salt type is preferably represented by a following general formula (12).

$$(R_{27})_{a21}-R_{26}-\underset{+}{N}\equiv N \qquad X_{21}^{-}$$

$R_{26}$ represents an aryl group or a heterocyclic group, preferably an aryl group, and more preferably a phenyl group.

$R_{27}$ represents a substituent (preferred examples of which being same as those for $R_{24}$); and a21 represents an integer from 0 to 5, preferably 0 to 2; in case a21 is 2 or larger, plural $R_{27}$ may be mutually same or different, or may be mutually bonded to form a ring.

$X_{21}^-$ represents an anion where $HX_{21}$ constitutes an acid with a pKa value (in water, 25°C) of 4 or less, preferably 3 or less and more preferably 2 or less, and can preferably be a chloride, a bromide, an iodide, a tetrafluoroborate, a hexafluorophosphate, a hexafluoroarsenate, a hexafluoroantimonate, a perchlorate, a trifluoromethanesulfonate, a 9,10-dimethoxyanthracene-2-sulfonate, a methanesulfonate, a benzenesulfonate, a 9-trifluoromethylbenzenesulfonate, a tosylate or a tetra(pentafluorophenyl)borate.

Specific examples of the diazonium acid generating agent include $X_{21}^-$ salts of benzenediazonium, 4-methoxydiazonium and 4-methyldiazonium.

3) Acid generating agent of diaryliodonium salt type

An acid generating agent of diaryliodonium salt type is preferably represented by a following general formula (13).

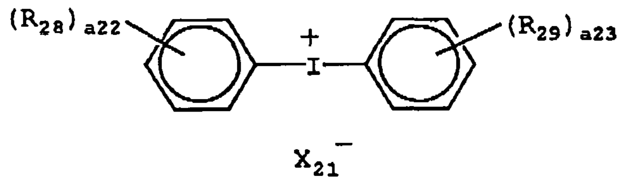

In the general formula (13), $X_{21}^-$ has the same meaning as in the general formula (12); $R_{28}$ and $R_{29}$ each independently represents a substituent (preferred examples of which being same as those for $R_{24}$) , preferably an alkyl group, an alkoxy group, a halogen atom, a cyano group or a nitro group.
a22 and a23 each independently represents an integer from 0 to 5, preferably 0 to 1; in case a22 or a23 is 2 or larger, plural $R_{28}$ or $R_{29}$ may be mutually same or different, or may be mutually bonded to form a ring.
Specific examples of the diaryl iodonium salt acid generating agent include a chloride, a bromide, an iodide, a tetrafluoroborate, a hexafluorophosphate, a hexafluoroarsenate, a hexafluoroantimonate, a perchlorate, a trifluoromethanesulfonate, a 9,10-dimethoxyanthracene-2-sulfonate, a methanesulfonate, a benzenesulfonate, a 4-trifluoromethylbenzenesulfonate, a tosylate, a tetra(pentafluorophenyl)borate, a perfluorobutanesulfonate, and a pentafluorobenzenesulfonate, of diphenyl iodonium, 4,4'-dichlorodiphenyl iodonium, 4,4' -dimethoxydiphenyl iodonium, 4,4'-dimethyldiphenyl iodonium, 4,4'-di-t-butyldiphenyl iodonium, 4,4'-di-t-amyldiphenyl iodonium, 3,3'-dinitrodiphenyl iodonium, phenyl(p-methoxyphenyl) iodonium, phenyl(p-octyloxyphenyl) iodonium, and bis(p-cyanophenyl) iodonium.
There can also be employed compounds described in Macromolecules, vol. 10, p. 1307 (1977) anddiaryl iodonium salts described in JP-A Nos. 58-29803 and 1-287105 and Japanese Patent Application No. 3-5569.

4) Acid generating agent of sulfonium salt type

An acid generating agent of sulfonium salt type is preferably represented by a following general formula (14).

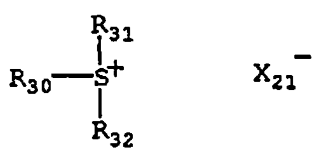

In the general formula (14), $X_{21}^-$ has the same meaning as in the general formula (12); $R_{30}$, $R_{31}$ and $R_{32}$ each independently represents an alkyl group, an aryl group or a heterocyclic group (preferred examples of the foregoing being same as those for $R_{24}$), preferably an alkyl group, a phenacyl group or an aryl group.
Specific examples of the sulfonium salt acid generating agent include a chloride, a bromide, a tetrafluoroborate, a hexafluorophosphate, a hexafluoroarsenate, a hexafluoroantimonate, a perchlorate, a trifluoromethanesulfonate, a 9,10-dimethoxyanthracene-2-sulfonate, a methanesulfonate, a benzenesulfonate, a 4-trifluoromethylbenzenesulfonate, a tosylate, a tetra(pentafluorophenyl) borate, a perfluorobutanesulfonate, and a pentafluorobenzenesulfonate, of a sulfonium salt such as triphenyl sulfonium, diphenylphenacyl sulfonium, dimethylphenacyl sulfonium, benzyl-4-hydroxyphenylmethyl sulfonium, 4-t-butyltriphenyl sulfonium, tris(4-methylphenyl) sulfonium, tris(4-methoxyphenyl) sulfonium, 4-phenylthiotriphenyl sulfonium, or bis-1-(4-(diphenylsulfonium)phenyl)sulfide.

5) Acid generating agent of metal allene complex type

In an acid generating agent of metal allene complex type, metal is preferably iron or titanium.
Specific preferred examples of the metal allene complex acid generating agent include iron allene complexes described in JP-A No. 1-54440, EP Nos. 109851 and 126712 and J. Imag. Sci., 30, p.174 (1986), ironallene organic boron complexes described in Organometallics, 8, p. 2737 (1989), iron allene complex salts described in Prog. Polym Sci., 21, p.7-8(1996) and titanocenes described in JP-A No. 61-151197.

6) Acid generating agent of sulfonate ester type

An acid generating agent of sulfonate ester type is preferably a sulfonate ester, a sulfonate nitrobenzyl ester, and an imidosulfonate.
Specific examples of the sulfonate ester include benzoin tosylate, and pyrogallol trimesylate; those of the

sulfonate nitrobenzyl ester include o-nitrobenzyl tosylate, 2,6-dinitrobenzyl tosylate, 2',6'-dinitrobenzyl-4-nitrobenzenesulfonate, p-nitrobenzyl-9,10-diethoxyanthracene-2-sulfonate and 2-nitrobenzyltrifluoromethylsulfonate; and those of imidosulfonate include N-tosylphthalic acid imide, 9-fluorenylidene aminotosylate and α-cyanobenzylidenetosylamine.

In addition, there can also be utilized acid generating agents described for example in UV Curing; Science and Technology, p.23-76, edited by S. Peter Pappas, A Technology Marketing Publication, and B Klingert, M. Riediker and A. Roloff, Comments Inorg. Chem., vol.7, No.3, p.109-138(1988).

Examples of the acid generating agent, in addition to those in the foregoing, include a photoacid generating agent having an o-nitrobenzyl protective group, described in S. Hayase et al., J. Polymer Sci., 25, 753(1987), E. Reichmanis et al., J. Polymer Sci., Polymer Chem. Ed., 23, 1(1985), D.H.R. Barton et al., J. Chem. Soc., 3571(1965), P. M. Collins et al., J. Chem. Soc., Perkin I, 1695(1975), M. Rudinstein et al., Tetrahedron Lett., (17), 1445(1975), J. W. Walker et al. , J. Am. Chem. Soc., 110, 7170(1989), S. C. Busman et al., J. Imaging Technol., 11(4), 191(1985), H. M. Houlihan et al., Macromolecules, 21, 2001 (1988) , P. M. Collins et al., J. Chem Soc., Chem Commun., 532(1972), S. Hayase et al., Macromolecules, 18, 1799(1985), E. Reichmanis et al., J. Electrochem. Soc., Solid State Sci. Technol., 130(6), F. M. Houlihan et al., Macromolecules, 21, 2001 (1988) , EP Nos. 0290, 750, 046,083, 156,535, 271,851, and 0,388,343, USP Nos. 3,901,710, and 4,181,531, JP-A Nos. 60-198538 and 53-133022, a halogenated sulfolane derivative disclosed in JP-A No. 4-338757 (specifically 3,4-dibromosulfolane or 3,4-dichlorosulfolane), a halogen-containing alkylene glycol ether compound such as methylene glycol bis(2,3-dibromopropyl) ether, a halogen-containing ketone such as 1,1,3,3-tetrabromoacetone or hexachloroacetone, and a halogen-containing alcohol such as 2,3-dibromopropanol.

Also as the acid generating agent in the invention, there can be employed a polymer in which an acid generating group is introduced into a main chain or in a side chain. In case the acid generating agent in the invention is a polymer in which an acid generating group is introduced into a main chain or in a side chain, such polymer may also function as a binder.

Specific examples of the compound in which an acid generating group or compound is introduced into a main chain or a side chain of a polymer include compounds described in M. E. Woodhouse et al., J. Am. Chem. Soc., 104, 5586(1982), S. P. Pappas et al., J. Imaging Sci., 30(5), 218 (1986), S. Kondo et al., Makromol. Chem., Rapid Commun., 9, 625(1988), J. V. Crivello et al., J. Polymer Sci., Polymer Chem. Ed., 17, 3845 (1979), USP No. 3, 849, 137, GP No. 3,914,407, JP-ANos. 63-26653, 55-164824, 62-69263, 63-146037, 63-163452, 62-153853, 63-146029 and 2000-143796.

The acid generating agent in the invention is more preferably:

3) diaryl iodonium salt acid generating agent;
4) sulfonium salt acid generating agent; or
6) sulfonate ester acid generating agent.

All these acid generating agents can also function as a cationic polymerization initiator.

Also,

1) trihalomethyl-substituted triazine acid generating agent;
2) diazonium salt acid generating agent;
3) diaryl iodonium salt acid generating agent;
4) sulfonium salt acid generating agent; and
5) metal allene complex acid generating agent;

can function as a cationic polymerization initiator and a radical polymerization initiator.

It is therefore possible to use a polymerizable monomer, a polymerizable binder, a reactive binder or a crosslinking agent in combination with the hologram recording material of the invention thereby executing a film hardening or the like by a polymerization or a crosslinking simultaneously with hologram recording.

In the following an acid-induced color forming dye precursor will be explained, in case an interference fringe recording component in the hologram recording material of the invention and in a composition therefor at least includes an acid-induced color forming dye precursor as a dye precursor and an acid generating agent.

The acid-induced color forming dye precursor in the invention is a dye precursor that can form a color-developed substance of which absorption is changed from an original state, by an acid generated by the acid generating agent. The acid-induced color forming dye precursor in the invention is preferably a compound of which absorption changes to a longer wavelength by the acid, more preferably a compound which develops a color from a colorless state by an acid.

The acid-induced color forming dye precursor is preferably a compound of triphenylmethane, phthalide (including indolylphthalide, azaphthalide, and triphenylmethane phthalide), phenothiazine, phenoxazine, fluorane, thiofluorane, xanthene, diphenylmethane, chromenopirazole, leucoauramine, methine, azomethine, rhodamine lactam, quinazoline, diazaxanthene, fluoren, or spiropyrane type. Specific examples of such compound are described for example in JP-A No. 2002-156454 and patents cited therein, JP-A Nos. 2000-281920, 11-279328 and 8-240908.

The acid-induced color forming dye precursor is more preferably a leuco dye having a partial structure of lactone, lactam, oxazine, or spiropyran, for example a compound of phthalide, fluorane, thiofluorane, phthalide, rhodamine lactam or spiropyran type.

In the interference fringe recording component of the invention, a dye generated from the acid-induced color forming dye precursor is preferably a xanthene dye, a fluorane dye or a triphenylmethane dye.

In the following, examples of the acid-induced color forming dye precursor preferred for the interference fringe recording component of the invention are shown, but the present invention is not limited to such following specific examples.

A preferred precursor for a phthalide dye is represented by a following general formula (21).

general formula (21)

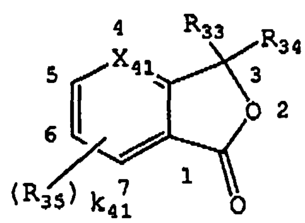

In the general formula (21), $X_{41}$ represents CH or N; $R_{33}$ and $R_{34}$ each independently represents an alkyl group with 1 to 20 carbon atoms, an aryl group with 6 to 24 carbon atoms, a heterocyclic group with 1 to 24 carbon atoms or a group represented by a following general formula (22) ; and $R_{35}$ represents a substituent (of which examples being same as those for $R_{24}$), $R_{35}$ being more preferably a halogen atom such as a chlorine atom or a bromine atom, an alkyl group with 1 to 20 carbon atoms, an alkoxy group with 1 to 20 carbon atoms, an amino group, an alkylamino group having an alkyl group with 1 to 20 carbon atoms, a dialkylamino group having alkyl groups independently having 1 to 20 carbon atoms, an arylamino group having an aryl group with 6 to 24 carbon atoms, a diarylamino group having aryl groups independently having 6 to 24 carbon atoms, a hydroxyl group, an alkoxy group with 1 to 20 carbon atoms, or a heterocyclic group; and $k_{41}$ represents an integer of 0 to 4, and, in case $k_{41}$ is an integer of 2 or larger, plural $R_{35}$ each independently represents one of groups mentioned above. These groups may further have a substituent, of which preferred examples can be those cited for $R_{24}$.

In the general formula (21), each of $R_{33}$ and $R_{34}$ is preferably represented by a following general formula (22).

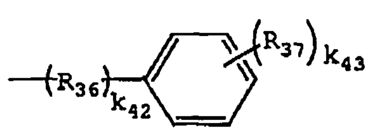

In the general formula (22), $R_{36}$ represents an alkylene group with 1 to 3 carbon atoms; $k_{42}$ represents an integer of 0 to 1; $R_{37}$ represents a substituent (of which preferred examples are same as those for $R_{24}$) , $R_{37}$ being more preferably a halogen atom such as a chlorine atom or a bromine atom, an alkyl group with 1 to 20 carbon atoms, an alkoxy group with 1 to 20 carbon atoms, an amino group, an alkylamino group having an alkyl group with 1 to 20 carbon atoms, a dialkylamino group having alkyl groups independently having 1 to 20 carbon atoms, an arylamino group having an aryl group with 6 to 24 carbon atoms, a diarylamino group having aryl groups independently having 6 to 24 carbon atoms, a hydroxyl group, an alkoxy group with 1 to 20 carbon atoms, or a heterocyclic group; and $k_{43}$ represents an integer of 0 to 5, and, in case $k_{43}$ is an integer of 2 or larger, plural $R_{37}$ each independently represents one of groups mentioned above. These groups may further have a substituent, of which preferred examples can be those cited for $R_{24}$.

In the general formula (21), the heterocyclic group represented by $R_{33}$, $R_{34}$ is more preferably an indolyl group represented by a following general formula (23).

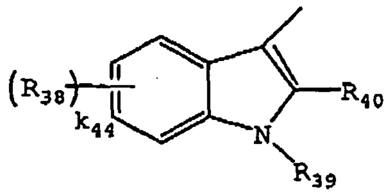

In the general formula (23), $R_{38}$ represents a substituent (of which preferred examples are same as those for $R_{24}$), $R_{38}$ being more preferably a halogen atom such as a chlorine atom or a bromine atom, an alkyl group with 1 to 20 carbon atoms, an alkoxy group with 1 to 20 carbon atoms, an amino group, an alkylamino group having an alkyl group with 1 to 20 carbon atoms, a dialkylamino group having alkyl groups independently having 1 to 20 carbon atoms, an arylamino group having an aryl group with 6 to 24 carbon atoms, a diarylamino group having aryl groups independently having 6 to 24 carbon atoms, a hydroxyl group, an alkoxy group with 1 to 20 carbon atoms, or a heterocyclic group; and $k_{44}$ represents an integer of 0 to 4, and, in case $k_{44}$ is an integer of 2 or larger, plural $R_{38}$ each independently represents one of groups mentioned above; $R_{39}$ represents a hydrogen atom or an alkyl group with 1 to 20 carbon atoms; and $R_{40}$ represents an alkyl group with 1 to 20 carbon atoms or an alkoxy group with 1 to 20 carbon atoms. These groups may further have a substituent, of which preferred examples can be those cited for $R_{24}$.

Specific examples of the phthalide dye precursor (including indophthalide dye precursor and azaphthalide dye precursor) include 3,3-bis(4-diethylaminophenyl)-6-diethylamino phthalide, 3-(4-diethylaminophenyl)-3-(1-ethyl-2-methylindol-3-yl) phthalide, 3-(4-dimethylaminophenyl)-3-(1,3-dimethylindol-3-yl) phthalide, 3,3-bis(1-n-butyl-2-methylindol-3-yl) phthalide, 3,3-bis(1-ethyl-2-methylindol-3-yl) phthalide, 3-(4-diethylamino-2-ethoxyphenyl)-3-(1-ethyl-2-methylindol-3-yl)-4-azaphthalide, 3,3-bis (4-hydroxyphenyl)-6-hydroxy phthalide, 3,3-bis (4-hexyloxyphenyl) phthalide, and 3,3-bis(4-hexyloxyphenyl)-6-methoxyphthalide.

The phthalide dye precursor represented by the general formula (21) is more preferably a triphenylmethane phthalide dye precursor represented by represented by a following general formula (24).

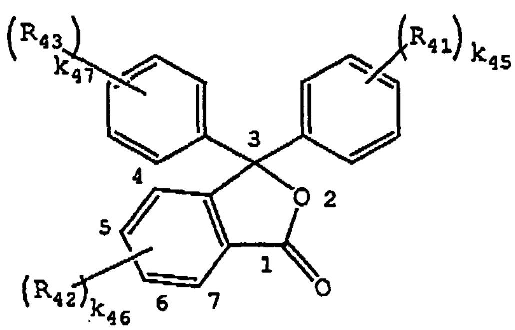

In the general formula (24), $R_{41}$, $R_{42}$ and $R_{43}$ each independently represents a substituent (of which preferred examples are same as those for $R_{24}$), such substituent of $R_{41}$, $R_{42}$ and $R_{43}$ being more preferably a halogen atom such as a chlorine atom or a bromine atom, an alkyl group with 1 to 20 carbon atoms, an alkoxy group with 1 to 20 carbon atoms, an amino group, an alkylamino group having an alkyl group with 1 to 20 carbon atoms, a dialkylamino group having alkyl groups independently having 1 to 20 carbon atoms, an arylamino group having an aryl group with 6 to 24 carbon atoms, a diarylamino group having aryl groups independently having 6 to 24 carbon atoms, a hydroxyl group, an alkoxy group with 1 to 20 carbon atoms, or a heterocyclic group; and $k_{45}$, $k_{46}$ and $k_{47}$ each independently represents an integer of 0 to 4, and, in case each of $k_{45}$, $k_{46}$ and $k_{47}$ is an integer of 2 or larger, plural $R_{41}$, $R_{42}$ or $R_{43}$ each independently represents one of groups mentioned above. These groups may further have a substituent, of which preferred examples can be those cited for $R_{24}$.

Specific examples of the triphenylmethane phthalide dye precursor include 3,3-bis(p-dimethylaminophenyl)-6-dimethylaminophthalide (namely crystal violet lactone), 3,3-bis(p-dimethylaminophenyl) phthalide, 3,3-bis(p-dihexylaminophenyl)-6-dimethylamino phthalide, 3,3-bis(p-dioctylaminophenyl) phthalide, 3,3-bis(p-dimethylaminophenyl)-6-diethylaminophthalide, 4-hydroxy-4'-dimethylaminotriphenylmethane lactone, 4,4'-bisdihydroxy-3,3'-bisdiaminotriphenylmethane lactone, 3,3-bis(4-hydroxyphenyl)-4-hydroxyphthalide, 3,3-bis(4-hexyloxyphenyl) phthalide, and 3,3-bis(4-hexyloxyphenyl)-6-methoxyphthalide.

The fluorane dye precursor is preferably represented by a following general formula (25).

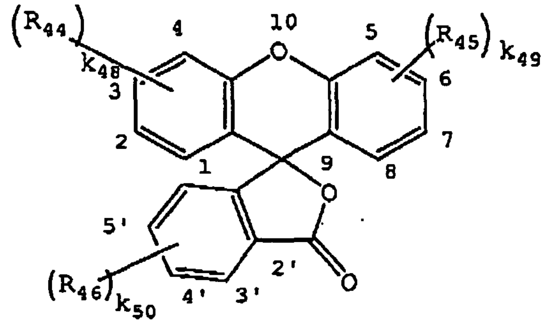

In the general formula (25) , $R_{44}$, $R_{45}$, and $R_{46}$ each independently represents a substituent (of which preferred examples are same as those for $R_{24}$), such substituent of $R_{44}$, $R_{45}$, and $R_{46}$ being more preferably a halogen atom such as a chlorine atom or a bromine atom, an alkyl group with 1 to 20 carbon atoms, an alkoxy group with 1 to 20 carbon atoms, an amino group, an alkylamino group having an alkyl group with 1 to 20 carbon atoms, a dialkylamino group having alkyl groups independently having 1 to 20 carbon atoms, an arylamino group having an aryl group with 6 to 24 carbon atoms, a diarylamino group having aryl groups independently having 6 to 14 carbon atoms, a hydroxyl group, or a heterocyclic group; and $k_{48}$, $k_{49}$ and $k_{50}$ each independently represents an integer of 0 to 4, and, in case each of $k_{48}$, $k_{49}$ and $k_{50}$ is an integer of 2 or larger, plural $R_{44}$, $R_{45}$ or $R_{46}$ each independently represents one of groups mentioned above. These groups may further have a substituent, of which preferred examples can be those cited for $R_{24}$.

Specific examples of the fluorane dye precursor include 3-diethylamino-6-(2-chloroanilino)fluorane, 3-dibutylamino-6-(2-chloroanilino)fluorane, 3-diethylamino-7-methyl-6-anilinofluorane, 3-dibutylamino)-7-methyl-6-anilinofluorane, 3-dipentylamino-7-methyl-6-anilinofluorane, 3-(N-ethyl-N-isopentylamino)-7-methyl-6-anilinofluorane, 3-diethylamino-7-methyl-6-xylidinofluorane, 3-diethylamino-6,7-benzofluorane, 3-diethylamino-7-methoxy-6,7-benzofluorane, 1,3-dimethyl-6,diethylaminofluorane, 2-bromo-3-methyl-6-dibutylaminofluorane, 2-N,N-dibenzylamino-6-diethylaminofluorane, 3-dimethylamino-6-methoxyfluorane, 3-diethylamino-7-methyl-6-chlorofluorane, 3-diethylamino-6-methoxyfluorane, 3,6-bisdiethylaminofluorane, 3,6-dihexyloxyfluorane, 3,6-dichlorofluorane, and 3,6-diacetyloxyfluorane.

Specific examples of the rhodamine lactam dye precursor include rhodamine-B-anilinolactam, rhogamine(p-nitroanilino)lactam, rhodamine-B-(p-chloroanilino)lactam and rhodamine-B-(o-chloroanilino)lactam.

Specific examples of the spiropyran dye precursor include 3-methyl-spirodinaphthopyran, 3-ethyl-spirodinaphthopyran, 3,3'-dichloro-spirodinaphthopyran, 3-benzyl-spirodinaphthopyran, 3-propyl-spirodibenzopyran, 3-phenyl-8'-methoxybenzoindolinospiropyran, 8'-methoxybenzoindolinospiropyran, and 4,7,8'-trimethoxybenzoindolinospiropyran.

Specific examples also include spiropyran dye precursors disclosed in JP-A No. 2000-281920.

Furthermore, as the acid-induced color forming dye precursor of the invention, there can be advantageously employed a BLD compound represented by a general formula (6) in JP-A No. 2000-284475, a leuco dye disclosed in JP-A No. 2000-144004 and leuco dyes of following structures.

R-1

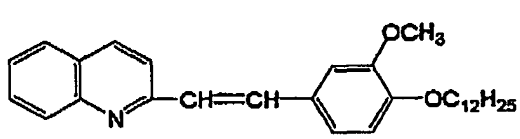

R-2

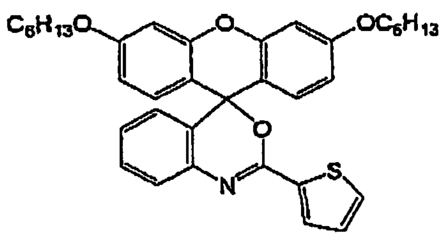

R-3

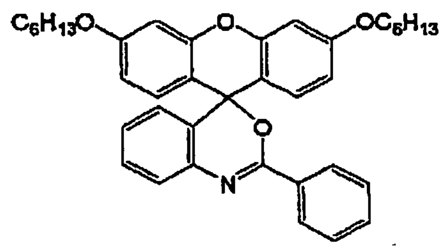

R-4

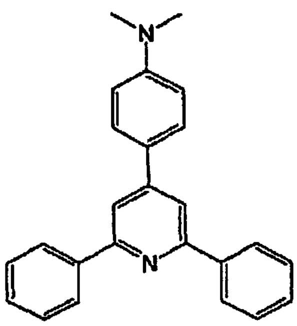

R-5

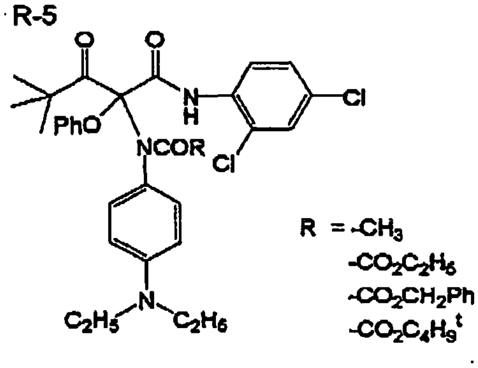

R-6

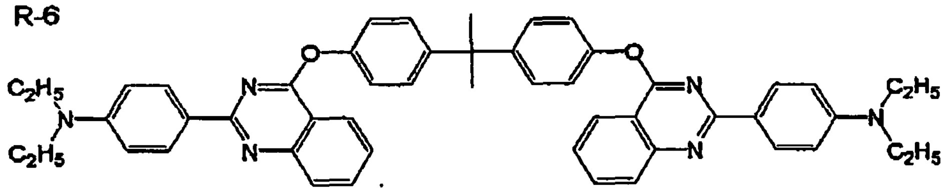

In particular, R-2 and R-3 are preferable as the acid-induced color forming dye precursor of the invention.

Also the dye precursor of the invention may be a leuco cyanine dye which forms a color by an acid (proton) addition. An example of color formation of a leuco cyanine dye by forming a cyanine dye with an acid is shown in the following.

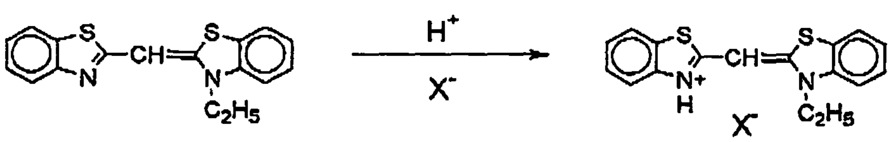


leuco cyanine dye, colorless

cyanine dye, yellow

Preferred examples of the leuco cyanine dye in the invention are shown in the following, but the present invention is not limited to those examples.

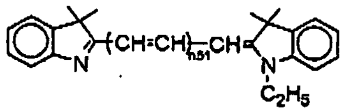

| | $n_{51}$ |
|---|---|
| LC-1 | 0 |
| LC-2 | 1 |
| LC-3 | 2 |

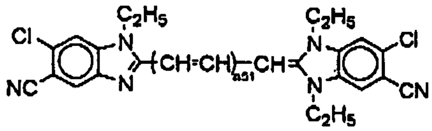

| | $n_{51}$ |
|---|---|
| LC-4 | 0 |
| LC-5 | 1 |
| LC-6 | 2 |

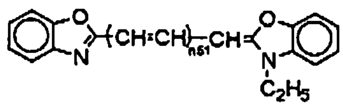

| | $n_{51}$ |
|---|---|
| LC-7 | 0 |
| LC-8 | 1 |
| LC-9 | 2 |

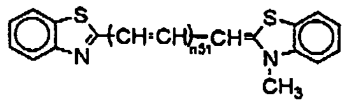

| | $n_{51}$ |
|---|---|
| LC-10 | 0 |
| LC-11 | 1 |
| LC-12 | 2 |

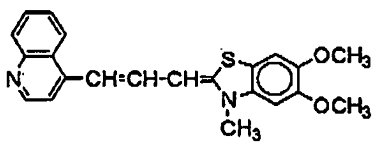

LC-13

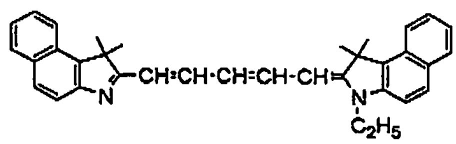

LC-14

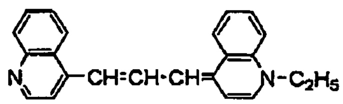

LC-15

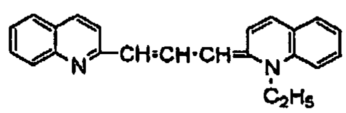

LC-16

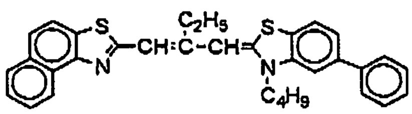

LC-17

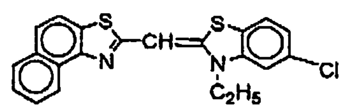

LC-18

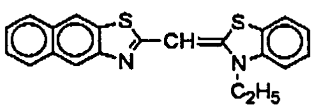

LC-19

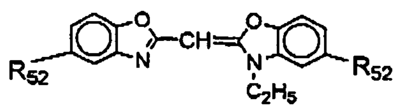

| | $R_{52}$ |
|---|---|
| LC-20 | $-Cl$ |
| LC-21 | $-Br$ |
| LC-22 | 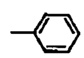 |
| LC-23 | $-CH_3$ |
| LC-24 | $-OCH_3$ |

In case the interference fringe recording component of the invention includes at least an acid-induced color forming dye precursor as a dye precursor and an acid generating agent, it may further contain an acid proliferating agent.

An acid proliferating agent of the invention is a compound that is stable in the absence of an acid but is decomposed in the presence of an acid thereby releasing an acid, which decomposes another acid proliferating agent to further release an acid, thus capable of an acid proliferation utilizing a small amount of acid generated by the acid generating agent as a trigger.

The acid proliferating agent is preferably represented by the foregoing general formulas (4-1) to (4-6).

In the general formulas (4-1) to (4-6), $R_{101}$ represents a group for which $R_{101}OH$ forms an acid with a pKa value of 5 or less, preferably 3 or less.

$R_{101}$ is preferably a group for which $R_{101}OH$ is a sulfonic acid, a carboxylic acid, a phosphonic acid, or a phosphinic acid, more preferably it is a sulfonic acid or a carboxylic acid substituted with an electron attracting group, and such electron attracting group is preferably a halogen atom, a cyano group, a nitro group, an alkoxycarbonyl group,

a carbamoyl group, an alkylsulfonyl group, an arylsulfonyl group or a heterocyclic group. Most preferably $R_{101}$ is a group for which $R_{101}$ OH is a sulfonic acid.

Specific preferred examples of $R_{101}$ are shown in the following, but the present invention is not limited to such examples.

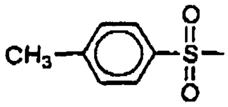
A-1

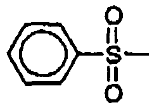
A-2

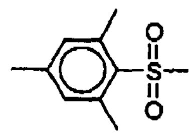
A-3

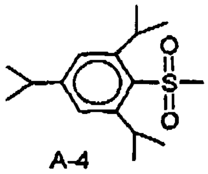
A-4

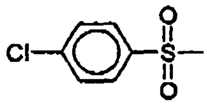
A-5

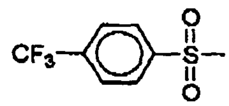
A-6

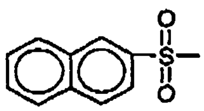
A-7

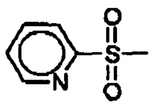
A-8

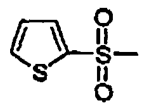
A-9

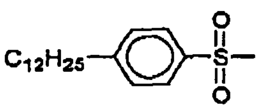
A-10

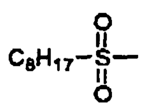
A-11

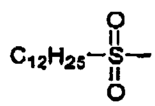
A-12

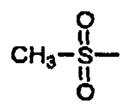
A-13

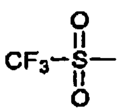
A-14

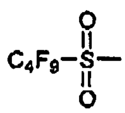
A-15

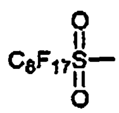
A-16

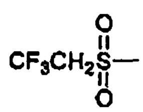
A-17

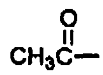
A-18

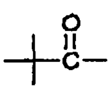
A-19

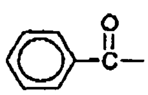
A-20

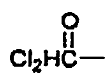
A-21

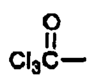
A-22

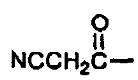
A-23

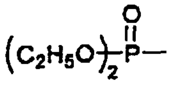
A-24

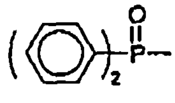
A-25

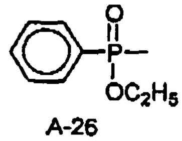
A-26

In the general formula (4-1), $R_{102}$ represents a 2-alkyl-2-propyl group, a 2-aryl-2-propyl group, a cyclohexyl group, a tetrahydropyranyl group, or a bis(p-alkoxyphenyl)methyl group, preferably a 2-alkyl-2-propyl group or a 2-aryl-2-propyl group, more preferably a 2-alkyl-2-propyl group, and most preferably a t-butyl group.

In the general formula (4-1), $R_{103}$ and $R_{104}$ each independently represents a substituent (of which preferred examples are same as those for $R_{24}$), more preferably each independently represents an alkyl group, an alkenyl group, a cycloalkyl group, an aryl group or a heterocyclic group, further preferably an alkyl group or an aryl group and most preferably an alkyl group.

In the general formulas (4-1) to (4-6), $R_{105,}$ $R_{106}$, $R_{107}$, $R_{110}$, $R_{113}$ and $R_{116}$ each independently represents a hydrogen atom or a substituent (of which preferred examples are same as those for $R_{24}$), more preferably a hydrogen atom, an alkyl group, an alkenyl group, a cycloalkyl group, an aryl group or a heterocyclic group, further preferably a hydrogen atom, an alkyl group or an aryl group.

More preferably $R_{105}$, $R_{106}$ and $R_{116}$ are all hydrogen atoms. More preferably $R_{107}$, $R_{110}$ and $R_{113}$ are all alkyl groups.

In the general formula (4-2), $R_{108}$ and $R_{109}$ each independently represents an alkyl group, preferably a methyl group or an ethyl group, or they may be mutually bonded to form a ring, and a ring to be formed is preferably a dioxal ring or a dioxane ring.

In the general formula (4-3), $R_{111}$ and $R_{112}$ represent alkyl groups which are mutually bonded to form a ring, and a ring to be formed is preferably a saturated cycloalkane ring.

In the general formula (4-4), $R_{114}$ represents a hydrogen atom or a nitro group, preferably a nitro group; $R_{115}$ represents a substituent; n101 represents an integer of 0 to 3, preferably 0 or 1 and more preferably 0.

In the general formula (4-6), $R_{117}$ represents a substituent (of which preferred examples are same as those for $R_{24}$), more preferably an alkyl group, an alkenyl group, a cycloalkyl group, an aryl group or a heterocyclic group, further preferably an alkyl group or an aryl group and most preferably an alkyl group.

The acid proliferating agent of the invention is more preferably represented by any of the general formulas (4-1), (4-3) or (4-4), and most preferably by the general formula (4-1).

Specific examples of the acid proliferating agent of the invention are shown in the following, but the present invention is not limited to such examples.

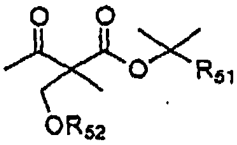

| | $R_{51}$ | $R_{52}$ |
|---|---|---|
| AA-1 | $-CH_3$ | 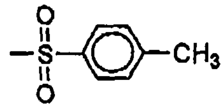 |
| AA-2 | 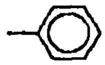 | ″ |
| AA-3 | $-CH_3$ | 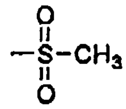 |
| AA-4 | 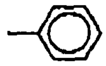 | ″ |
| AA-5 | $-CH_3$ | 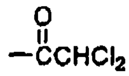 |
| AA-6 | 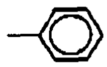 | 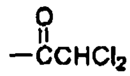 |
| AA-7 | $-CH_3$ | 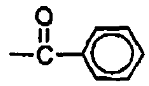 |
| AA-8 | $-CH_3$ | 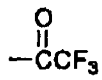 |
| AA-9 | $-CH_3$ | $-SO_2CF_3$ |
| AA-10 | $-CH_3$ | $-SO_2C_4F_9$ |

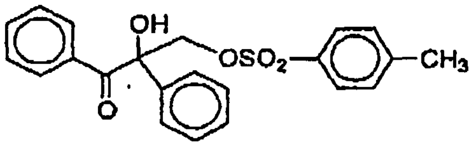

AA-11

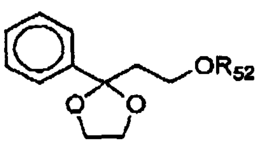

| | $R_{52}$ | | $R_{52}$ |
|---|---|---|---|
| AA-12 | 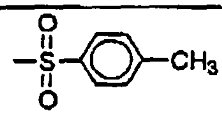 | AA-15 | 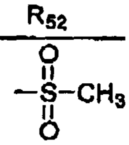 |
| AA-13 | 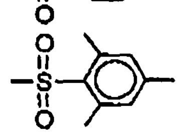 | AA-16 | 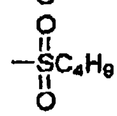 |
| AA-14 | 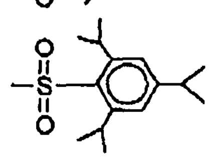 | AA-17 | 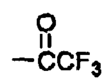 |

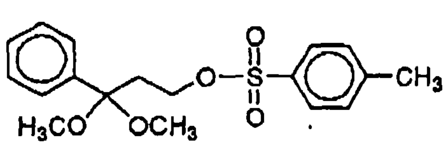

AA-18

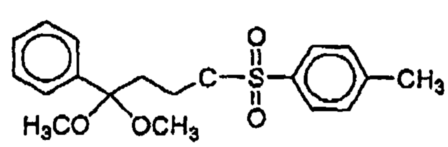

AA-19

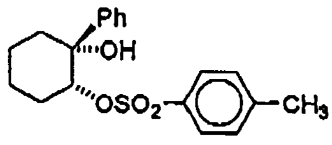

AA-20

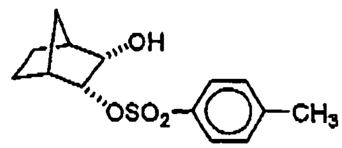

AA-21

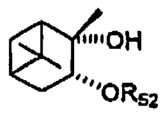

R52

AA-22 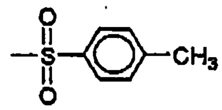

AA-23 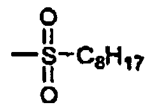

AA-24 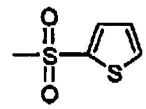

AA-25 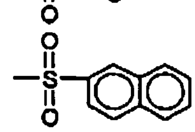

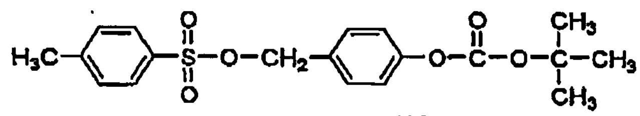

AA-26

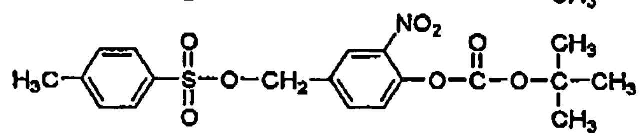

AA-27

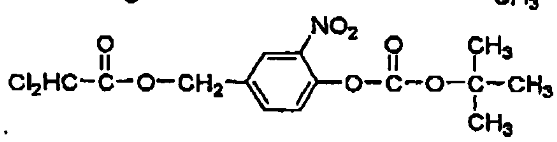

AA-28

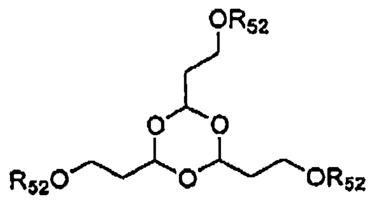

| | $R_{52}$ |
|---|---|
| AA-29 | 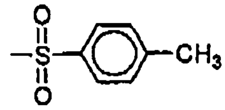 |
| AA-30 | 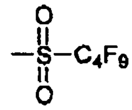 |

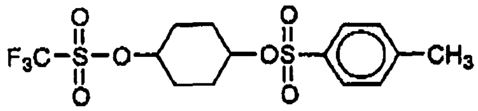

AA-31

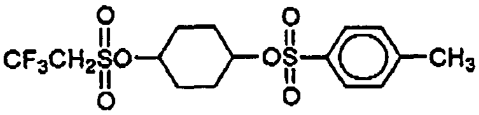

AA-32

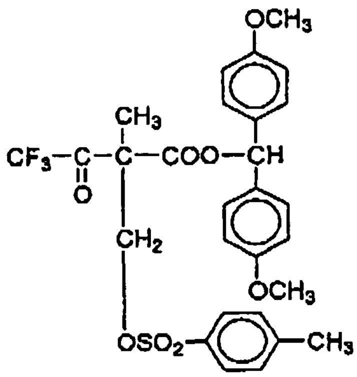

AA-33

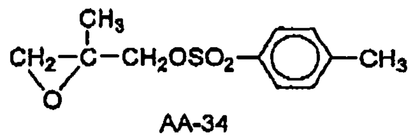

AA-34

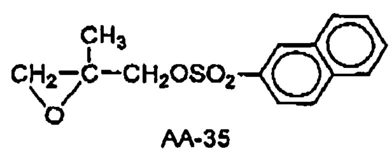

AA-35

Since heating is preferable for acid proliferation, a heat treatment is preferably executed after a holographic exposure.

In the following, there will be explained a case where the interference fringe recording component of the invention or a composition therefor includes at least a base-induced color forming dye precursor as a dye precursor and a base generating agent.

A base generating agent means a compound capable of generating a base by an energy transfer or an electron transfer from a sensitizing dye or an excited state of a color developed substance. The base generating agent is preferably stable in a darkplace. The base generating agent in the invention is preferably a compound capable of generating a base by an energy transfer or an electron transfer from an excited state of a sensitizing dye or a color developed substance.

The base generating agent of the invention preferably generates a Bronsted's base by light, more preferably an organic base and particularly preferably an amine as an organic base.

The base generating agent of the invention is preferably represented by the aforementioned general formulas (1-1) to (1-4). These base generating agents may be employed if necessary in a mixture of two or more kinds of an arbitrary ratio.

In the general formula (1-1) or (1-2), $R_1$ and $R_2$ each independently represents a hydrogen atom, an alkyl group (preferably with 1 to 20 carbon atoms, such as methyl, ethyl, n-propyl, isopropyl, n-butyl, n-pentyl, n-octadecyl, benzyl, 3-sulfopropyl, 4-sulfobutyl, carboxymethyl or 5-carboxypentyl), an alkenyl group (preferably with 2 to 20 carbon atoms, such as vinyl, allyl, 2-butenyl or 1,3-butadienyl), a cycloalkyl group (preferably with 3 to 20 carbon atoms, such as cyclopentyl, or cyclohexyl), an aryl group (preferably with 6 to 20 carbon atoms, such as phenyl, 2-chlorophenyl, 4-methoxyphenyl, 3-methylphenyl, 1-naphthyl or 2-naphthyl), or a heterocyclic group (preferably with 1 to 20 carbon atoms, such as pyridyl, thienyl, furyl, thiazolyl, imidazolyl, pyrazolyl, pyrolidino, piperidino or morpholino), more preferably a hydrogen atom, an alkyl group or a cycloalkyl group, and further preferably ahydrogen atom, amethyl group, an ethyl group, a cyclohexyl group or a cyclopentyl group.

$R_1$ and $R_2$ may be mutually bonded to form a ring, and a heterocycle to be formed is preferably a piperidine ring, a pyrrolidine ring, a piperadine ring, a morpholine ring, a pyridine ring, a quinoline ring or an imidazole ring, more preferably a piperidine ring, a pyrrolidine ring or an imidazole ring, andmost preferably a piperidine ring.
A more preferred combination of $R_1$ and $R_2$ includes a case where $R_1$ is a cyclohexyl group that may be substituted and $R_2$ is a hydrogen atom, a case where $R_1$ is an alkyl group that may be substituted and $R_2$ is a hydrogen atom, and a case where $R_1$ and $R_2$ are bonded to form a piperidine ring or an imidazole ring.
In the general formula (1-1) or (1-2), n1 represents 0 or 1, preferably 1.
In the general formula (1-1), $R_3$ represents a substituent, and preferred examples of the substituent include an alkyl group (preferably with 1 to 20 carbon atoms, such as methyl, ethyl, n-propyl, isopropyl, n-butyl, n-pentyl, benzyl, 3-sulfopropyl, 4-sulfobutyl, carboxymethyl or 5-carboxypentyl), an alkenyl group (preferably with 2 to 20 carbon atoms, such as vinyl, allyl, 2-butenyl or 1, 3-butadienyl) , a cycloalkyl group (preferably with 3 to 20 carbon atoms, such as cyclopentyl, or cyclohexyl), an aryl group (preferably with 6 to 20 carbon atoms, such as phenyl, 2-chlorophenyl, 4-methoxyphenyl, 3-methylphenyl, or 1-naphthyl), a heterocyclic group (preferably with 1 to 20 carbon atoms, such as pyridyl, thienyl, furyl, thiazolyl, imidazolyl, pyrazolyl, pyrolidino, piperidino or morpholino), an alkinyl group (preferably with 2 to 20 carbon atoms, such as ethinyl, 2-propinyl, 1,3-butadinyl, or 2-phenylethinyl), a halogen atom (such as F, Cl, Br or I), an amino group (preferably with 0 to 20 carbon atoms, such as amino, dimethylamino, diethylamino, dibutylamino, or anilino), a cyano group, a nitro group, a hydroxyl group, a mercapto group, a carboxyl group, a sulfo group, a phosphoric acid group, an acyl group (preferably with 1 to 20 carbon atoms, such as acetyl, benzoyl, salicyloyl or pivaloyl), an alkoxy group (poreferably with 1 to 20 carbon atoms, such as methoxy, butoxy or cyclohexyloxy) , an aryloxy group (preferably with 6 to 26 carbon atoms, such as phenoxy or 1-naphthoxy), an alkylthio group (preferably with 1 to 20 carbon atoms, such as methylthio or ethylthio), an arylthio group (preferably with 6 to 20 carbon atoms, such as phenylthio or 4-chlorophenylthio), an alkylsulfonylgroup (preferably with 1 to 20 carbon atoms, such as methanesulfonyl or butanesulfonyl), an arylsulfonyl group (preferably with 6 to 20 carbon atoms, such as benzenesulfonyl or paratoluenesulfonyl), asulfamoylgroup (preferably with 0 to 20 carbon atoms, such as sulfamoyl, N-methylsulfamoyl or N-phenylsulfamoyl), a carbamoyl group (preferably with 1 to 20 carbon atoms, such as carbamoyl, N-methylcarbamoyl, N,N-dimethylcarbamoyl or N-phenylcarbamoyl), an acylamino group (preferably with 1 to 20 carbon atoms, such as acetylamino, or benzoylamino), an imino group (preferablywith 2 to 20 carbon atoms, such as phthalimino) , an acyloxy group (preferably with 1 to 20 carbon atoms, such as acetyloxy or benzoyloxy) , an alkoxycarbonyl group (preferably with 2 to 20 carbon atoms, such as methoxycarbonyl or phenoxycarbonyl), and a carbamoylamino group (preferably with 1 to 20 carbon atoms, such as carbamoylamino, N-methylcarbamoylamino or N-phenylcarbamoylamino), and more preferably an alkyl group, an aryl group, a heterocyclic group, a halogen atom, an amino group, a cyano group, a nitro group, a carboxyl group, a sulfo group, an alkoxy group, an alkylthio group, an arylsulfonyl group, a sulfamoyl group, a carbamoyl group and an alkoxycarbonyl group.
In the general formula (1-1), $R_3$ is preferably a nitro group or an alkoxy group, more preferably a nitro group or a methoxy group, and most preferably a nitro group.
In the general formula (1-1), n2 represents an integer of 0 to 5, preferably 0 to 3 and further preferably 1 or 2. In case n2 is 2 or larger, plural $R_3$ may be mutually same or different or may be bonded to form a ring, and a ring to be formed is preferably a benzene ring or a naphthalene ring.
In case $R_3$ is a nitro group in the general formula (1-1), it is preferably substituted in 2-position or in 2- and 6-positions, and, in case $R_3$ is an alkoxy group, it is preferably substituted in 3- and 5-positions.
In the general formula (1-1), $R_4$ and $R_5$ each independently represents a hydrogen atom or a substituent (of which preferred examples are same as those for $R_3$), preferably a hydrogen atom, an alkyl group or an aryl group, and more preferably a hydrogen atom, a methyl group or a 2-nitrophenyl group.
More preferred combination of $R_4$ and $R_5$ includes a case where $R_4$ and $R_5$ are both hydrogen atoms, a case where $R_4$ is a methyl group and $R_5$ is a hydrogen atom, a case where $R_4$ and $R_5$ are both methyl groups, and a case where $R_4$ is a 2-nitrophenyl group and $R_5$ is a hydrogen atom, more preferably a case where $R_4$ and $R_5$ are both hydrogen atoms.
In the general formula (1-2), $R_6$ and $R_7$ each independently represents a substituent (of which preferred examples are same as those for $R_3$), preferably an alkoxy group, an alkylthio group, a nitro group or an alkyl group, more preferably a methoxy group.
In the general formula (1-2), n3 and n4 each independently represents an integer of 0 to 5, preferably 0 to 2. In case n3 or n4 is 2 or larger, plural $R_6$ or $R_7$ may be mutually same or different, or may be bonded to form a ring, and a ring to be formed is preferably a benzene ring or a naphthalene ring.
In the general formula (1-2), $R_6$ is more preferably an alkoxy group substituted in 3- and 5-positions, and further preferably a methoxy group substituted in 3- and 5-positions.
In the general formula (1-2), $R_8$ represents a hydrogen atom or a substituent (of which preferred examples are same as those for $R_3$), preferably a hydrogen atom or an aryl group, more preferably a hydrogen atom.
In the general formula (1-3), $R_9$ represents a substituent (of which preferred examples are same as those for

$R_3$), preferably an alkyl group, an aryl group, a benzyl group, or an amino group, more preferably an alkyl group that may be substituted, a t-butyl group, a phenyl group, a benzyl group, an aniline group that may be substituted, or a cyclohexylamino group.

A compound represented by the general formula (1-3) may be a compound connected to a polymer chain from $R_9$.

In the general formula (1-3), $R_{10}$ and $R_{11}$ each independently represents a hydrogen atom or a substituent (of which preferred examples are same as those for $R_3$), preferably an alkyl group or an aryl group, more preferably a methyl group, a phenyl group or a 2-naphthyl group.

$R_{10}$ and $R_{11}$ may be mutually bonded to form a ring, and a ring to be formed is preferably a fluorene ring.

In the general formula (1-4), $R_{12}$ represents an aryl group or a heterocyclic group, more preferably an aryl group or a heterocyclic ring shown below.

$R_{12}$: 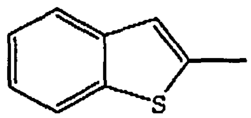 , 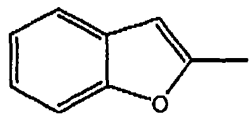 , 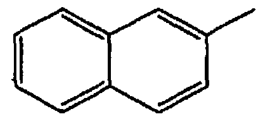 .

In the general formula (1-4), $R_{13}$, $R_{14}$ and $R_{15}$ each independently represents a hydrogen atom, an alkyl group, an alkenyl group, a cycloalkyl group, an aryl group, or a heterocyclic group (preferred examples of the foregoing being same as those for $R_1$ and $R_2$), preferably an alkyl group and more preferably a butyl group. $R_{13}$, $R_{14}$ and $R_{15}$ may be mutually bonded to form a ring, and a heterocycle to be formed is preferably a piperidine ring, apyrrolidine ring, a piperadine ring, a morpholine ring, a pyridine ring, a quinoline ring or an imidazole ring, more preferably a piperidine ring, a pyrrolidine ring or an imidazole ring.

In the general formula (1-4), $R_{16}$, $R_{17}$, $R_{18}$ and $R_{19}$ each independently represents an alkyl group or an aryl group, and more preferred is a case where $R_{16}$, $R_{17}$ and $R_{18}$ are all phenyl groups and $R_{19}$ is an n-butyl group or a phenyl group.

The base generating agent of the invention is preferably represented by the aforementioned general formula (1-1) or (1-3), more preferably by the general formula (1-1).

Specific preferred examples of the base generating agent of the invention are shown in the following, but the present invention is not limited to such examples.

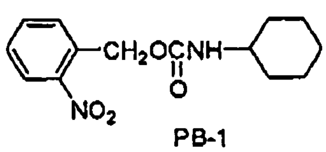

PB-1

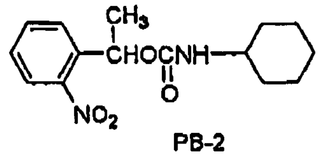

PB-2

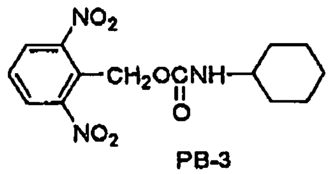

PB-3

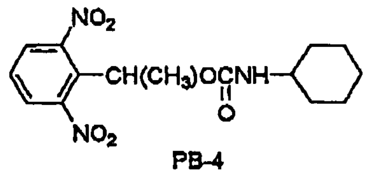

PB-4

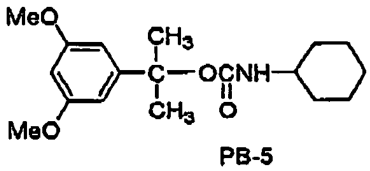

PB-5

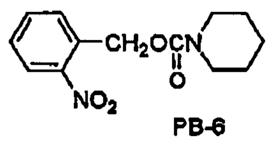

PB-6

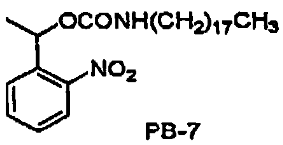

PB-7

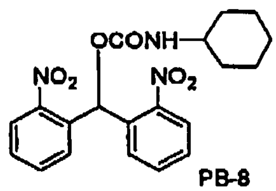

PB-8

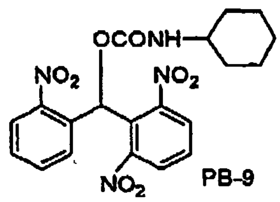

PB-9

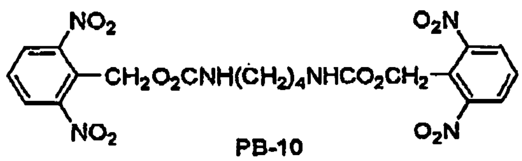

PB-10

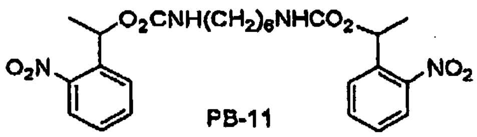

PB-11

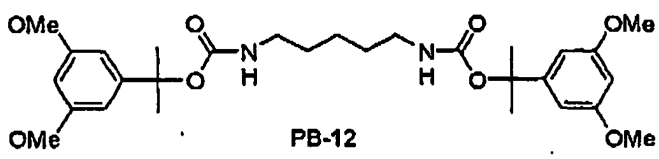

PB-12

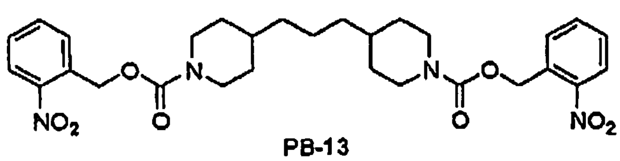

PB-13

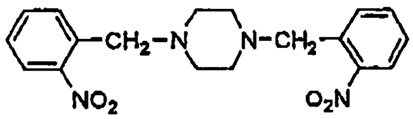

PB-14

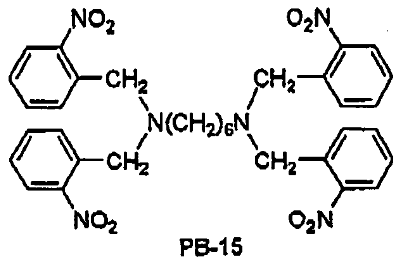

PB-15

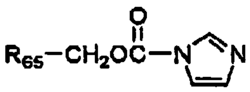

| | R65 | | R65 |
|---|---|---|---|
| PB-16 | 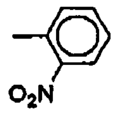 | PB-18 | 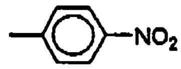 |
| PB-17 | 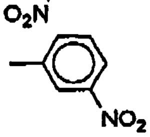 | PB-19 | 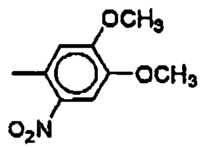 |

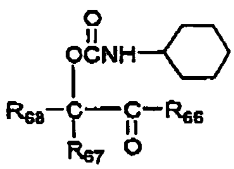

| | R66 | R67 | R68 |
|---|---|---|---|
| PB-20 | 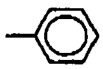 | 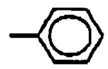 | —H |
| PB-21 | 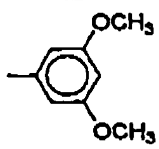 | 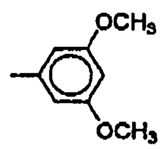 | " |
| PB-22 | 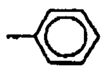 | " | " |
| PB-23 | 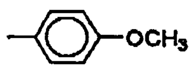 | " | " |
| PB-24 | 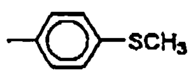 | " | " |
| PB-25 | 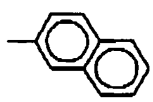 | " | " |
| PB-26 | 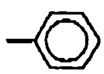 | " | 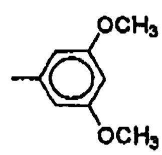 |

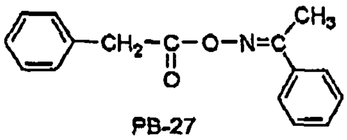

PB-27

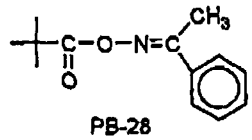

PB-28

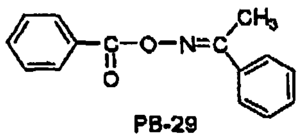

PB-29

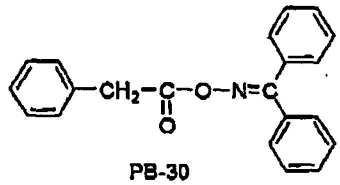

PB-30

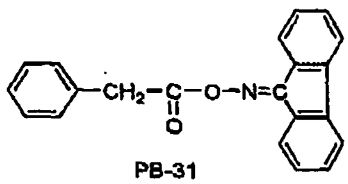

PB-31

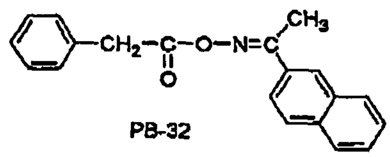

PB-32

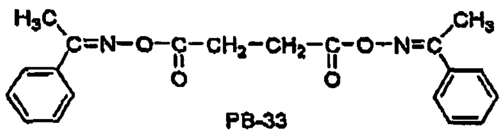

PB-33

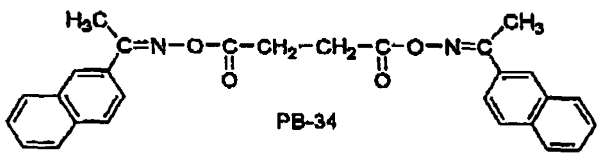

PB-34

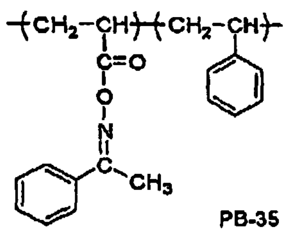

PB-35

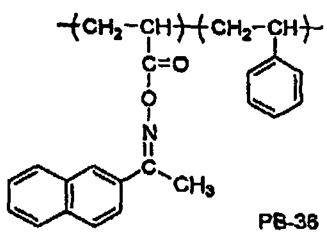

PB-36

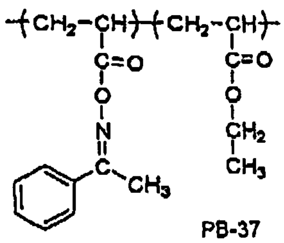

PB-37

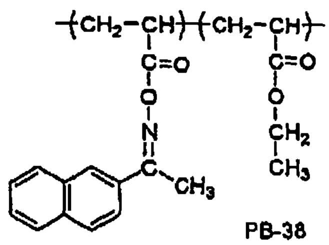

PB-38

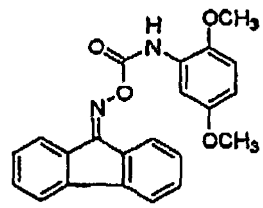

PB-39

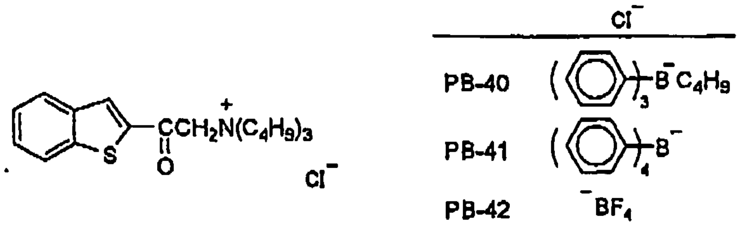

PB-40

PB-41

PB-42

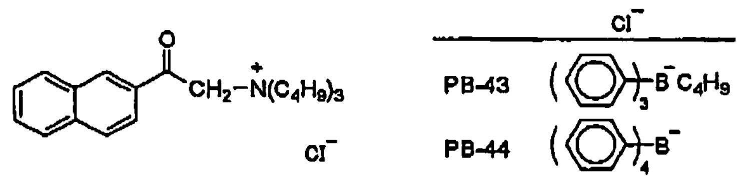

PB-43

PB-44

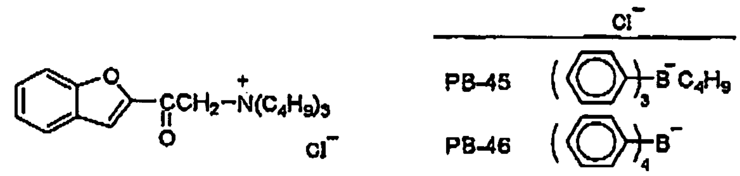

PB-45

PB-46

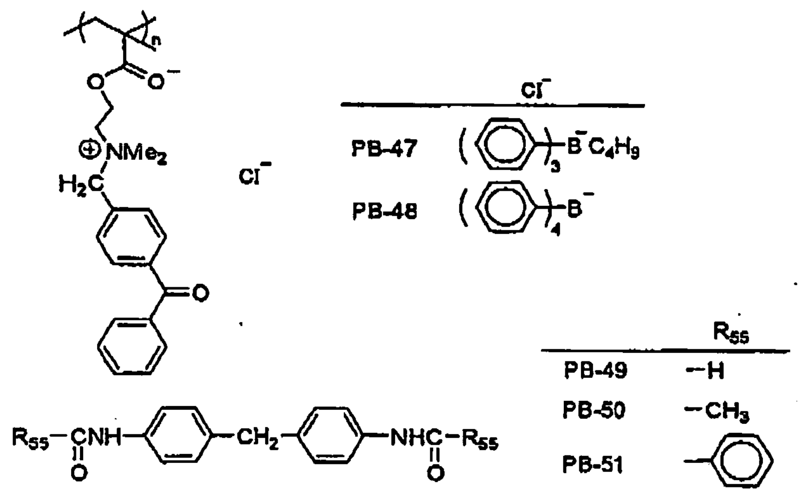

PB-47

PB-48

PB-49

PB-50

PB-51

$[Co(III)(NH_3)_5Br](ClO_4)_2$ PB-52

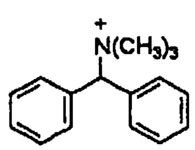

PB-53

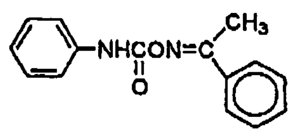

PB-54

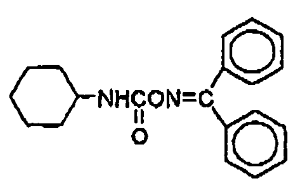

PB-55

In the following, there will be explained a base-induced color forming dye precursor to be employed in a case where the interference fringe recording component of the invention or a composition therefor includes at least a base-induced color forming dye precursor as a dye precursor and a base generating agent.

The base-induced color forming dye precursor in the invention is a dye precursor that can form a color-developed substance of which absorption is changed from an original state, by a base generated by the base generating agent. The base-induced color forming dye precursor in the invention is preferably a compound of which absorption changes to a longer wavelength by the acid, more preferably a compound which develops a color from a colorless

state by a base.

The base-induced color forming dye precursor is preferably a non-dissociated substance of a dissociable dye. A dissociable dye means a compound which has, on a dye chromophore, a dissociable group dissociating at a pKa value of 12 or less, preferably 10 or less, to release a proton, and which shows a shift of the absorption to a longer wavelength or a shift from a colorless state to a colored state by the transition from the non-dissociated state to the dissociated state. The dissociable group ca preferably be OH, SH, COOH, $PO_3H_2$, $SO_3H$, $NR_{91}R_{92}H^+$, $NHSO_2R_{93}$, $CHR_{94}R_{95}$ or $NHR_{96}$.

$R_{91}$, $R_{92}$ and $R_{96}$ each independently represents a hydrogen atom, an alkyl group, an alkenyl group, a cycloalkyl group, an aryl group or a heterocyclic group (preferred examples of the foregoing being same as those for $R_3$), preferably a hydrogen atom or an alkyl group. $R_{93}$ represents an alkyl group, an alkenyl group, a cycloalkyl group, an aryl group or a heterocyclic group (preferred examples of the foregoing being same as those for $R_3$), preferably an alkyl group that may be substituted, or an aryl group that may be substituted, more preferably an alkyl group that may be substituted, and a substituent in such case is preferably an electron attracting group, more preferably a fluorine atom.

$R_{94}$ and $R_{95}$ each independently represents a substituent (of which preferred examples are same as those for $R_3$), preferably an electron attracting substituent and more preferably a cyano group, an alkoxycarbonyl group, a carbamoyl group, an acyl group, an alkylsulfonyl group or an arylsulfonyl group.

The dissociable group of the dissociable dye in the invention is more preferably an OH group, a COOH group, an $NHSO_2R_{93}$ group, an $NHR_{96}$ group or a $CHR_{94}R_{95}$ group, further preferably an OH group or a $CHR_{94}R_{95}$ group, and most preferably an OH group.

A non-dissociated substance of the dissociable dye preferred as the base-induced color forming dye precursor of the invention can be a non-dissociated substance of a dissociable azo dye, a dissociable azomethine dye, a dissociable oxonol dye, a dissociable arylidene dye, a dissociable xanthene dye, a dissociable fluorane dye or a dissociable triphenylamine dye, more preferably a non-dissociated substance of a dissociable azo dye, a dissociable azomethine dye, a dissociable oxonol dye, or a dissociable arylidene dye.

In the following, examples of the non-dissociated substance of the dissociable dye are shown as examples of the base-induced color forming dye precursor of the invention, but the present invention is not limited to such examples.

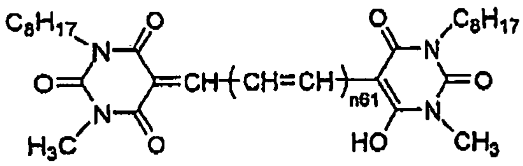

| | $n_{61}$ |
|---|---|
| DD-1 | 1 |
| DD-2 | 2 |
| DD-3 | 3 |

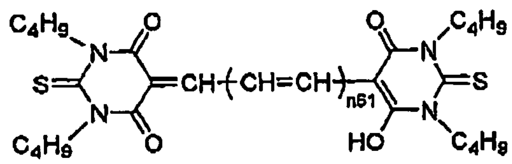

| | $n_{61}$ |
|---|---|
| DD-4 | 0 |
| DD-5 | 1 |
| DD-6 | 2 |

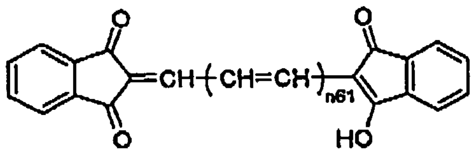

| | $n_{61}$ |
|---|---|
| DD-7 | 0 |
| DD-8 | 1 |
| DD-9 | 2 |

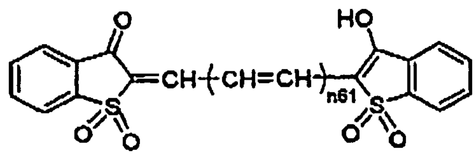

| | $n_{61}$ |
|---|---|
| DD-10 | 0 |
| DD-11 | 1 |
| DD-12 | 2 |

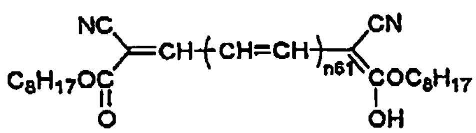

| | $n_{61}$ |
|---|---|
| DD-13 | 0 |
| DD-14 | 1 |
| DD-15 | 2 |

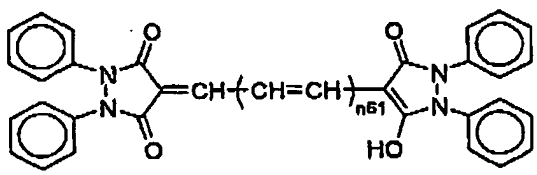

| | $n_{61}$ |
|---|---|
| DD-16 | 0 |
| DD-17 | 2 |
| DD-18 | 3 |

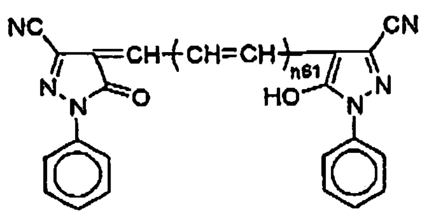

| | $n_{61}$ |
|---|---|
| DD-19 | 1 |
| DD-20 | 2 |

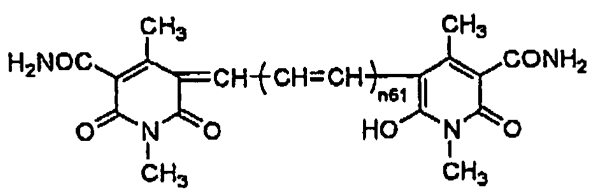

| | $n_{61}$ |
|---|---|
| DD-21 | 1 |
| DD-22 | 2 |

DD-23

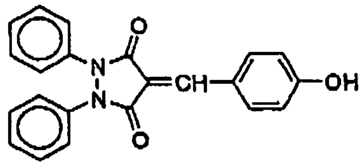

DD-24

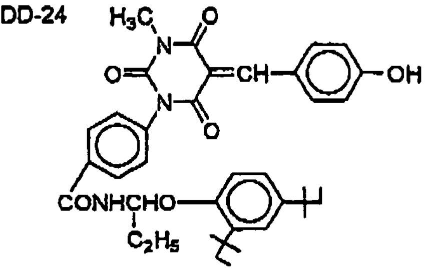

DD-25

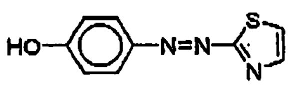

DD-26

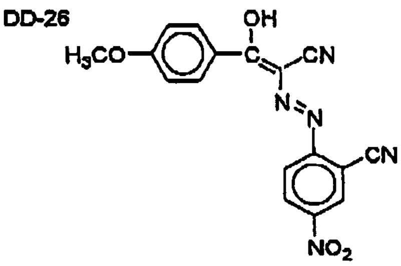

DD-27

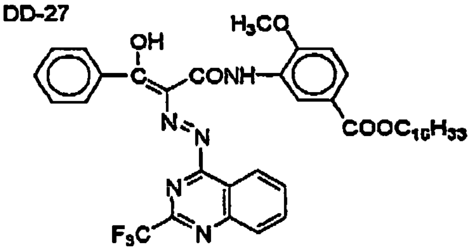

DD-28

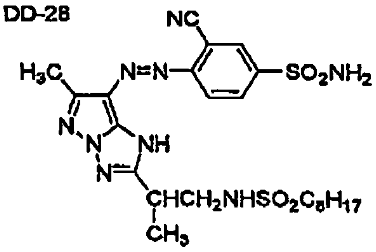

DD-29

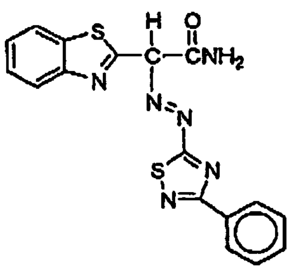

DD-30

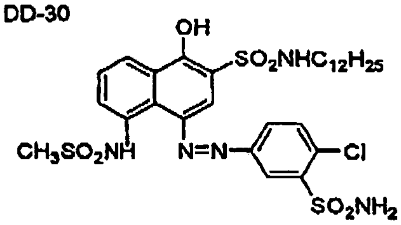

DD-31

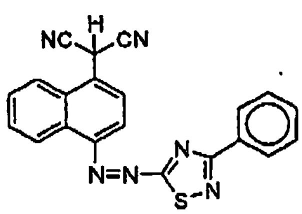

DD-32

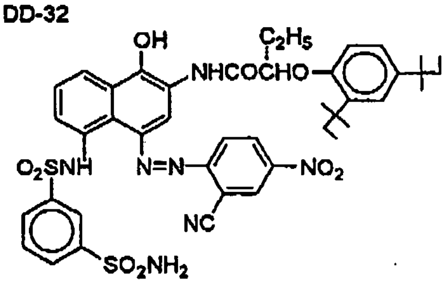

DD-33

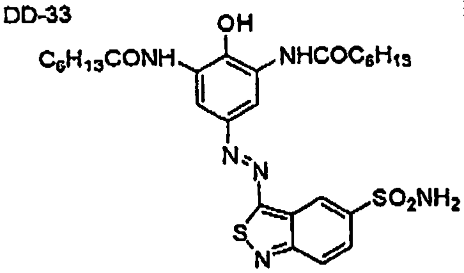

DD-34

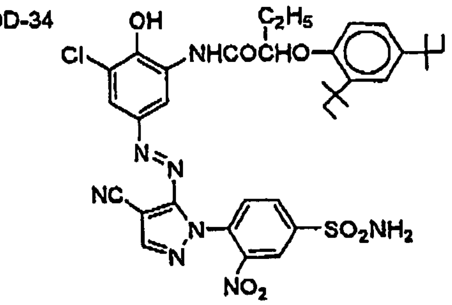

DD-35

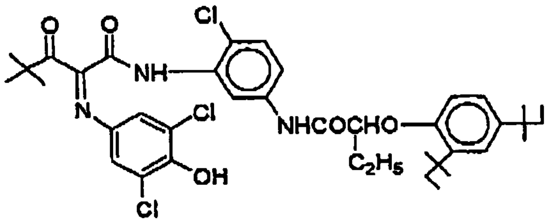

DD-36

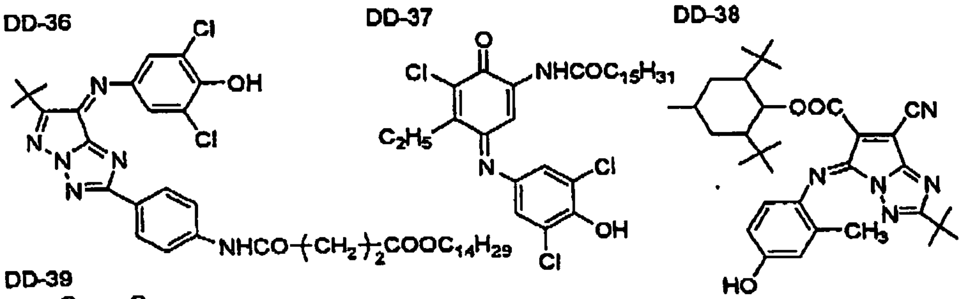

DD-37

DD-38

DD-39

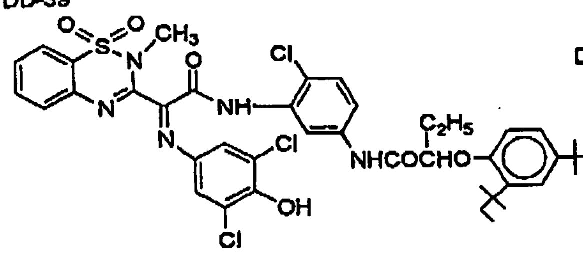

DD-40

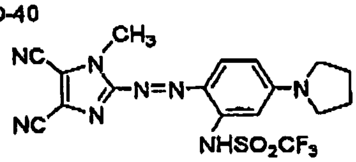

DD-41

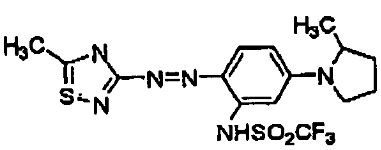

DD-42

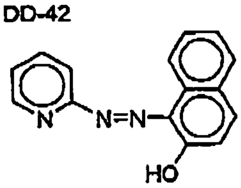

DD-43

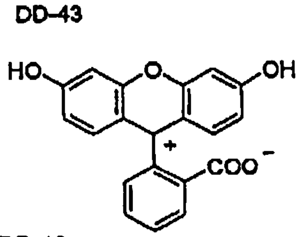

DD-44

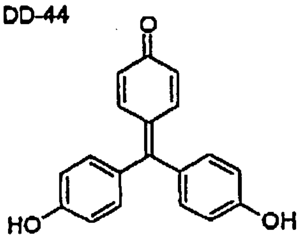

DD-45

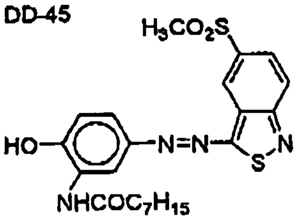

DD-46

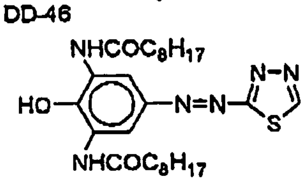

DD-47

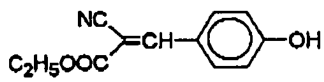

DD-48

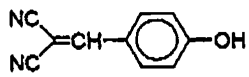

DD-49

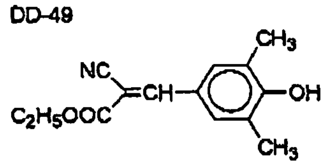

In case the interference fringe recording component of the invention includes at least a base-induced color forming dye precursor as a dye precursor and a base generating agent, it may further contain a base proliferating agent.

A base proliferating agent of the invention is a compound that is stable in the absence of a base but is decomposed in the presence of a base thereby releasing a base, which decomposes another base proliferating agent to further release a base, thus capable of a base proliferation utilizing a small amount of base generated by the base generating agent as a trigger.

The base proliferating agent is preferably represented by the foregoing general formula (5).

In the general formula (5), $R_{121}$ and $R_{122}$ each independently represents a hydrogen atom, an alkyl group, an alkenyl group, a cycloalkyl group, an aryl group, or a heterocyclic group (preferred examples of the foregoing substituent being same as those for $R_1$), more preferably a hydrogen atom, an alkyl group or a cycloalkyl group, and further preferably a hydrogen atom, a methyl group, an ethyl group, a cyclohexyl group or a cyclopentyl group.

$R_{121}$ and $R_{122}$ may be mutually bonded to form a ring, and a heterocycle to be formed is preferably a piperidine ring, a pyrrolidine ring, a piperadine ring, a morpholine ring, a pyridine ring, a quinoline ring or an imidazole ring, more preferably a piperidine ring, a pyrrolidine ring or an imidazole ring, and most preferably a piperidine ring.

A more preferred combination of $R_{121}$ and $R_{122}$ includes a case where $R_{121}$ is a cyclohexyl group which may be substituted and $R_{122}$ is a hydrogen atom, a case where $R_{121}$ is an alkyl group which may be substituted and $R_{122}$ is a hydrogen atom, and a case where $R_{121}$ and $R_{122}$ are mutually bonded to form a piperidine ring or an imidazole ring.

$R_{123}$ and $R_{124}$ each independently represents a hydrogen atom or a substituent (of which preferred examples are same as those for $R_3$), preferably a hydrogen atom, an aryl group or an arylsulfonyl group, and more preferably an aryl group.

$R_{123}$ and $R_{124}$ may be mutually bonded to form a ring, and a ring to be formed is preferably a fluorene ring.

$R_{125}$ and $R_{126}$ each independently represents a hydrogen atom or a substituent (of which preferred examples are same as those for $R_3$), preferably a hydrogen atom or an alkyl group, and more preferably a hydrogen atom or a methyl group.

n102 represents an integer 0 or 1, preferably 1.

The base proliferating agent of the invention is preferably represented by a general formula (6-1) or (6-2), in which $R_{121}$ and $R_{122}$ have same meanings as in the general formula (5).

The base proliferating agent of the invention is more preferably represented by the general formula (6-1).

Examples of the base proliferating agent of the invention will be shown in the following, but the present invention is not limited to these examples.

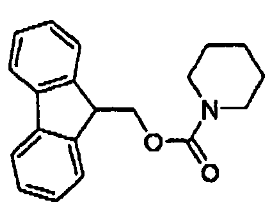

BA-1

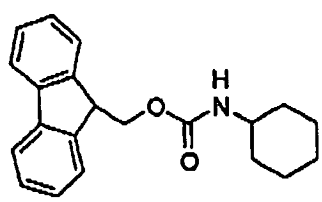

BA-2

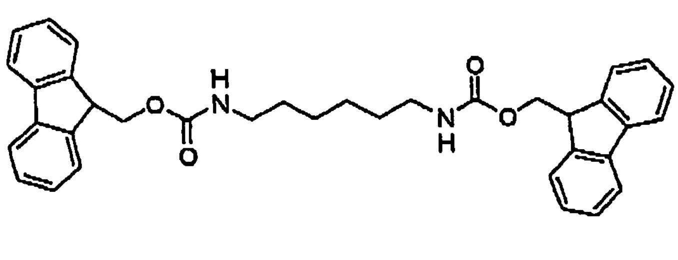

BA-3

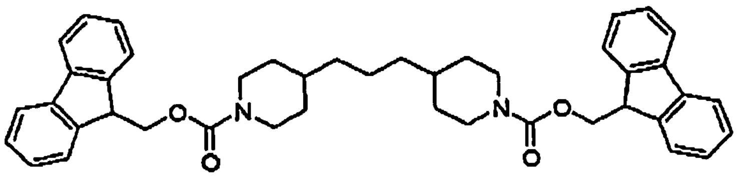

BA-4

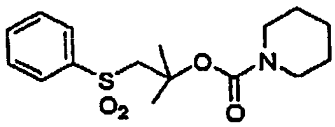

BA-5

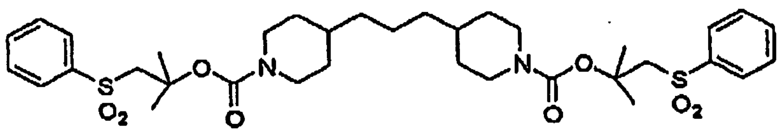

BA-6

Since heating is preferable for base proliferation, in case the hologram recording material of the invention employs a base proliferating agent, a heat treatment is preferably executed after a holographic exposure.

In the following, there will be explained a case where the interference fringe recording component of the invention includes a compound in which an organic compound site, having a function of cleaving a covalent bond by an electron transfer or an energy transfer with a sensitizing dye or a color-developed substance in an excited state, and an organic compound site, having a feature of constituting a color-developed substance when covalent bonded or when released, are covalent bonded.

In such case, the interference fringe recording component of the invention preferably includes at least a dye precursor represented by the aforementioned general formula (2).

In the general formula (2), A1 and PD are covalent bonded; A1 represents an organic compound site, having a function of cleaving a covalent bond with PD by an electron transfer or an energy transfer with a sensitizing dye or a color-developed substance in an excited state; and PD represents an organic compound site, having a feature of constituting a color-developed substance when it is covalent bonded with A1 or when it is released by the cleavage of the covalent bond with A1.

More preferably, A1 is an organic compound site, having a function of cleaving the covalent bond with PD by an electron transfer with a sensitizing dye or a color-developed substance in an excited state.

PD is preferably a group constituted of a dissociable dye such as a dissociable azo dye, a dissociable azomethine dye, a dissociable oxonol dye or a dissociable arylidene dye, or a dye that can form so-called "leuco dye" such as a triphenylmethane dye or a xanthene (fluorine) dye, and is bonded to A1 by a covalent bond on the chromophore.

PD is more preferably any one of a dissociable azo dye, a dissociable azomethine dye, a dissociable oxonol dye and a dissociable arylidene dye.

Preferably PD is colorless, pale-colored or has an absorption at a short wavelength when it is covalent bonded to A1, and is strongly colored or shows a shift of the absorption to a longer wavelength when it is released by a cleavage of the covalent bond with A1.

Preferred specific examples of PD are shown in the following, but the present invention is not limited to such examples.

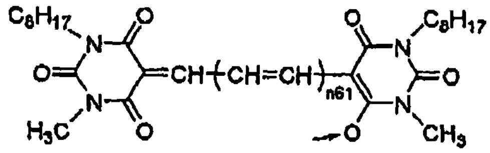

| | $n_{61}$ |
|---|---|
| PD-1 | 1 |
| PD-2 | 2 |
| PD-3 | 3 |

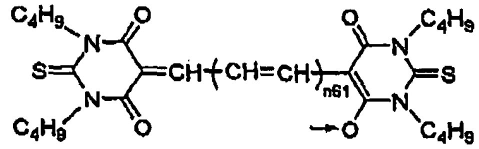

| | $n_{61}$ |
|---|---|
| PD-4 | 0 |
| PD-5 | 1 |
| PD-6 | 2 |

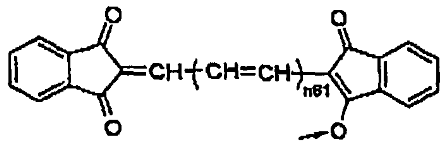

| | $n_{61}$ |
|---|---|
| PD-7 | 0 |
| PD-8 | 1 |
| PD-9 | 2 |

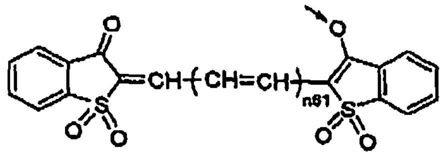

| | $n_{61}$ |
|---|---|
| PD-10 | 0 |
| PD-11 | 1 |
| PD-12 | 2 |

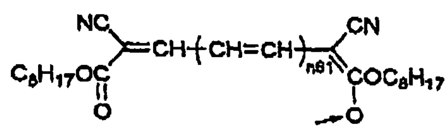

| | $n_{61}$ |
|---|---|
| PD-13 | 0 |
| PD-14 | 1 |
| PD-15 | 2 |

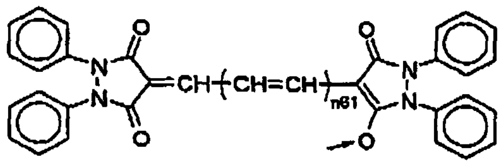

| | $n_{61}$ |
|---|---|
| PD-16 | 0 |
| PD-17 | 2 |
| PD-18 | 3 |

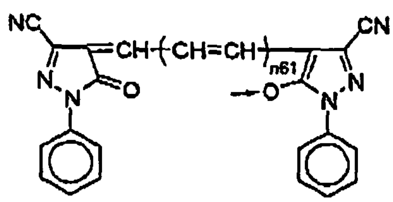

| | $n_{61}$ |
|---|---|
| PD-19 | 1 |
| PD-20 | 2 |

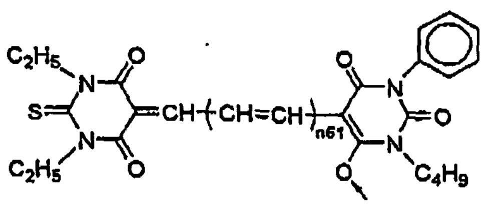

| | $n_{61}$ |
|---|---|
| PD-21 | 0 |
| PD-22 | 1 |

PD-23

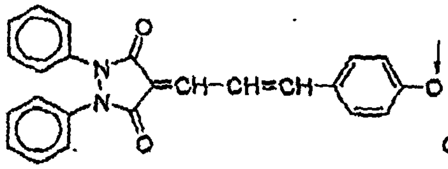

PD-24

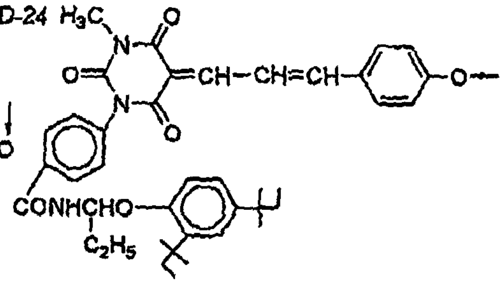

PD-25

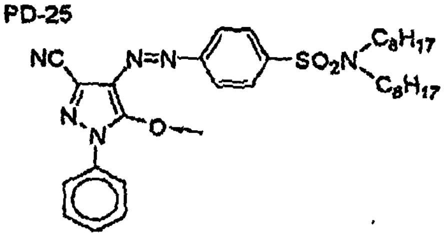

PD-26

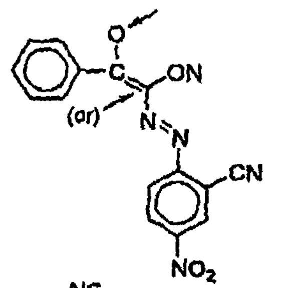

PD-27

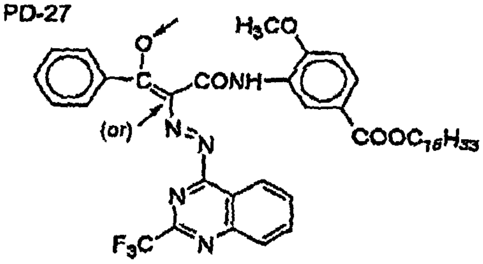

PD-28

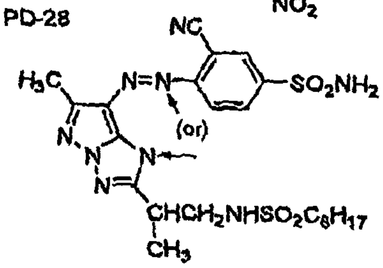

PD-29

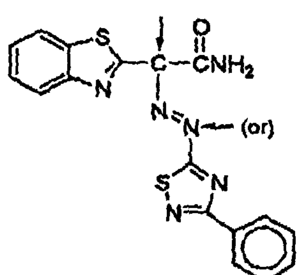

PD-30

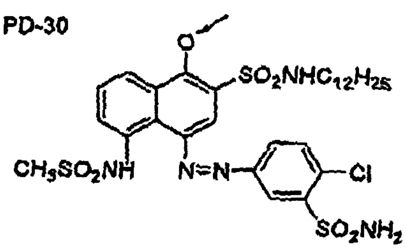

PD-31

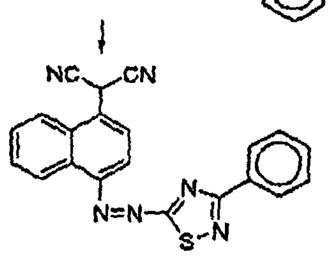

PD-32

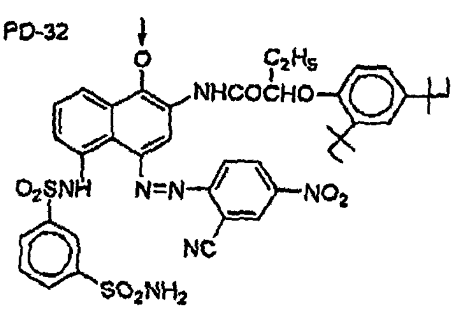

PD-33

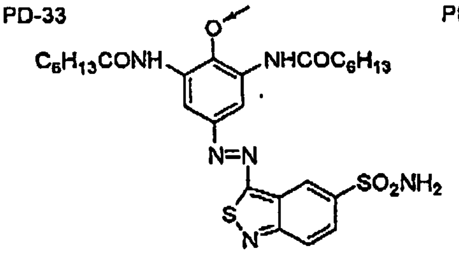

PD-34

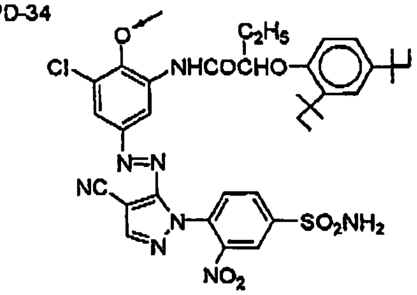

PD-35

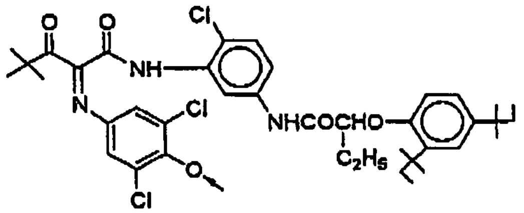

PD-36

PD-37

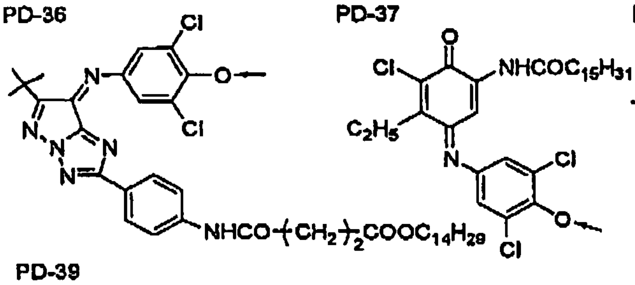

PD-38

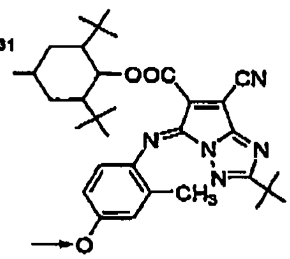

PD-39

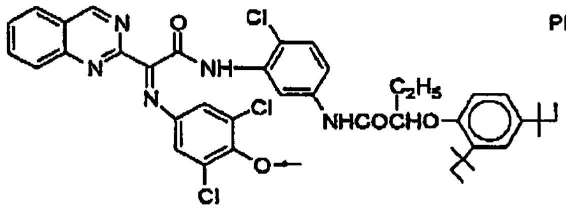

PD-40

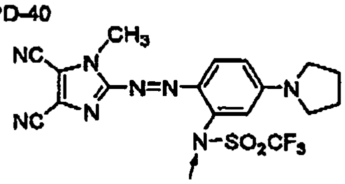

PD-41

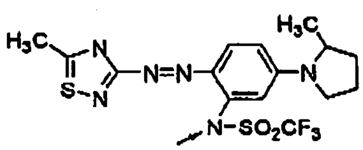

PD-42

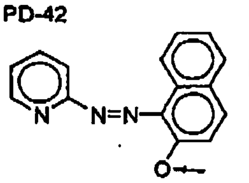

PD-43

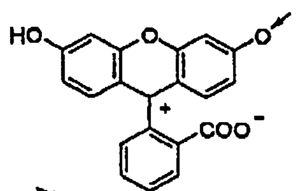

PD-44

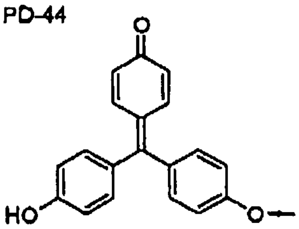

PD-45

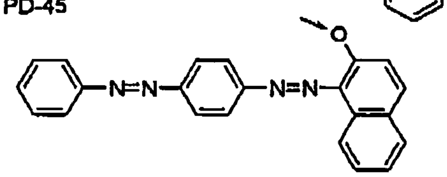

PD-46

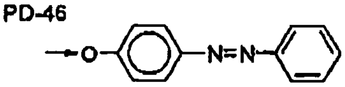

PD-47

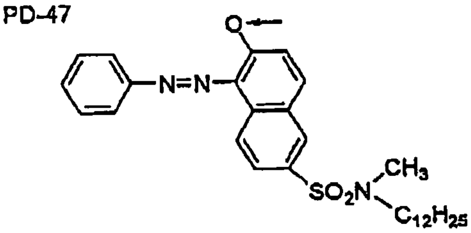

PD-48

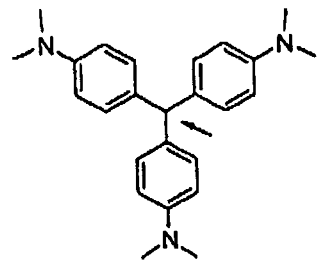

PD-49

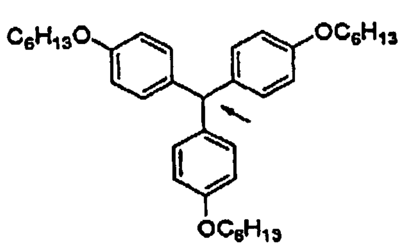

PD-50

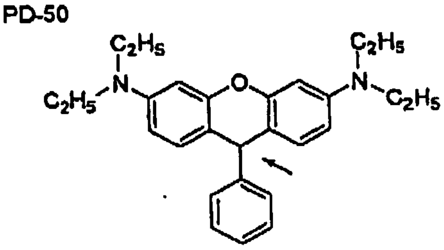

PD-51

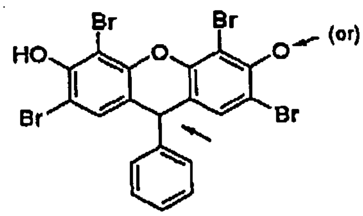

(or)

PD-52

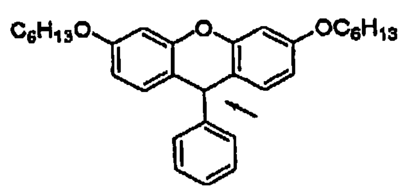

PD-53

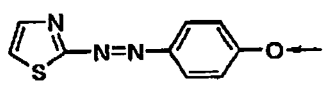

PD-54

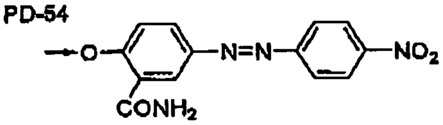

PD-55

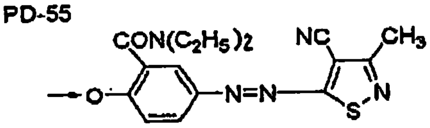

PD-56

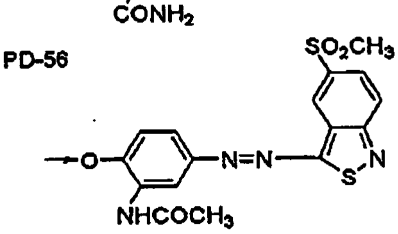

PD-57

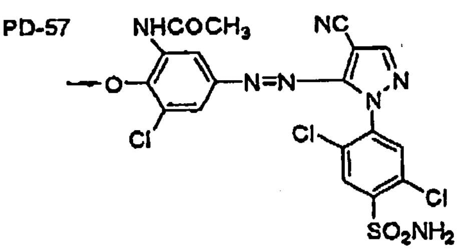

PD-58

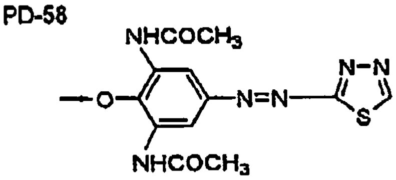

PD-59

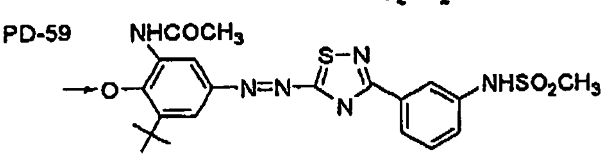

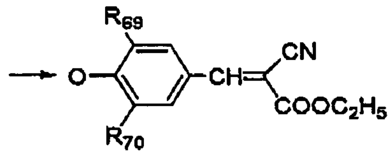

| | $R_{69}$ | $R_{70}$ |
|---|---|---|
| PD-60 | H | H |
| PD-61 | Cl | H |
| PD-62 | Cl | Cl |

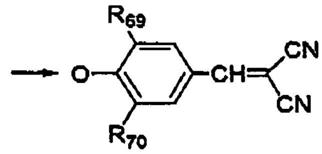

| | $R_{69}$ | $R_{70}$ |
|---|---|---|
| PD-63 | H | H |
| PD-64 | Cl | H |
| PD-65 | Cl | Cl |

In forming a covalent bond with A1, PD may form a covalent bond with any position of A1 as long as it is on the chromophore, but preferably forms a covalent bond with A1 at an atom indicated by an arrow in the foregoing formulas.

The dye precursor of the general formula is more preferably represented by any of the general formulas (3-1) to (3-6).

In the general formulas (3-1) to (3-6), PD has the same meaning as in the general formula (2).

In the general formula (3-1), $R_{71}$ represents a hydrogen atom or a substituent (of which preferred examples are same as those for $R_3$), preferably an alkyl group or an aryl group, more preferably a t-butyl group, a methyl group or a phenyl group, and further preferably a methyl group or a t-butyl group.

$R_{72}$ represents a substituent (of which preferred examples are same as those for $R_3$), preferably an electron attracting group, and more preferably a nitro group, a sulfamoyl group, a carbamoyl group, an alkoxycarbonyl group, a cyano group or a halogen atom; a71 represents an integer from 0 to 5, and, in case a71 is 2 or larger, plural $R_{72}$ may be mutually same or different or may be mutually bonded to form a ring. a71 is preferably 1 or 2, and $R_{72}$ is preferably substituted in 2- or 4-position.

In the general formula (3-2), $R_{73}$ represents a substituent (of which preferred examples are same as those for $R_3$), preferably an electron attracting group, more preferably a nitro group, a sulfamoyl group, a carbamoyl group, an alkoxycarbonyl group, a cyano group or a halogen atom and further preferably a nitro group; a72 each independently represents an integer from 0 to 5, and, in case a72 is 2 or larger, plural $R_{73}$ may be mutually same or different or may be mutually bonded to form a ring. a72 is preferably 1 or 2, and, in case a72 is 1, substitution is preferably on a 2-position, and, in case a72 is 2, the substitution is preferably on 2- and 4-positions or 2- and 6-positions, more preferably on 2- and 6-positions.

a73 represents 0 or 1.

In the general formula (3-3), $R_{74}$ - $R_{77}$ each independently represents an alkyl group, and they preferably represent methyl groups.

In the general formula (3-4), $R_{78}$ and $R_{79}$ each independently represent a substituent (of which preferred examples are same as those for $R_3$); and $R_{79}$ preferably represents an alkoxy group, more preferably a methoxy group; a74 and a75 each independently represents an integer from 0 to 5, and, in case a74 or a 75 is 2 or larger, plural $R_{78}$ or $R_{79}$ may be mutually same or different or may be mutually bonded to form a ring. Each of a74 and a75 preferably represents 0 to 2, and, a74 is more preferably 0 or 1 while a75 is more preferably 2. In case a75 is 2, $R_{79}$ is preferably substituted on 3- and 5-positions.

a76 represents 0 or 1.

In the general formula (3-5), $R_{80}$ and $R_{81}$ each independently represent a hydrogen atom or a substituent (of which preferred examples are same as those for $R_3$), and $R_{80}$ and $R_{81}$ may be mutually bonded to form a ring, and a ring to be formed is preferably a benzene ring or a norbornene ring. $R_{80}$ and $R_{81}$ not forming a ring are preferably both hydrogen atoms.

In the general formula (3-6), $R_{82}$ and $R_{83}$ each independently represent a substituent (of which preferred examples are same as those for $R_3$), preferably an alkyl group, an alkenyl group or an aryl group. $R_{82}$ and $R_{83}$ are preferably mutually bonded to form a ring, and a ring to be formed is preferably a fluorene ring, a dibenzopyran ring, or a tetrahydronaphthalene ring.

The dye precursor representedby the general formula (2) is preferably represented by the general formula (3-1), (3-2) or (3-4).

Preferred examples of the dye precursor of the invention represented by the general formulas (3-1) to (3-6) are shown in the following, but the present invention is not limited to such examples.

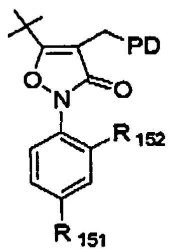

| | $R_{151}$ | $R_{152}$ | PD |
|---|---|---|---|
| E-1 | $-CONHC_2H_5$ | $-NO_2$ | PD-1 |
| E-2 | $-SO_2NHC_2H_5$ | 〃 | PD-7 |
| E-3 | $-CONHC_2H_5$ | 〃 | PD-4 |
| E-4 | 〃 | 〃 | PD-23 |
| E-5 | 〃 | 〃 | PD-24 |
| E-6 | $-SO_2NHC_2H_5$ | 〃 | PD-25 |
| E-7 | $-CONHC_2H_5$ | $-H$ | PD-26 |
| E-8 | $-OC_8H_{17}$ | $-Cl$ | PD-28 |
| E-9 | $-CONHC_{16}H_{33}$ | $-CN$ | PD-36 |
| E-10 | $-C_8H_{17}$ | $-NO_2$ | PD-37 |
| E-11 | $-SO_2N(C_2H_5)_2$ | 〃 | PD-33 |
| E-12 | 〃 | 〃 | PD-62 |
| E-13 | 〃 | 〃 | PD-65 |
| E-14 | 〃 | 〃 | PD-32 |
| E-15 | 〃 | 〃 | PD-35 |
| E-16 | 〃 | 〃 | PD-42 |
| E-17 | 〃 | 〃 | PD-54 |
| E-18 | 〃 | 〃 | PD-53 |
| E-19 | 〃 | 〃 | PD-58 |

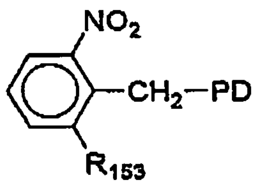

| | $R_{153}$ | PD |
|---|---|---|
| E-20 | H | PD-21 |
| E-21 | " | PD-10 |
| E-22 | $-NO_2$ | PD-4 |
| E-23 | H | PD-16 |
| E-24 | " | PD-24 |
| E-25 | $-NO_2$ | PD-23 |
| E-26 | H | PD-30 |
| E-27 | $-NO_2$ | PD-26 |
| E-28 | " | PD-29 |
| E-29 | " | PD-35 |
| E-30 | H | PD-39 |
| E-31 | " | PD-55 |
| E-32 | $-NO_2$ | PD-53 |
| E-33 | " | PD-65 |
| E-34 | H | PD-57 |

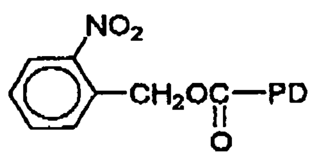

| | PD |
|---|---|
| E-35 | PD-4 |
| E-36 | PD-29 |
| E-37 | PD-35 |
| E-38 | PD-23 |
| E-39 | PD-53 |
| E-40 | PD-44 |

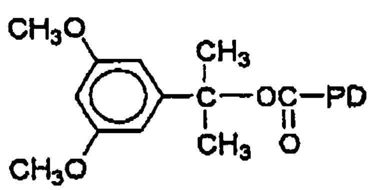

| | PD |
|---|---|
| E-41 | PD-16 |
| E-42 | PD-23 |
| E-43 | PD-31 |
| E-44 | PD-61 |
| E-45 | PD-42 |

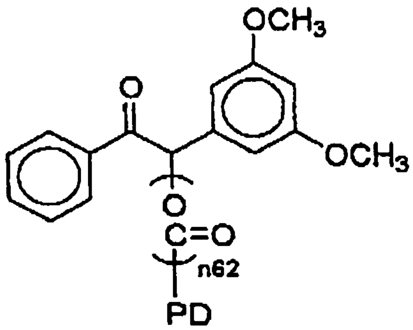

| | PD | $n_{62}$ |
|---|---|---|
| E-46 | PD-60 | 0 |
| E-47 | PD-30 | 0 |
| E-48 | PD-35 | 0 |
| E-49 | PD-52 | 1 |

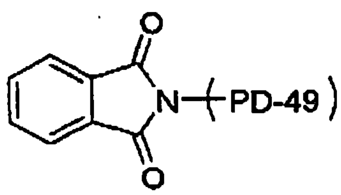

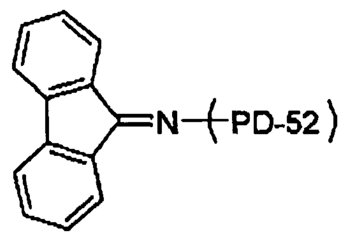

In case the interference fringe recording component of the invention includes at least a dye precursor represented by the following general formula (2) or any of (3-1) to (3-6), the hologram recording material of the invention preferably includes a base for the purpose of dissociating a dissociable dye to be generated. The base can be an organic base or an inorganic base, preferably an alkylamine, an aniline, an imidazole, a pyridine, a carbonate salt, a hydroxide salt, a carboxylic acid salt or a metal alkoxide. A polymer containing such base can also be advantageously employed.

In the following, there will be explained a case where the interference fringe recording component of the invention includes a compound capable of causing a reaction to change a form of the absorption by an electron transfer with a sensitizing dye or a color-developed substance in an excited state.

The compound capable of causing such change is generally called an "electrochromic compound".

The electrochromic compound to be employed as the dye precursor in the invention is preferably a polypyrrol (for example preferably polypyrrol, poly(N-methylpyrrol), poly(N-methylindole), or polypyrrolopyrrol), a polythiophene (for example preferably polythiophene, poly(3-hexylthiophene), polyisothianaphthene, polydithienothiophene, poly (3-hexylthiophene), polyisothioanaphthene, polydithienothiophene, or poly(3,4-ethylenedioxy)thiophene), a polyaniline (for example preferably polyaniline, poly(N-naphthylaniline), poly(o-phenylenediamine), poly(aniline-m-sulfonic acid), poly(2-methoxyaniline), poly(oaminophenol), or poly(diallylamine)), a poly(N-vinylcarbazole), a Co-pyridinoporphyrazine complex, a Ni-phenanthroline complex, or a Fe-basophenanthroline complex.

There is also preferred an electrochromic material such as a viologen, a polyviologen, a lanthanoid diphthalocyanine, a styryl dye, a TNF, a TCNQ/TTF complex, a Ru-trisbipyridyl complex etc.

The interference fringe recording component of the invention may be available commercially or synthesized by a known method.

In the hologram recording material of the invention, there can be advantageously employed an electron donating compound capable of reducing a radical cation of a sensitizing dye or a color developed substance, or an electron accepting compound capable of oxidizing a radical anion of a sensitizing dye or a color developed substance.

Preferred examples of the electron donating compound include an alkylamine (such as triethylamine, tributylamine, trioctylamine, N,N-dimethyldodecylamine, triethanolamine, or triethoxyethylamine), an aniline (such as N, N-dioctylaniline, N,N-dimethylaniline, 4-methoxy-N,N-dibutylaniline, or 2-methoxy-N,N-dibutylaniline), a phenylenediamine (such as N,N,N',N'-tetramethyl-1,4-phenylenediamine, N,N,N',N'-tetramethyl-1,2-phenylenediamine, N,N,N',N'-tetramethyl-1,3-phenylenediamine, or N,N'-dibutylphenylenediamine), a triphenylamine (such as triphenylamine, tri (4-methoxyphenyl)amine, tri(4-dimethylaminophenyl)amine, or TPD), a carbazole (such as N-vinylcarbazole, or N-ethylcarbazole), a phenothiazine (such as N-methylphenothiazine, or N-phenylphenothiazine), a phenoxazine (such as N-methylphenoxazine or N-phenylphenoxazine), a phenazine (such as N,N'-dimethylphenazine, or N,N'-diphenylphenazine), a hydroquinone (for example hydroquinone, 2,5-dimethylhydroquinone, 2,5-dichlorohydroquinone, 2,3,4,5-tetrachlorohydroquinone, 2,6-dichloro-3,5-dicyanohydroquinone, 2,3-dichloro-5,6-dicyanohydroquinone, 1,4-dihydroxynaphthalene, or 9,10-dihydroxynaphthalene),a cathecol(such as cathecol, or 1,2,4-trihydroxybenzene), an alkoxybenzene (such as 1,2-dimethoxybenzene, 1,2-dibutoxybenzene, 1,2,4-tributoxybenzene or 1,4-dihexyloxybenzene), an aminophenol (such as 4-(N,N-diethylamino)phenol or N-octylaminophenol), an imidazole (such as imidazole, N-methylimidazole, N-octylimidazole or N-butyl-2-methylimidazole), a pyridine (such as pyridine, picoline, lutidine, 4-t-butylpyridine, 4-octyloxypyridine, 4-(N,N-dimethylamino)pyridine, 4-(N,N-dibutylamino)pyridine, or 2-(N-octylamino)pyridine), a metalocene (such as ferrocene, titanocene or lutenocene), a metal complex (such as Ru-bisbipyridine complex, Cu-phenanthroline complex, Co-trisbipyridine complex, Fe-EDTA complex, or complexes of Ru, Fe, Re, Pt, Cu, Co, Ni, Pd, W, Mo, Cr, Mn, Ir, Ag etc.) and semiconductor fine particles (for example Si, CdSe, GaP, PbS or ZnS).

The electron donating compound is more preferably a phenothiazine compound, and most preferably N-methylphenothiazine.

On the other hand, preferredexamples of the electron accepting compound includes an aromatic compound in which an electron attracting group is introduced (such as 1,4-dinitrobenzene, 1,4-dicyanobenzene, 4,5-dichloro-1,2-dicyanobenzene, 4-nitro-1,2-dicyanobenzene, 4-octanesulfonyl-1,2-dicyanobenzene, or 1,10-dicyanoanthracene), a heterocyclic compound or a heterocyclic compound in which an electron attracting group is introduced (such as pyrimidine, pyrazine, triazine, dichloropyrazine, 3-cyano-pyrazole, 4,5-dicyana-1-methyl-2-octanoylaminoimidazole, 4,5-dicyanoimidazole, 2,4-dimethyl-1,3,4-thiadiazole, 5-chloro-3-phenyl-1,2,4-thiadiazole, 1,3,4-oxadiazole, 2-chlorobenzothiazole, or N-butyl-1,2,4-triazole), an N-alkylpyridinium salt (such as N-butylpyridiniumiodide, N-butylpyridiniumbis(trifluoromethanesulfonyl) imide, N-butyl-3-ethoxycarbonyl-pyridinium butanesulfonate, N-octyl-3-carbamoylpyridinium bis(trifluoromethanesulfonyl) imide, N,N-dimethylviologen di(hexafluorophosphate), or N,N-diphenylviologen bis(bis(trifluoromethanesulfonyl)imide)), a benzoquinone (such as benzoquinone, 2,5-dimethylbenzoquinone, 2,5-dichlorobenzoquinone, 2,3,4,5-tetrachlorobenzoquinone, 2,6-dichloro-3,5-dicyanobenzoquinone, 2,3-dichloro-5,6-dicyanobenzoquinone, naphthoquinone or anthraquinone), an imide (such as N,N'-dioctylpyromellitimide or 4-nitro-N-octylphthalimide), a metal complex (such as Ru-trisbipyridine complex, Ru-bisbipyridine complex, Co-trisbipyridine complex, Cr-trisbipyridine complex, $PtCl_6$ complex, or complexes of Ru, Fe, Re, Pt, Cu, Co, Ni, Pd, W, Mo, Cr, Mn, Ir, Ag etc.) and semiconductor fine particles (for example $TiO_2$, $Nb_2O_5$, ZnO, $SnO_2$, $Fe_2O_3$, or $WO_3$).

The electron donating compound preferably has an oxidation potential baser (at the negative side) than an oxidation potential of the sensitizing dye or the color-developed substance or an oxidation potential of an excited state of the sensitizing dye or the color-developed substance, and the electron accepting compound preferably has a reduction potential more precious (at the positive side) than a reduction potential of the sensitizing dye or the color-developed substance or a reduction potential of an excited state of the sensitizing dye or the color-developed substance.

In the hologram recording material of the invention, a binder is advantageously employed. The binder is usually employed for the purposes of improving a film forming property of the composition, a uniformity of film thickness and a stability in storage. The binder preferably has a satisfactory mutual solubility with the sensitizing dye and the interference fringe recording component.

The binder is preferably constituted of a thermoplastic polymer soluble in a solvent, which can be employed singly or in a combination of plural kinds.

The binder may have a reactive site and may be crosslinked or hardened by a reaction with a crosslinking agent, a polymerizable monomer or oligomer. The reactive site in such case can be, for example as a radical reactive site, an ethylenic unsaturated group represented by an acryl group or a methacryl group, also as a cationic reactive site, an oxilane compound, an oxetane compound or a vinyl ether group, and as a polycondensation reactive site, a carboxylic acid, an alcohol or an amine.

Preferred examples of the binder to be employed in the invention include a polymer of an acrylate or $\alpha$-alkylacrylate ester or an acid or an interpolymer (such as polymethyl methacrylate, polyethyl methacrylate, or copolymer of methyl methacrylate and another alkyl (meth)acrylate ester), a polyvinyl ester (such as polyvinyl acetate, polyvinyl acetate/acrylate, polyvinyl acetate/methacrylate or hydrolyzed polyvinyl acetate), an ethylene/vinyl acetate copolymer, a saturated or unsaturated polyurethane, a butadiene or isoprene polymer/copolymer, a high-molecular polyoxyethylene of a polyglycol having a weight-averaged molecular weight of about 4, 000 to 1,000,000, an epoxide (such as an epoxide having an acrylate group or a methacrylate group), a polyamide (such as N-methoxymethylpolyhexamethylene adipamide), a cellulose ester (such as cellulose acetate, cellulose acetate succinate or cellulose acetate butyrate), a cellulose ester (such as methyl cellulose, ethyl cellulose, or ethylbenzyl cellulose), polycarbonate, polyvinylacetal (such as polyvinyl butyral or polyvinylformal), polyvinyl alcohol, polyvinylpyrrolidone, and an acid-containing polymer/copolymer functioning as an appropriate binder as disclosed in USP Nos. 3,458,311 and 4,273,857.

Examples further include a polystyrene polymer or a copolymer with acrylonitrile, maleic anhydride, acrylic acid, methacrylic acid or an ester thereof, a vinylidene chloride copolymer (such as a vinylidene chloride/acrylonitrile copolymer, a vinylidene chloride/methacrylate copolymer, or a vinylidene chloride/vinyl acetate copolymer), polyvinyl chloride and a copolymer thereof (such as polyvinyl chloride/acetate, or a vinyl chloride/acrylonitrile copolymer), polyvinylbenzal synthetic rubber (such as a butadiene/acrylonitrile copolymer, an acrylonitrile/butadiene /styrene copolymer, a methacrylate/acrylonitrile/butadiene/styrene copolymer, a 2-chlorobutadiene-1,3 polymer, chlorinated rubber, a styrene/butadiene or styrene/isoprene/styrene block copolymer), a copolyester (such as a product produced from a

reaction product of polymethylene glycol represented by a formula HO $(CH_2)_n$OH (in which n represents an integer of 2 to 10) and (1) hexahydroterephthalic acid, sebacic acid and terephthalic acid, (2) terephthalic acid, isophthalic acid and sebacic acid, (3) terephthalic acid and sebacic acid, or (4) terephthalic acid and isophthalic acid, or (5) a copolyester mixture produced from the aforementioned glycol and (i) terephthalic acid, isophthalic acid and sebacic acid, and (ii) terephthalic acid, isophthalic acid, sebacic acid and adipic acid), poly-N-vinylcarbazole or a copolymer thereof, a carbazole-containing polymer disclosed by Kamogawa et al., in Journal of Polymer Science: Polymer Chemistry Edition, 18, p.9-18(1979), and a polycarbonate constituted of a bisphenol and a carbonate ester.

A fluorine atom-containing polymer is also preferable as a binder of a low refractive index. A preferred example is a polymer including a fluoroolefin as an essential component and one or more unsaturated monomers selected from an alkyl vinyl ether, an alicyclic vinyl ether, a hydroxyvinyl ether, an olefin, a haloolefin, an unsaturated carboxylic acid, an ester thereof, and a vinyl carboxylate ester as a copolymerizing component, and soluble in an organic solvent. It preferably has a weight-averaged molecular weight of 5, 000 to 200, 000 and a fluorine atom content of 5 to 70 wt.%.

The fluoroolefin in the fluorine atom-containing polymer can be tetrafluoroethylene, chlorotrifluoroethylene, vinyl fluoride or vinylidene fluoride. Also as to other copolymeriztion components, the alkyl vinyl ether can for example be ethyl vinyl ether, isobutyl vinyl ether, or n-butyl vinyl ether; the alicyclic vinyl ether can be cyclohexyl vinyl ether or a derivative thereof; the hydroxyvinyl ether can be cyclohexyl vinyl ether or a derivative thereof; the hydroxyvinyl ether can be hydroxybutyl vinyl ether; the olefin or haloolefin can be ethylene, propylene, isobutylene, vinyl chloride, or vinylidene chloride; the vinyl carboxylate ester can be vinyl acetate or vinyl n-butyrate; and the unsaturated carboxylic acid or an ester thereof can be an unsaturated carboxylic acid such as (meth)acrylic acid or crotonic acid, or a $C_1$ to $C_{18}$ alkyl ester of (meth)acrylic acid such as methyl (meth)acrylate, ethyl (meth)acrylate, propyl (meth)acrylate, isopropyl (meth)acrylate, butyl (meth)acrylate, hexyl (meth)acrylate, octyl (meth)acrylate or lauryl (meth)acrylate, or a $C_2$ - $C_8$ hydroxyalkyl ester of (meth)acrylic acid such as hydroxyethyl (meth)acrylate or hydroxypropyl (meth)acrylate; N, N-dimethylaminoethyl (meth) acrylate, orN,N-diethylaminoethyl (meth)acrylate. These radical polymerizable monomers may be employed singly or in a combination of two or more kinds, and, if necessary, a part of such monomer may be replaced by another radical polymerizable monomer for example a vinyl compound such as styrene, $\alpha$-methylstyrene, vinyltoluene or (meth)acrylonitrile. Also as another derivative of the monomer, there can be employed a fluoroolefin containing a carboxylic acid group, or a vinyl ether containing a glycidyl group.

Examples of the fluorine atom-containing polymer include products of a "Lumiflon" series, having a hydroxyl group and soluble in organic solvents (for example Lumiflon LF200, weight-averaged molecular weight: ca. 50, 000, manufactured by Asahi Glass Co.). The fluorine atom-containing polymers soluble in organic solvents are commercially available also from Daikin Industries Ltd., Central Glass Co., Penwalt Inc. etc. and are likewise usable.

The binder to be employed in the hologram recording material of the invention preferably has a refractive index equal to or less than 1.5.

The hologram recording material of the invention may suitably contain, if necessary, additives such as a polymerizable monomer, a polymerizable oligomer, a crosslinking agent, a thermal stabilizer, a plasticizer, a solvent etc.

Examples of the polymerizable monomer, the polymerizable oligomer, and the crosslinking agent preferably employable in the hologram recording material of the invention are described for example in JP-A No. 2003-82732.

In the hologram recording material of the invention, a thermal stabilizer may be added in order to improve the stability in the storage.

Examples of the useful thermal stabilizer include hydroquinone, phenidone, p-methoxyphenol, an alkyl- or aryl-substituted hydroquinone or quinone, cathecol, t-butylcathecol, pyrogallol, 2-naphthol, 2,6-di-t-butyl-p-cresol, phenothiazine and chloranil. Also a dinitrosodimer, described by Pazos in USP No. 4,168,982, is useful.

The plasticizer is used for regulating an adhesion property, a flexibility, a hardness, a scattering property and other mechanical properties of the hologram recording material. Examples of the plasticizer include triethylene glycol tricaprilate, triethylene glycol bis(2-ethylhexanoate), tetraethylene glycol diheptanoate, diethyl sebacate, dibutyl suberate, tris(2-ethylhexyl) phosphate, tricresyl phosphate and dibutyl phthalate. Also an alcohol or a phenol can be advantageously employed as an additive.

Components of the hologram recording material of the invention or the composition thereof are preferably present within following ranges, in percentage with respect to the total mass of the composition:

(reactive) binder, polymerizable monomer, polymerizable oligomer, crosslinking agent: preferably 0 - 95 mass%, more preferably 30 - 95 mass%

interference fringe recording component: preferably 3 - 70 mass%, more preferably 5 - 70 mass%, further preferably 5 - 50 mass%

sensitizing dye: preferably 0.001 - 10 mass%, more preferably 0.01 - 10 mass%, furthermore preferably 0.01 - 3, particularly preferably 0.1 - 3 mass%

electron-donating compound or electron-accepting compound: preferably 0 - 40 mass%, more preferably 0 - 30 mass%.

The hologram recording material of the invention or the composition therefor can be prepared by an ordinary method. For example, it can be prepared from the essential component and other components mentioned above, with an addition of a solvent if necessary.

For example, the film formation of the hologram recording material of the present invention may be performed by a method of dissolving the binder and respective components in a solvent or the like and coating the obtained solution with use of a spin coater, a bar coater or the like.

Examples of the solvent include a ketone solvent such as methyl ethyl ketone, methyl isobutyl ketone, acetone or cyclohexanone, an ester solvent such as ethyl acetate, butyl acetate, ethylene glycol diacetate, ethyl lactate or cellosolve acetate, a hydrocarbon solvent such as cyclohexane, toluene or xylene, an ether solvent such as tetrahydrofuran, dioxane, or diethyl ether, a cellosolve solvent such as methyl cellosolve, ethyl cellosolve, butyl cellosolve, or dimethyl cellosolve, an alcohol solvent such as methanol, ethanol, n-propanol, 2-propanol, n-butanol, or diacetone alcohol, a fluorinated solvent such as 2,2,3,3-tetrafluoropropanol, a halogenated hydrocarbon solvent such as dichloromethane, chloroform or 1, 2-dichloroethane, an amide solvent such as N,N-dimethylformamide, and a nitrile solvent such as acetonitrile or propionitrile.

The hologram recording material of the invention can be prepared by direct coating on a substrate with a spin coater, a roll coater, a bar coater or the like, or by casting into a film followed by a lamination in an ordinary method on a substrate.

The "substrate" can be any natural or synthetic substrate, which preferably can exist as a flexible or rigid film, a sheet or a plate.

The substrate is preferably constituted for example of polyethylene terephthalate, polyethylene terephthalate with a resinous undercoating, polyethylene terephthalate subjected to a flame or electrostatic discharge treatment, cellulose acetate, polycarbonate, polymethyl methacrylate, polyester, polyvinyl alcohol or glass.

The solvent employed may be removed by evaporation at a drying. The removal by evaporation may be executed by heating or under a reduced pressure.

The film formation of the hologram recording material of the present invention may also be performed by melting the binder containing respective components at a temperature higher than the glass transition temperature or melting point of the binder and melt-extruding or injection-molding the obtained melt. At this time, a reactive crosslinking binder may be used as the binder to cure the film by causing crosslinking after extrusion or molding and thereby increase the film strength. Examples of the crosslinking reaction which can be used here include a radical polymerization reaction, a cationic polymerization reaction, a condensation polymerization reaction and an addition polymerization reaction. Furthermore, the methods described, for example, in JP-A-2000-250382 and JP-A-2000-172154 can also be preferably used.

In addition, a method of dissolving respective components in a monomer solution for forming the binder, causing thermal polymerization or photopolymerization of the monomer to form a polymer and using the polymer as the binder can also be preferably used. Examples of the polymerization method which can be used here include, similarly to the above, a radical polymerization reaction, a cationic polymerization reaction, a condensation polymerization reaction and an addition polymerization reaction.

Also a protective layer for intercepting oxygen may be provided on the hologram recording material. The protective layer may be formed by adhering a plastic film or a plastic plate of a polyolefin such as polypropylene or polyethylene, polyvinyl chloride, polyvinylidene chloride, polyvinyl alcohol, polyethylene terephthalate or a cellophane film by electrostatic adhesion or by lamination utilizing an extruder, or it may also be formed by coating a solution of the aforementioned polymer. Also a glass plate may be adhered. Also in order to increase hermeticity a tacking agent or a liquid substance may be made present between the protective layer and the photosensitive film and/or between the substrate and the photosensitive film.

In case of utilizing the hologram recordingmaterial of the invention for a holographic optical memory, the hologram recording material is preferably free from a shrinkage before and after the hologram recording, in order to improve the S/N ratio at the signal reproduction.

For this purpose, it is preferable to employ in the hologram recording material of the invention, for example, an expanding agent described in JP-A No. 2000-86914, or a shrinkage-resistant binder described in JP-A Nos. 2000-250382, 2000-172154 and 11-344917.

It is also preferable to regulate a gap of interference fringes by a diffusing element described in JP-A Nos. 3-46687 and 5-204288 and JP-T No. 9-506441.

In general, the refractive index of a dye assumes a high value within a longer wavelength range from a vicinity of a wavelength of a linear absorption maximum (λmax), particularly a very high value within a longer wavelength range of about 200 nm from λmax, exceeding 2 in certain dyes and exceeding 2.5 in certain cases. On the other hand, a non-dye organic compound such as a binder polymer has a refractive index of about 1.4 to 1.6.

In the holography, it is preferable in principle that a reproducing wavelength is same as a recording wavelength.

Therefore, in the hologram recording material of the invention, it is preferable that the refractive index of the

dye formed from the interference fringe recording component becomes largest in the vicinity of the wavelength of the laser employed for recording (reproduction). The dye formed from the interference fringe recording component more preferably has, in a dye single film, a refractive index at the recording wavelength of 1.7 or higher, further preferably 1.8 or higher and most preferably 2 or higher.

Thus, in the aforementioned method for the hologram recording material of the invention, by causing a color development (absorption shift to a longer wavelength) either by an excitation energy acquiredby the sensitizing dye through a holographic exposure in a first step or by an excitation energy acquired by the color-developed substance in a second step, it is possible to modulate the refractive index more significantly between a light region and a dark region in the interference, in comparison with the known photopolymer processes described for example in patent references 1 - 3 and 5 - 8.

Besides, the hologram recording method of the invention, including a first step of forming a latent image by a holographic exposure and a second step of amplifying such latent image thereby modulating the refractive index to form interference fringes, is capable of a recording with a very high sensitivity in comparison with the known methods.

Also the hologram recording material of the invention, being free from a material displacement or a polymerization in the interference fringe recording as in a photopolymer method, can exclude a trade-off restriction and achieve a high sensitivity, a low shrinkage and a satisfactory storability at the same time. Also, multiplex recording can be executed many times since the recording itself does not involve polymerization, and, an exposure amount can be maintained constant in any of the multiplex recording, so that a wide dynamic range can be realized. In particular, the method of the invention utilizing the latent image amplification is advantageous in the adaptability to the multiplex recording.

These factors are advantageous for achieving a high capacity, simplifying the recording system and improving the S/N ratio.

On the other hand, in comparison with a recording method utilizing a change in orientation of a compound having a birefringent property such as an azobenzene polymer, as disclosed in the patent reference 4, the method of the invention has a high sensitivity because of a high quantum yield, and also enables a non-destructive reproduction by decomposing the sensitizing dye in the hologram recording, in the thermal or optical fixation after the recording, or in the first or second step, thereby providing an excellent storability.

As explained in the foregoing, the hologram recording material of the invention provides a totally novel recording method fundamentally free from the aforementioned drawbacks and capable of realizing, in particular, a high sensitivity, a low shrinkage, a satisfactory storability, a dry processing and a multiplex recording characteristics at the same time, and is preferably applied to an optical recording medium (holographic optical memory). In particular, the hologram recording material of the invention is further preferably applied to a dry unrewritable method. Also there is preferred an unrewritable hologram recording method described in (A-36) mentioned in the foregoing.

In case of utilizing the hologram recording material of the invention as an optical recording medium, the hologram recording material is stored preferably in a light-tight cartridge. It is also preferable to provide the hologram recording material, on a front surface and/or a rear surface thereof, with a light-shielding filter capable of intercepting a part of ultraviolet, visible and infrared wavelength ranges other than the wavelength of the recording light and the reproducing light.

In case of employing the hologram recording material of the invention as an optical recording medium, such optical recording medium can be of any shape such as a disk, a card or a tape.

Also the hologram recording material of the invention can be advantageously applied, in addition to the optical recording medium, for example to a three-dimensional display hologram, a holographic optical element (HOE, such as a head-up display (HUD) for an automobile, a pickup lens for an optical disk, a head-mount display, a color filter for liquid crystal display, a reflection plate for a reflective liquid crystal display, a lens, a diffraction grating, an interference filter, an optical fiber coupler, a photodeflector for facsimile, and a window pane for construction), a cover for a book or a magazine, a display such as a POP, a gift, a credit card for antiforging, a banknote, a package etc.

In the following, examples of the present invention will be explained, but the present invention is not limited to such examples.

Example 1

Under a red light, a sensitizing dye, an electron donating compound, an interference fringe recording component, an additive and a binder PMMA-EA (polymethyl methacrylate-5% ethyl acrylate copolymer, Mw: 101,000) shown in Table 1 were dissolved in methylene chloride of 2 to 4 times amount (acetone or acetonitrile being also employed if necessary) to obtain compositions A101 - A110 for hologram recording material.

Percentages are shown in wt.% with respect to the binder PMMA-EA.

I-101

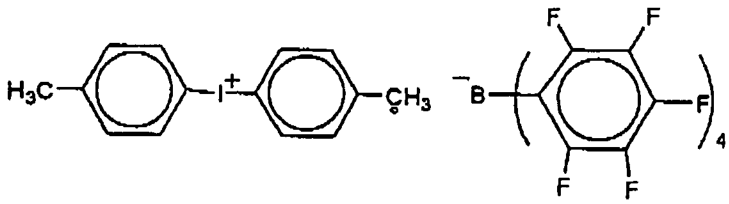

I-102

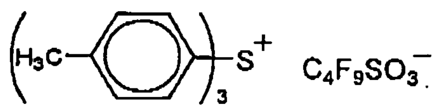

I-103

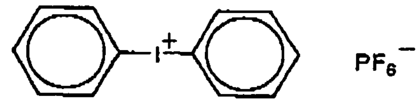

R-7

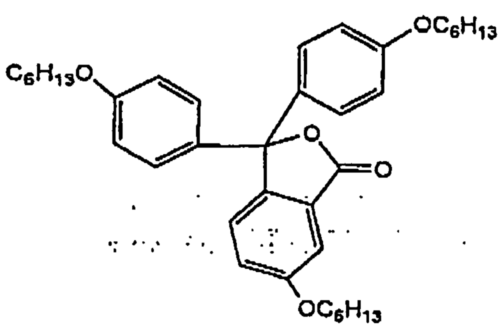

R-3

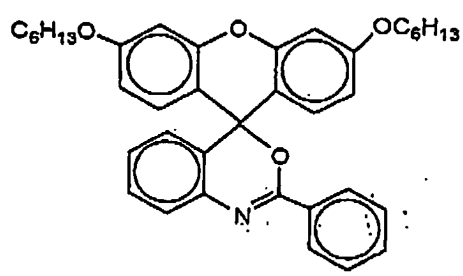

ED-1

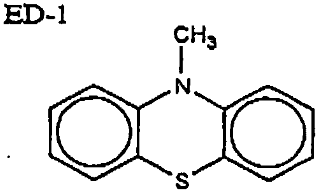

SO-1

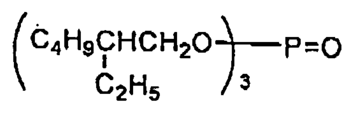

SO-2

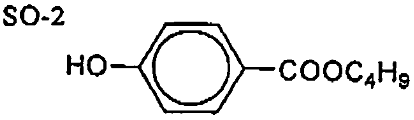

SO-3

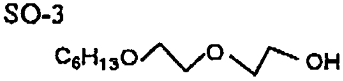

Table 1

| Sample | Sensitizing dye | | Electron donating compd. | Interference fringe recording component | Additive |
|---|---|---|---|---|---|
| A101 | D-91 | 4 % | - | I-103 50% + R-3 10% | SO-1 8% |
| A102 | D-95 | 8 % | - | 1-103 50% + R-3 10% | SO-1 8% |
| A103 | D-95 | 4 % | ED-1 36 % | I-103 50% + R-3 10% | - |
| A104 | D-101 | 30 % | - | I-103 50% + R-3 10% | SO-2 36% |
| A105 | D-107 | 30 % | - | I-103 50% + R-3 10% | SO-2 36% |
| A106 | D-115 | 0.5% | ED-1 42 % | I-103 50% + R-3 10% | SO-3 8% |
| A107 | D-118 | 1.6% | ED-1 42 % | 1-103 50% + R-3 10% | SO-3 8% |
| A108 | D-117 0.84% | | ED-1 42 % | PB-3 20% + DD-47 10% | - |
| A109 | D-118 | 1.6% | ED-1 42 % | E-12 25% | trioctylamine 10% |
| A110 | D-101 | 30 % | - | E-13 25% | trioctylamine 10% |

Each of the compositions A101 - A110 for the hologram recording material was blade coated on a glass substrate (superposed coating if necessary) to obtain a thickness of about 80 μm to form a photosensitive layer, and was dried by heating for 3 minutes at 40°C for removing the solvent. Then the photosensitive layer was covered with a TAC film to obtain hologram recording materials A101 - A110.

Also as a comparative example, there was prepared a hologram recording material of radical polymerization photopolymer type, described in Example 1 of JP-A No. 6-43634 (corresponding to USP 4,942,112).

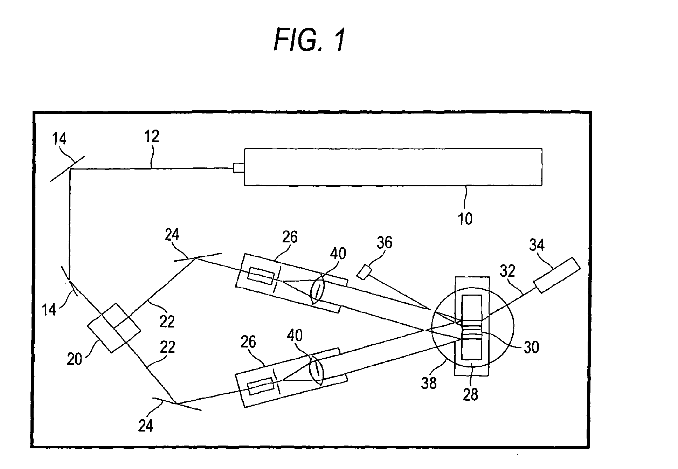

The hologram recording material was recorded by an exposure in a two-beam optical system for transmission hologram recording as shown in Fig. 1, utilizing a second harmonic wave of a YAG laser (wavelength: 532 nm, output: 2 W) as a light source. An object light and a reference light formed an angle of 30°. The light beamhad a diameter of 0.6 cm and an intensity of 8 mW/cm$^2$, and the exposure was made by varying a holography exposure time within a range of 0.1 to 400 seconds (range of irradiation energy of 0.8 to 3200 mJ/cm$^2$) . During the holographic exposure, a beam of 632 nm of a He-Ne laser was passed with a Bragg's angle at the center of the exposure area, and a ratio of a diffracted light to an incident light (diffraction efficiency) was measure on real-time basis.

Results of evaluations of the maximum diffraction efficiency and the shrink rate, on the hologram recording materials A101 - A110, are shown in Table 2. The shrink rate is a ratio of film thickness before and after the recording.

Table 2

| Sample | Maximum diffraction efficiency | Shrink rate |
|---|---|---|
| A101 | 73 % | < 0.01 % |
| A102 | 76 % | < 0.01 % |
| A103 | 76 % | < 0.01 % |
| A104 | 71 % | < 0.01 % |
| A105 | 71 % | < 0.01 % |
| A106 | 73 % | < 0.01 % |
| A107 | 75 % | < 0.01 % |
| A108 | 70 % | < 0.01 % |
| A109 | 72 % | < 0.01 % |
| A110 | 72 % | < 0.01 % |
| comp. ex. | 69 % | 5.1 % |

Table 2 indicates that the known comparative example described in JP-A No. 6-43634 had a high diffraction

efficiency but resulted in a large shrinkage exceeding 5 % because it was based on a photopolymer method involving a radical polymerization, thus showing an extreme deterioration in the S/N ratio, and was unsuitable particularly for a holographic memory. On the other hand, it is indicated that the hologram recording materials A101 - A110 of the invention, based on a recording method which was totally different from that of the known hologram recording materials and which executed a hologram recording by a refractive index modulation by a color developing reaction instead of a material transfer or a polymerization, could achieve a high diffraction efficiency and an extremely small shrink rate not exceeding 0.01 % at the same time, and was particularly suitable for a holographic memory.

It is also identified that the hologram recording material of the present invention showed a linear increase in $\Delta n$ (modulation amount of refractive index, calculated from diffraction efficiency and film thickness according to Kogelnick's equation) in proportion to the exposure amount (mJ/cm$^2$), thus being advantageous for multiplex recording.

In practice, the hologram recording material of the invention was subjected to a multiplex hologram recording of 10 times in a same position with an exposure amount each equal to 1/10 of the exposure amount providing the maximum diffraction efficiency andwith a reference light angle changed by 2° for each exposure, and it was confirmed that each obj ect light could be reproduced by a reproducing light irradiation changed by 2° for each time. Thus the hologram recording material of the invention is capable of multiplex recording with a same exposure amount, thus being suitable for multiplex recording. Stated differently, the hologram recording material of the invention is capable of multiplex recording of many times, thus achieving a recording of a high density (capacity) .

On the other hand, in the hologram recording materials of JP-A No. 6-43634 and other known photopolymer methods, the polymerization of photopolymer progresses to retard the monomer displacement required for recording, in a latter period of the multiplex recording, thus requiring a larger exposure amount for a same recording in comparison with an early period of the multiplex recording, and constituting a difficulty in increasing the level of multiplicity or the recording density.

In the samples A101 - A110, similar effects could be obtained also in case of changing the sensitizing dye to D-1, D-8, D-17, D-22, D-31, D-33, D-34, D-46, D-49, D-50, D-55, D-74, D-87, D-93, D-94, D-97, D-100, D-116, D-119, D-120, or D-121 or changing the binder to polymethyl methacrylate (Mw: 996,000, 350,000 or 120, 000) , methyl methacrylate-butyl methacrylate copolymer (Mw: 75,000), polyvinyl acetate (Mw: 83,000) or polycarbonate.

Furthermore, in the samples A101 - A107, similar effects could be obtained also in case of changing the acid generating agent of the interference fringe recording component to 2-(4'-methoxyphenyl)-4,6-bis(trichloromethyl)-1,3,5-triazine, 4-diethylaminophenyl-diazonium tetrafluoroborate, di(t-butylphenyl)iodonium tetra(pentafluorophenyl) borate, tris(4-methylphenyl)sulfonium tetra(pentafluorophenyl)borate, triphenylsulfonium methanesulfonate, triphenylsulfonium perfluoropentanoate, bis(1-(4-diphenylsulfonium) phenylsulfideditriflato, benzoin tosylate, 2,6-dinitrobenzyl tosylate, N-tosylphthalic imide, 1-101 or 1-107, or by changing the acid-induced color forming dye precursor of the interference fringe recording component to R-1, R-2, R-4, R-6 or R-7.

Furthermore, similar effects could be obtained also in case of changing, in the sample A103, the base generating agent of the interference fringe recording component to PB-4, PB-8, PB-10, PB-12, PB-13, PB-19, PB-22, PB-32, PB-33, or PB-52, or, in the sample A108, changing the base-induced color forming dye precursor (undissociated substance of dissociable dye) to DD-1, DD-4, DD-7, DD-10, DD-16, DD-23, DD-25, DD-35, DD-39, DD-43, DD-47, DD-48, or DD-49.

Furthermore, similar effects could be obtained also in case of changing, in the samples A109 and A110, the interference fringe recording component to E-4, E-5, E-15, E-16, E-17, E-18, E-24, E-25, E-28, E-29, E-32, E-33, E-37, E-38, E-42 or E-44.

Example 2

Under a red light, a sensitizing dye, an electron donating compound, an interference fringe recording component, an additive and a binder PMMA-EA (polymethyl methacrylate-5% ethyl acrylate copolymer, Mw: 101,000) shown in Table 3 were dissolved in methylene chloride of 2 to 4 times amount (acetone or acetonitrile being also employed if necessary) to obtain compositions B101 - B104 for hologram recording material.

Percentages are shown in wt.% with respect to the binder PMMA-EA.

R-7

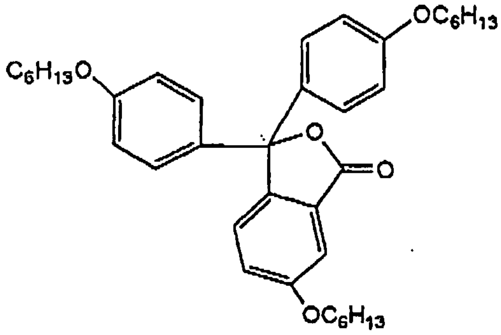

R-3

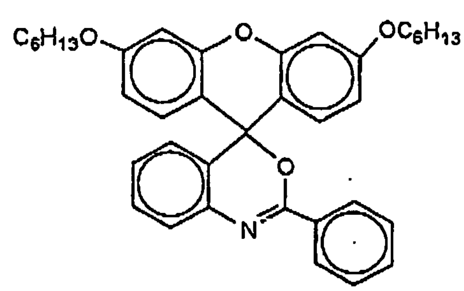

I-101

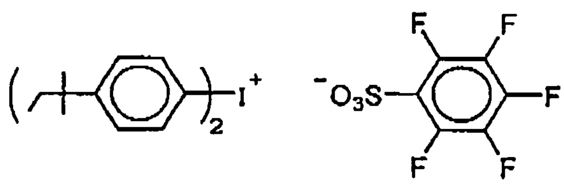

I-102

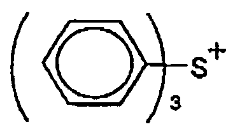

$CF_3SO_3^-$

I-103

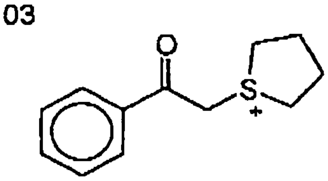

$C_4F_9SO_3^-$

I-104

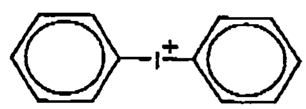

$PF_6^-$

ED-1

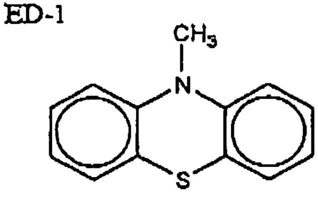

SO-3

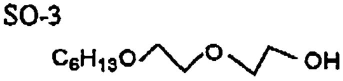

Table 3

| Sample | Sensitizing dye | Electron donating compd. | Interference fringe recording component | Additive |
|---|---|---|---|---|
| B101 | D-115 0.5 % | ED-1 42 % | I-104 50% + R-3 10% | SO-3 8% |
| B102 | D-118 1.6 % | ED-1 42 % | I-104 50% + R-3 10% | SO-3 8% |
| B103 | D-117 0.84% | ED-1 42 % | PB-3 20% + DD-47 10% | - |
| B104 | D-118 1.6 % | ED-1 42 % | E-12 25% | trioctylamine 10% |

Each of the compositions B101 - B104 for the hologram recording material was blade coated on a glass substrate (superposed coating if necessary) to obtain a thickness of about 80 μm to form a photosensitive layer, and was dried by heating for 3 minutes at 40°C for removing the solvent. Then the photosensitive layer was covered with a TAC film to obtain hologram recording materials 101 - 104.

The hologram recording material was recorded by an exposure in a two-beam optical system for transmission hologram recording as shown in Fig. 1, utilizing a second harmonic wave of a YAG laser (wavelength: 532 nm, output: 2 W) as a light source. An object light and a reference light formed an angle of 30°. The light beam had a diameter of 0.6 cm and an intensity of 8 $mW/cm^2$, and the exposure was made by varying a holography exposure time within a range of 0.1 to 40 seconds (range of irradiation energy of 0.08 to 320 $mJ/cm^2$). During the holographic exposure, a beam of 632 nm of a He-Ne laser was passed with a Bragg' s angle at the center of the exposure area, and a ratio of a diffracted light to an incident light (diffraction efficiency) was measure on real-time basis. Also each sample was flush irradiated over the entire area with a light of a wavelength range of 370 - 410 nm (second step) and a diffraction efficiency was measured.

Results of evaluations of the diffraction efficiency after the holographic exposure in the first step, the maximum diffraction efficiency to the exposure after the light irradiation in the second step, and the shrink rate (calculated from film thickness before and after the recording) , on the hologram recording materials B101 - B104, are shown in Table 4.

Table 4

| Sample | Diffraction efficiency η after 1st step | Max. diffraction efficiency η after 2nd step | Shrink rate | Amplification rate* |
|---|---|---|---|---|
| B-101 | 14 % | 72 % | < 0.01% | 5.9 |
| B-102 | 15 % | 73 % | < 0.01% | 6.4 |
| B-103 | 14 % | 70 % | < 0.01% | 5.1 |
| B-104 | 14 % | 71 % | < 0.01% | 4.6 |
| comp. ex. | Diffraction efficiency η 69% | | 5.1 % | - |

*) Amplification rate: An irradiation amount required for obtaining the maximum diffraction efficiency with the first step only, without employing the second step, divided by an irradiation amount required for the first step in case of employing the second step.

Table 4 indicates that the known comparative example described in JP-A No. 6-43634 had a high diffraction efficiency but resulted in a large shrinkage exceeding 5 % because it was based on a photopolymer method involving a radical polymerization, thus showing an extreme deterioration in the S/N ratio, and was unsuitable particularly for a holographic memory. On the other hand, it is indicated that the hologram recording materials B101 - B104 of the invention, based on a recording method which was totally different fromthat of the known hologram recording materials and which executed a hologram recording by a refractive index modulation by a color developing reaction instead of a material transfer or a polymerization, could achieve a high diffraction efficiency and an extremely small shrink rate not exceeding 0.01 % at the same time, and was particularly suitable for a holographic memory.

Also as indicated in Table 4, in the hologram recording material of the invention, the amount of irradiation in the first step can be made 1/5 to 1/6 of that in case the second step is not employed. The second step, which can be

executed in a collective exposure, achieves an amplification of the refractive index modulation recording based on the color-developed substance formed in the first step as a latent image and utilizing a self-sensitizing color formation of the color-developed substance itself in the second step, thereby enabling a shortening of the first step or namely an increase in the sensitivity.

A sensitivity increase by such amplification is naturally not possible in the known materials.

It is also identified that the hologram recording material of the present invention showed a linear increase in Δn (modulation amount of refractive index, calculated from diffraction efficiency and film thickness according to Kogelnick's equation) in proportion to the exposure amount (mJ/$cm^2$), thus being advantageous for multiplex recording.

In practice, the hologram recording material of the invention was subj ected to a multiplex hologram recording, by a multiplex recording of 10 times in a same position with an exposure amount each equal to 1/10 of the exposure amount in the aforementioned first step and with a reference light angle changed by 2° for each exposure (first step) , followed by a flush irradiation with a light of a wavelength range of 370 - 410 nm (second step), and it was confirmed that each object light could be reproduced by a reproducing light irradiation changed by 2° for each time. Thus the hologram recording material of the invention is capable of multiplex recording with a same exposure amount, thus being suitable for multiplex recording. Stated differently, the hologram recording material of the invention is capable of multiplex recording of many times, thus achieving a recording of a high density (capacity).

On the other hand, in the hologram recording materials of JP-ANo. 6-43634 and other known photopolymer methods, the polymerization of photopolymer progresses to retard the monomer displacement required for recording, in a latter period of the multiplex recording, thus requiring a larger exposure amount for a same recording in comparison with an early period of the multiplex recording, and constituting a difficulty in increasing the level of multiplicity or the recording density.

In the hologram recording materials (samples) B101 - B104, similar effects could be obtained also in case of changing the sensitizing dye to D-1, D-8, D-17, D-22, D-31, D-33, D-34, D-46, D-49, D-50, D-55, D-74, D-87, D-91, D-93, D-94, D-95, D-97, D-100, D-101, D-107, D-116, D-119, D-120 or D-121, or changing the binder to polymethyl methacrylate (Mw: 996,000, 350,000 or 120,000), methyl methacrylate-butyl methacrylate copolymer (Mw: 75,000) or polyvinyl acetate (Mw: 83,000).

Furthermore, in the samples B101 and B102, similar effects could be obtained also in case of changing the acid generating agent of the interference fringe recording component to 2-(4'-methoxyphenyl)-4,6-bis(trichloromethyl)-1,3,5-triazine, 4-diethylaminophenyl-diazonium tetrafluoroborate, di(t-butylphenyl)iodonium tetra(pentafluorophenyl) berate, tris(4-methylphenyl)sulfonium tetra(pentafluorophenyl)borate, triphenylsulfonium methanesulfonate, triphenylsulfonium perfluoropentanoate, bis(1-(4-diphenylsulfonium) phenylsulfideditriflato, benzoin tosylate, 2,6-dinitrobenzyl tosylate, N-tosylphthalic imide, I-101, I-102 or I-103, or, in the samples B101 and B102, by changing the acid-induced color forming dye precursor of the interference fringe recording component to R-1, R-2, R-4, R-6 or R-7.

Furthermore, similar effects could be obtained also in case of changing, in the sample B103, the base generating agent of the interference fringe recording component to PB-4, PB-8, PB-10, PB-12, PB-13, PB-19, PB-22, PB-32, PB-33, or PB-52, or, in the sample B103, changing the base-induced color forming dye precursor (undissociated substance of dissociable dye) to DD-1, DD-4, DD-7, DD-10, DD-16, DD-23, DD-25, DD-35, DD-39, DD-43, DD-47, DD-48, or DD-49.

Furthermore, similar effects could be obtained also in case of changing, in the sample B104, the interference fringe recording component to E-4, E-5, E-13, E-15, E-16, E-18, E-24, E-25, E-28, E-29, E-32, E-33, E-37, E-38, E-42 or E-44.

In the foregoing, the flush exposure was executed with a light of an optimumwavelength for respective system, and the electron donating compound was changed to an optimum one if necessary.

The present application claims foreign priority based on Japanese Patent Application Nos. JP2003-298936 and JP2003-300059, filed August 22, 2003 and August 25, 2003, respectively, the contents of which is incorporated herein by reference.

**Claims**

**1.** A hologram recording method, which comprises:

subjecting a sensitizing dye to holographic exposure so that the sensitizing dye absorbs light and is transformed into an excited state;
effecting a chemical reaction comprising a coloring reaction, the coloring reaction involving one of electron transfer and energy transfer from the excited state, so as to form a hologram,

wherein the hologram recording method employs a nonwritable process.

**2.** The hologram recording method according to claim 1, wherein the holographic exposure is not followed by any wet processing.

**3.** A hologram recording material composition comprising: a sensitizing dye which is subjected to holographic exposure to absorb light so that the sensitizing dye is transformed into an excited state; and a dye precursor which develops a color when one of electron and energy transfers from the excited state of the sensitizing dye.

**4.** The hologram recording material composition according to claim 3, wherein the dye precursor is capable of becoming a colored material having absorption at a longer wavelength than original state when one of electron and energy transfers from the excited state of the sensitizing dye.

**5.** The hologram recording material composition according to claim 3, which is a phase hologram recording material composition capable of recording an interference fringe by refractive index modulation.

**6.** The hologram recording material composition according to claim 3, wherein the dye precursor forms a colored material which has no absorption in a wavelength of hologram-reproducing light but has absorption in a longer wavelength range than the wavelength of hologram-reproducing light.

**7.** The hologram recording material composition according to claim 3, wherein the dye precursor is an acid-induced color-forming dye precursor, and the hologram recording material further comprises an acid generator.

**8.** The hologram recording material composition according to claim 7, wherein the dye formed from the acid-induced color-forming dye precursor is a xanthene dye, fluorane dye or triphenylmethane dye.

**9.** The hologram recording material composition according to claim 3, wherein the dye precursor is a base-induced color-forming dye precursor, and the hologram recording material composition further comprises a base generator.

**10.** The hologram recording material composition according to claim 9, wherein the base-induced color-forming dye precursor is an undissociated form of dissociative azo dye, dissociative azomethine dye, dissociative oxonol dye, dissociative xanthene dye, dissociative fluorane dye or dissociative triphenylmethane dye.

**11.** The hologram recording material composition according to claim 3, wherein the dye precursor is represented by the following general formula (2): A1-PD
wherein A1 and PD are covalently bonded to each other; A1 represents an organic compound moiety capable of severing the covalent bonding to PD when one of electron and energy transfers from the excited state of the sensitizing dye; and PD represents an organic compound moiety which differs in absorption form between when covalently bonded to A1 and when severed and released from the covalent bonding to A1.

**12.** The hologram recording material composition according to claim 3, which comprises an electron-donating compound capable of reducing a radical cation of the sensitizing dye.

**13.** The hologram recording material composition according to claim 12, wherein the electron-donating compound is a phenothiazine.

**14.** A hologram recording material comprising a hologram recording material composition according to claim 3.

**15.** The hologram recording method according to claim 1, which is a volume phase hologram recording method.

**16.** The hologram recording method according to claim 1, which is capable of multi-recording wherein a holographic exposure amount in each of the multi-recording is kept constant.

**17.** An optical recording medium comprising a hologram recording material composition according to claim 3.

**18.** The optical recording medium according to claim 17, which is kept in a light-shielding cartridge during storage.

**19.** A three-dimensional display comprising a hologram recording material according to claim 14.

**20.** A holographic optical element comprising a hologram recording material according to claim 14.

**21.** The hologram recording method according to claim 1, comprising: a first step of forming a latent image by holographic exposure; and a second step of amplifying the latent image to form an interference fringe, wherein the first and second steps are effected in a dry process.

**22.** The hologram recording method according to claim 21, wherein in the second step, the interference fringe is formed due to refractive index modulation by amplifying the latent image.

**23.** The hologram recording method according to claim 21, wherein the second step is triggered by at least one of irradiation with light, application of heat, application of electric field and application of magnetic field.

**24.** The hologram recording method according to claim 21, wherein the first step comprises forming as a latent image a colored material having no absorption in the wavelength of hologram-reproducing light, and the second step comprises irradiating the latent image of the colored material with light having a different wavelength from that of holographic exposure so that the colored material is self-sensitized or self-amplified to record an interference fringe as refractive index modulation.

**25.** The hologram recording method according to claim 21, which employs a nonrewritable process.

**26.** A hologram recording material which allows hologram recording by a hologram recording method according to claim 21, wherein the hologram recording material comprises:

1) a sensitizing dye which absorbs light at holographic exposure of the first step to produce an excited state; and
2) an interference fringe recording component comprising a dye precursor which can form a colored material having absorption in a longer wavelength than the original state and no absorption in the wavelength of hologram-reproducing light, the interference infringe recording component being capable of recording an interference fringe using refractive index modulation by color development which occurs via the step of transfer of electron or energy from the excited state of sensitizing dye or colored material.

**27.** The hologram recording material according to claim 26, wherein the dye precursor contained in the interference fringe recording component can form a colored material having absorption in a longer wavelength than the original state, no absorption in the wavelength of hologram-reproducing light and an absorption maximum in the range between the wavelength of hologram-reproducing light and the wavelength 200 nm shorter than the wavelength of hologram-reproducing light.

**28.** The hologram recording material according to claim 26, wherein the interference fringe recording component comprises: an acid-induced color-forming dye precursor as a dye precursor; and an acid generator.

**29.** The hologram recording material according to claim 26, wherein the interference fringe recording component comprises: a base-induced color-forming dye precursor as a dye precursor; and a base generator.

**30.** The hologram recording material according to claim 26, comprising one of: an electron-donating compound capable of reducing a radical cation of colored material produced by the sensitizing dye or dye precursor; and an electron-accepting compound capable of oxidizing a radical anion of colored material produced by the sensitizing dye or dye precursor.

**31.** The hologram recording material according to claim 30, comprising a phenothiazine as an electron-donating compound.

**32.** The hologram recording method according to claim 21, which involves volume phase hologram recording.

**33.** The hologram recording method according to claim 21, which comprises performing multi-hologram recording 10 or more times to form a latent image at the first step and then forming an interference fringe from the latent image at the second step.

**34.** The hologram recording method according to claim 33, wherein a holographic exposure amount in each of the multi-hologram recording in the first step is kept constant.

**35.** An optical recording medium comprising a hologram recording material according to claim 26.

**36.** The optical recordingmedium according to claim 35, which is kept in a light-shielding cartridge during storage.

**37.** The hologram recording method according to claim 1, further comprising a step of amplifying the latent image formed by the chemical reaction step.

FIG. 1